# EUROPEAN PATENT APPLICATION

(11) **EP 4 679 175 A1**
(43) Date of publication of application: **14.01.2026**
(21) Application number: 24767034.2
(22) Date of filing: 01.03.2024
(51) Int. Cl.: G03F 7/11, C07F 7/18, C08G 77/28, C09D 5/00, C09D 7/20, C09D 7/61, C09D 183/04, G03F 7/20

(54) **COMPOSITION FOR FORMING SILICON-CONTAINING RESIST UNDERLAYER FILM**

(30) Priority: 03.03.2023 JP 2023032573
(71) Applicant: Nissan Chemical Corporation, Tokyo 103-6119 (JP)
(72) Inventor: SAIJO, Taiki, Toyama-shi, Toyama 939-2792 (JP); SHIBAYAMA, Wataru, Toyama-shi, Toyama 939-2792 (JP)
(74) Representative: Müller-Boré & Partner Patentanwälte PartG mbB
(86) International application number: PCT/JP2024/007687
(87) International publication number: WO 2024/185665

(57) **Abstract**

A silicon-containing resist underlayer film-forming composition including: a polysiloxane as a component [A]; and a solvent as a component [C], in which the polysiloxane contains a constituent unit derived from a hydrolyzable silane (A) having at least one of an arylsulfonyl group having an iodine atom directly bonded to an aromatic ring or an arylthioester group having an iodine atom directly bonded to an aromatic ring.

## Description

### Technical Field

The present invention relates to a silicon-containing resist underlayer film-forming composition.

### Background Art

Conventionally, microfabrication by lithography using a photoresist has been performed in the production of a semiconductor device. The microfabrication is a processing method including: forming a photoresist thin film on a semiconductor substrate such as a silicon wafer; irradiating the thin film with active rays such as ultraviolet rays through a mask pattern having a semiconductor device pattern drawn thereon; developing the irradiated thin film; and etching the substrate with the resultant photoresist pattern serving as a protective film to form, on the surface of the substrate, fine irregularities corresponding to the pattern.

In recent years, as a result of an increase in the degree of integration of semiconductor devices, active rays having a shorter wavelength have tended to be used, with a shift from KrF excimer laser (248 nm) to ArF excimer laser (193 nm). The use of such active rays having a shorter wavelength causes a serious problem in terms of reflection of active rays from a semiconductor substrate. In order to avoid such a problem, there has been widely used a method of providing a resist underlayer film called anti-reflective coating (Bottom Anti-Reflective Coating, BARC) between a photoresist and a to-be-processed substrate.

As an advanced microfabrication technology, mass production of devices at the 10 nm node using double patterning with ArF immersion lithography has been carried out. As a next generation technology, preparations are underway for mass production of devices at the 7 nm node using double patterning with ArF immersion lithography. Extreme ultraviolet (EUV) lithography at a wavelength of 13.5 nm is being considered as a candidate for a mass production technology for the 5 nm node, which is a next generation technology.

As a resist underlayer film-forming composition for EUV lithography, a silicon-containing resist underlayer film-forming composition for EUV lithography containing a thermosetting silicon-containing material having a specific repeating unit containing iodine, and a crosslinking catalyst has been proposed (Patent Literature 1).

### Citation List

### Patent Literature

Patent Literature 1: JP 2020-84175 A

### Summary of Invention

### Technical Problem

In semiconductor device processing, in order to improve productivity, an increase in resist sensitivity has been required as one of the methods for shortening an exposure time. In particular, in semiconductor device processing using the most-advanced electron beam (EB) or extreme ultraviolet (EUV) lithography technology, the increase in resist sensitivity is strongly required due to the impact of EB irradiation time and EUV exposure time on productivity.

The present invention has been made in view of such circumstances, and an object of the present invention is to provide a silicon-containing resist underlayer film-forming composition for forming a resist underlayer film capable of increasing resist sensitivity.

### Solution to Problem

As a result of intensive studies to solve the above problem, the present inventors have found that the above problem can be solved, and completed the present invention having the following gist.

That is, the present invention includes the following aspects.
[1] A silicon-containing resist underlayer film-forming composition including:
   a polysiloxane as a component [A]; and
   a solvent as a component [C], wherein
   the polysiloxane contains a constituent unit derived from a hydrolyzable silane (A) having at least one of an arylsulfonyl group having an iodine atom directly bonded to an aromatic ring or an arylthioester group having an iodine atom directly bonded to an aromatic ring.
[2] A silicon-containing resist underlayer film-forming composition including:
   a polysiloxane as a component [A'];
   a hydrolyzable silane (A) having at least one of an arylsulfonyl group having an iodine atom directly bonded to an aromatic ring or an arylthioester group having an iodine atom directly bonded to an aromatic ring as a component [B]; and
   a solvent as a component [C].
[3] The silicon-containing resist underlayer film-forming composition according to [1] or [2], wherein the hydrolyzable silane (A) is a compound represented by Formula (A-1) described below, 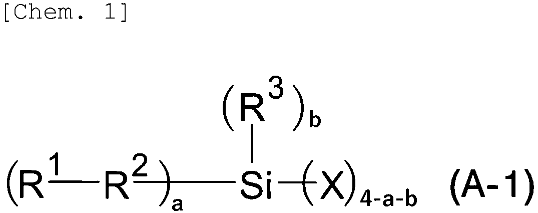 in the Formula (A-1), a represents an integer of 1 to 3;
   b represents an integer of 0 to 2;
   a + b represents an integer of 1 to 3;
   R¹ represents an arylsulfonyl group having an iodine atom directly bonded to an aromatic ring or an arylthioester group having an iodine atom directly bonded to an aromatic ring;
   R² represents a single bond or a divalent linking group;
   R³ represents an alkyl group which may be substituted, an aryl group which may be substituted, an aralkyl group which may be substituted, an alkyl halide group which may be substituted, an aryl halide group which may be substituted, an aralkyl halide group which may be substituted, an alkoxyalkyl group which may be substituted, an alkoxyaryl group which may be substituted, an alkoxyaralkyl group which may be substituted, or an alkenyl group which may be substituted, or an organic group having an epoxy group, an organic group having an acryloyl group, an organic group having a methacryloyl group, an organic group having a mercapto group, an organic group having an amino group, an organic group having an alkoxy group, an organic group having a sulfonyl group, or an organic group having a cyano group, or a combination of two or more thereof;
   X represents an alkoxy group, an aralkyloxy group, an acyloxy group, or a halogen atom; and
   when a plurality of R¹s, a plurality of R²s, a plurality of R³s, and a plurality of Xs are present, the plurality of R¹s, the plurality of R²s, the plurality of R³s, and the plurality of Xs may be the same or different from each other.
[4] The silicon-containing resist underlayer film-forming composition according to [3], wherein R¹ in the Formula (A-1) is represented by Formula (A-1-1) or Formula (A-1-2) described below, 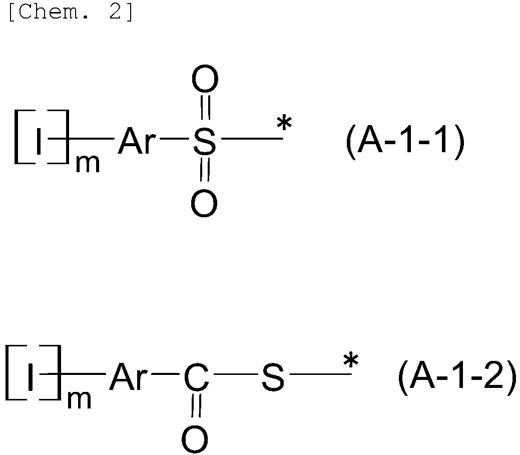
   in the Formulae (A-1-1) and (A-1-2), each Ar independently represents an aromatic hydrocarbon group which may have a substituent;
   m represents an integer of 1 to x, where x represents the number of substituents which can be bonded to an aromatic hydrocarbon ring in the Ar; and
   * represents a bond.
[5] The silicon-containing resist underlayer film-forming composition according to [4], wherein the Ar in the Formulae (A-1-1) and (A-1-2) represents a benzene ring, and m represents an integer of 1 to 5.
[6] The silicon-containing resist underlayer film-forming composition according to any one of [1] to [5], wherein the component [C] contains an alcohol-based solvent.
[7] The silicon-containing resist underlayer film-forming composition according to [6], wherein the component [C] contains a propylene glycol monoalkyl ether.
[8] The silicon-containing resist underlayer film-forming composition according to any one of [1] to [7], further containing a curing catalyst as a component [D].
[9] The silicon-containing resist underlayer film-forming composition according to any one of [1] to [8], further containing a nitric acid as a component [E].
[10] A resist underlayer film which is a cured product of the silicon-containing resist underlayer film-forming composition according to any one of [1] to [9].
[11] A semiconductor processing substrate including: a semiconductor substrate; and the resist underlayer film according to [10].
[12] A method for producing a semiconductor element, the method including:
   a step of forming an organic underlayer film on a substrate;
   a step of forming a resist underlayer film on the organic underlayer film using the silicon-containing resist underlayer film-forming composition according to any one of [1] to [9]; and
   a step of forming a resist film on the resist underlayer film.
[13] A pattern forming method, including:
   a step of forming an organic underlayer film on a semiconductor substrate;
   a step of applying the silicon-containing resist underlayer film-forming composition according to any one of [1] to [9] on the organic underlayer film and baking the silicon-containing resist underlayer film-forming composition to form a resist underlayer film;
   a step of forming a resist film on the resist underlayer film;
   a step of exposing and developing the resist film to obtain a resist pattern;
   a step of etching the resist underlayer film using the resist pattern as a mask; and
   a step of etching the organic underlayer film using the patterned resist underlayer film as a mask.
[14] The pattern forming method according to [13], further including:
   a step of removing the resist underlayer film by a wet method using a chemical solution after the step of etching the organic underlayer film.
[15] A hydrolyzable silane having at least one of an arylsulfonyl group having an iodine atom directly bonded to an aromatic ring or an arylthioester group having an iodine atom directly bonded to an aromatic ring.
[16] The hydrolyzable silane according to [15], wherein the hydrolyzable silane is a compound represented by Formula (A-1) described below, 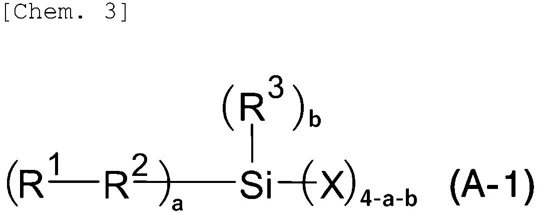 in the Formula (A-1), a represents an integer of 1 to 3;
   b represents an integer of 0 to 2;
   a + b represents an integer of 1 to 3;
   R¹ represents an arylsulfonyl group having an iodine atom directly bonded to an aromatic ring or an arylthioester group having an iodine atom directly bonded to an aromatic ring;
   R² represents a single bond or a divalent linking group;
   R³ represents an alkyl group which may be substituted, an aryl group which may be substituted, an aralkyl group which may be substituted, an alkyl halide group which may be substituted, an aryl halide group which may be substituted, an aralkyl halide group which may be substituted, an alkoxyalkyl group which may be substituted, an alkoxyaryl group which may be substituted, an alkoxyaralkyl group which may be substituted, or an alkenyl group which may be substituted, or an organic group having an epoxy group, an organic group having an acryloyl group, an organic group having a methacryloyl group, an organic group having a mercapto group, an organic group having an amino group, an organic group having an alkoxy group, an organic group having a sulfonyl group, or an organic group having a cyano group, or a combination of two or more thereof;
   X represents an alkoxy group, an aralkyloxy group, an acyloxy group, or a halogen atom; and
   when a plurality of R¹s, a plurality of R²s, a plurality of R³s, and a plurality of Xs are present, the plurality of R¹s, the plurality of R²s, the plurality of R³s, and the plurality of Xs may be the same or different from each other.
[17] The hydrolyzable silane according to [16], wherein R¹ in the Formula (A-1) is represented by Formula (A-1-1) or Formula (A-1-2) described below, 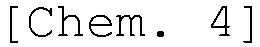 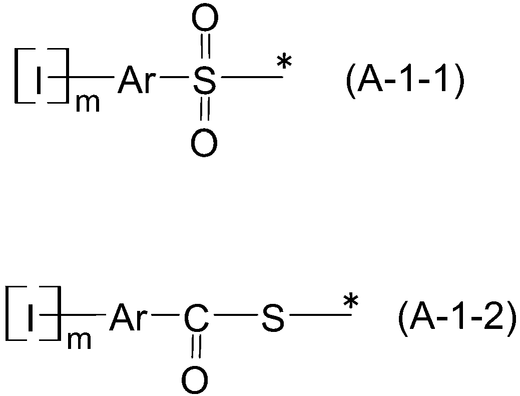
   in the Formulae (A-1-1) and (A-1-2), each Ar independently represents an aromatic hydrocarbon group which may have a substituent;
   m represents an integer of 1 to x, where x represents the number of substituents which can be bonded to an aromatic hydrocarbon ring in the Ar; and
   * represents a bond.
[18] A polysiloxane containing a constituent unit derived from the hydrolyzable silane according to any one of [15] to [17].

### Advantageous Effects of Invention

According to the present invention, it is possible to provide the silicon-containing resist underlayer film-forming composition for forming a resist underlayer film capable of increasing resist sensitivity.

### Description of Embodiments

### (Silicon-Containing Resist Underlayer Film-Forming Composition)

### <First Embodiment>

A first embodiment of a silicon-containing resist underlayer film-forming composition of the present invention contains a polysiloxane as a component [A] and a solvent as a component [C], and further contains an additional component, as necessary.

The polysiloxane as the component [A] contains a constituent unit (monomer unit or repeating unit) derived from a hydrolyzable silane (A) having at least one of an arylsulfonyl group having an iodine atom directly bonded to an aromatic ring or an arylthioester group having an iodine atom directly bonded to an aromatic ring.

The polysiloxane is also a subject of the present invention.

In addition, the hydrolyzable silane (A) having at least one of an arylsulfonyl group having an iodine atom directly bonded to an aromatic ring or an arylthioester group having an iodine atom directly bonded to an aromatic ring is also a subject of the present invention.

### <Second Embodiment>

A second embodiment of the silicon-containing resist underlayer film-forming composition of the present invention contains a polysiloxane as a component [A'], a hydrolyzable silane (A) having at least one of an arylsulfonyl group having an iodine atom directly bonded to an aromatic ring or an arylthioester group having an iodine atom directly bonded to an aromatic ring as a component [B], and a solvent as a component [C], and further contains an additional component, as necessary.

When a resist underlayer film containing the silicon-containing resist underlayer film-forming composition of the present invention has at least one of an arylsulfonyl group having an iodine atom directly bonded to an aromatic ring or an arylthioester group having an iodine atom directly bonded to an aromatic ring, the resist sensitivity can be improved.

The present inventors consider that both an iodine atom and a sulfonyl bond [-S(O)₂-] contribute to the improvement of the resist sensitivity.

The present inventors consider that both an iodine atom and a thioester bond [-S(=O)C-] contribute to the improvement of the resist sensitivity.

Hereinafter, the "arylsulfonyl group having an iodine atom directly bonded to an aromatic ring" and the "arylthioester group having an iodine atom directly bonded to an aromatic ring" may be referred to as an "iodine atom-containing group".

### <Hydrolyzable Silane (A)>

The "iodine atom-containing group" (specifically, an arylsulfonyl group having an iodine atom directly bonded to an aromatic ring or an arylthioester group having an iodine atom directly bonded to an aromatic ring) contained in the hydrolyzable silane (A) having at least one of an arylsulfonyl group having an iodine atom directly bonded to an aromatic ring and an arylthioester group having an iodine atom directly bonded to an aromatic ring (hereinafter, may be referred to as "hydrolyzable silane (A)") may be directly bonded (single bond) to a silicon atom or may be bonded via a linking group, and is preferably bonded via a linking group. Examples of the linking group include a hydrocarbon group having 1 to 20 carbon atoms which may be interrupted by an oxygen atom, a sulfur atom, or an amide bond, -O-, -S-, -NHCO-, or -CONH-.

The hydrolyzable silane (A) may have two or more iodine atom-containing groups. In that case, two or more "iodine atom-containing groups" may have the same structure or different structures. In addition, the two or more "iodine atom-containing groups" may be each bonded to one linking group bonded to a silicon atom, and the two or more "iodine atom-containing groups" may be each directly bonded to a silicon atom, or may be bonded via different linking groups.

In one "iodine atom-containing group", the number of iodine atoms directly bonded to an aromatic ring may be one or may be two or more.

The arylsulfonyl group having an iodine atom directly bonded to an aromatic ring is represented by, for example, the following Formula (A-1-1).

The arylthioester group having an iodine atom directly bonded to an aromatic ring is represented by, for example, the following Formula (A-1-2).

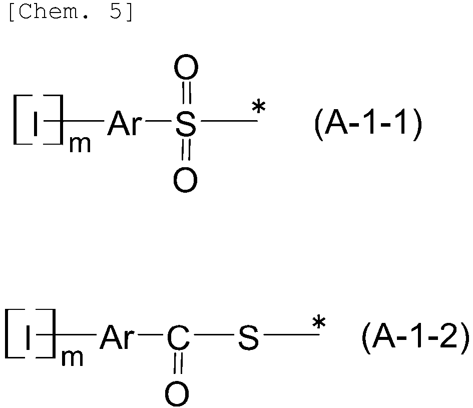

In Formulae (A-1-1) and (A-1-2), each Ar independently represents an aromatic hydrocarbon group which may have a substituent.

m represents an integer of 1 to x (x represents the number of substituents which can be bonded to an aromatic hydrocarbon ring in the Ar).

* represents a bond.

Examples of Ar in Formulae (A-1-1) and (A-1-2) include a benzene ring which may have a substituent, a naphthalene ring which may have a substituent, and an anthracene ring which may have a substituent. Examples of the substituent include an alkyl group having 1 to 6 carbon atoms and an alkoxy group having 1 to 6 carbon atoms.

When Ar in Formulae (A-1-1) and (A-1-2) is a benzene ring, m is an integer of 1 to 5.

When Ar in Formulae (A-1-1) and (A-1-2) is a naphthalene ring, m is an integer of 1 to 7.

Ar in Formulae (A-1-1) and (A-1-2) preferably represents a benzene ring. In that case, m in Formulae (A-1-1) and (A-1-2) preferably represents an integer of 1 to 5.

The hydrolyzable silane (A) is preferably a compound represented by the following Formula (A-1).

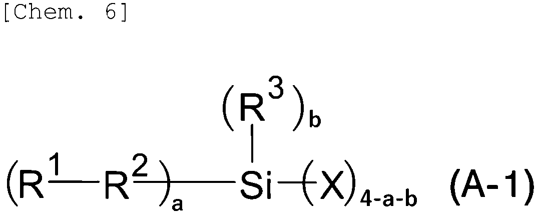

In Formula (A-1), a represents an integer of 1 to 3.
b represents an integer of 0 to 2.
a + b represents an integer of 1 to 3.
R¹ represents an arylsulfonyl group having an iodine atom directly bonded to an aromatic ring or an arylthioester group having an iodine atom directly bonded to an aromatic ring.
R² represents a single bond or a divalent linking group.
R³ represents an alkyl group which may be substituted, an aryl group which may be substituted, an aralkyl group which may be substituted, an alkyl halide group which may be substituted, an aryl halide group which may be substituted, an aralkyl halide group which may be substituted, an alkoxyalkyl group which may be substituted, an alkoxyaryl group which may be substituted, an alkoxyaralkyl group which may be substituted, or an alkenyl group which may be substituted, or an organic group having an epoxy group, an organic group having an acryloyl group, an organic group having a methacryloyl group, an organic group having a mercapto group, an organic group having an amino group, an organic group having an alkoxy group, an organic group having a sulfonyl group, or an organic group having a cyano group, or a combination of two or more thereof.
X represents an alkoxy group, an aralkyloxy group, an acyloxy group, or a halogen atom.

When a plurality of R¹s, a plurality of R²s, a plurality of R³s, and a plurality of Xs are present, the plurality of R¹s, the plurality of R²s, the plurality of R³s, and the plurality of Xs may be the same or different from each other.

An R¹-R²- group and an R³- group are different groups.

Specific examples and preferred aspects of the arylsulfonyl group having an iodine atom directly bonded to an aromatic ring of R¹ include specific examples and preferred aspects of the arylsulfonyl group having an iodine atom directly bonded to an aromatic ring of the hydrolyzable silane (A) described above.

Specific examples and preferred aspects of the arylthioester group having an iodine atom directly bonded to an aromatic ring of R¹ include specific examples and preferred aspects of the arylthioester group having an iodine atom directly bonded to an aromatic ring of the hydrolyzable silane (A) described above.

R¹ in Formula (A-1) is preferably represented by Formula (A-1-1) or (A-1-2) described above.

Examples of the divalent linking group of R² in Formula (A-1) include a hydrocarbon group having 1 to 20 carbon atoms which may be interrupted by an oxygen atom, a sulfur atom, or an amide bond, -O- (ether bond), -S- (sulfide bond), -NHCO-, or -CONH- (both are amide bonds).

Examples of the hydrocarbon group having 1 to 20 carbon atoms include an alkylene group having 1 to 20 carbon atoms. The alkylene group having 1 to 20 carbon atoms may be linear, branched, cyclic, or a combination of two or more thereof. The alkylene group preferably has 1 to 10 carbon atoms and more preferably has 1 to 6 carbon atoms. Examples of such an alkylene group include a methylene group, an ethylene group, a trimethylene group, a tetramethylene group, a pentamethylene group, a hexamethylene group, a heptamethylene group, an octamethylene group, a nonamethylene group, and a decamethylene group.

Examples of the hydrocarbon group having 1 to 20 carbon atoms include an o-phenylene group, an m-phenylene group, and a p-phenylene group.

Examples of the hydrocarbon group having 1 to 20 carbon atoms include a group in which one or more methylene groups in an alkylene group are substituted with an o-phenylene group, an m-phenylene group, or a p-phenylene group.

Among them, a methylene group, an ethylene group, and a trimethylene group are preferable as a linking group.

Examples of the hydrocarbon group having 1 to 20 carbon atoms which may be interrupted by an oxygen atom, a sulfur atom or an amide bond include a group containing a structural unit -CH₂-O-, -CH₂-S-, -CH₂-NHCO- or -CH₂-CONH-.

Specific examples thereof include a divalent group obtained by removing one hydrogen atom from a methoxy group, an ethoxy group, a propoxy group, a butoxy group, a methylthio group, an ethylthio group, a propylthio group, a butylthio group, a methylcarbonylamino group, an ethylcarbonylamino group, a propylcarbonylamino group, a butylcarbonylamino group, a methylaminocarbonyl group, an ethylaminocarbonyl group, a propylaminocarbonyl group, a butylaminocarbonyl group, and the like, and further include a divalent group obtained by removing one hydrogen atom from a methyl group, an ethyl group, a propyl group, a butyl group, a pentyl group, a hexyl group, a heptyl group, an octyl group, a nonyl group, a decyl group, a dodecyl group, or an octadecyl group, in which one or more hydrogen atoms of each group may be substituted with a methoxy group, an ethoxy group, a propoxy group, a butoxy group, a methylthio group, an ethylthio group, propylthio group, a butylthio group, a methylcarbonylamino group, an ethylcarbonylamino group, a methylaminocarbonyl group, an ethylaminocarbonyl group, or the like.

### <<R³ in Formula (A-1)>>

The alkyl group may be linear, branched, or cyclic, and preferably has, but is not particularly limited to, 40 or less carbon atoms, more preferably 30 or less carbon atoms, still more preferably 20 or less carbon atoms, and yet still more preferably 10 or less carbon atoms.

Specific examples of the linear or branched alkyl group as the alkyl group include a methyl group, ethyl group, n-propyl group, i-propyl group, n-butyl group, i-butyl group, s-butyl group, t-butyl group, n-pentyl group, 1-methyl-n-butyl group, 2-methyl-n-butyl group, 3-methyl-n-butyl group, 1,1-dimethyl-n-propyl group, 1,2-dimethyl-n-propyl group, 2,2-dimethyl-n-propyl group, 1-ethyl-n-propyl group, n-hexyl group, 1-methyl-n-pentyl group, 2-methyl-n-pentyl group, 3-methyl-n-pentyl group, 4-methyl-n-pentyl group, 1,1-dimethyl-n-butyl group, 1,2-dimethyl-n-butyl group, 1,3-dimethyl-n-butyl group, 2,2-dimethyl-n-butyl group, 2,3-dimethyl-n-butyl group, 3,3-dimethyl-n-butyl group, 1-ethyl-n-butyl group, 2-ethyl-n-butyl group, 1,1,2-trimethyl-n-propyl group, 1,2,2-trimethyl-n-propyl group, 1-ethyl-1-methyl-n-propyl group, and 1-ethyl-2-methyl-n-propyl group.

In the present specification, "i" means "iso", "s" means "sec", and "t" means "tert".

Specific examples of the cyclic alkyl group include cycloalkyl groups, such as cyclopropyl group, cyclobutyl group, 1-methyl-cyclopropyl group, 2-methyl-cyclopropyl group, cyclopentyl group, 1-methyl-cyclobutyl group, 2-methyl-cyclobutyl group, 3-methyl-cyclobutyl group, 1,2-dimethyl-cyclopropyl group, 2,3-dimethyl-cyclopropyl group, 1-ethyl-cyclopropyl group, 2-ethyl-cyclopropyl group, cyclohexyl group, 1-methyl-cyclopentyl group, 2-methyl-cyclopentyl group, 3-methyl-cyclopentyl group, 1-ethyl-cyclobutyl group, 2-ethyl-cyclobutyl group, 3-ethyl-cyclobutyl group, 1,2-dimethyl-cyclobutyl group, 1,3-dimethyl-cyclobutyl group, 2,2-dimethyl-cyclobutyl group, 2,3-dimethyl-cyclobutyl group, cycloalkyl groups, such as 2,4-dimethyl-cyclobutyl group, 3,3-dimethyl-cyclobutyl group, 1-n-propyl-cyclopropyl group, 2-n-propyl-cyclopropyl group, 1-i-propyl-cyclopropyl group, 2-i-propyl-cyclopropyl group, 1,2,2-trimethyl-cyclopropyl group, 1,2,3-trimethyl-cyclopropyl group, 2,2,3-trimethyl-cyclopropyl group, 1-ethyl-2-methyl-cyclopropyl group, 2-ethyl-1-methyl-cyclopropyl group, 2-ethyl-2-methyl-cyclopropyl group, and 2-ethyl-3-methyl-cyclopropyl group; and crosslinked cyclic cycloalkyl groups, such as bicyclobutyl group, bicyclopentyl group, bicyclohexyl group, bicycloheptyl group, bicyclooctyl group, bicyclononyl group, and bicyclodecyl group.

The aryl group may be any of a phenyl group, a monovalent group derived by removing one hydrogen atom of a condensed ring aromatic hydrocarbon compound, and a monovalent group derived by removing one hydrogen atom of a ring-linked aromatic hydrocarbon compound, and preferably has, but is not particularly limited to, 40 or less carbon atoms, more preferably 30 or less carbon atoms, and still more preferably 20 or less carbon atoms.

Examples of the aryl group include an aryl group having 6 to 20 carbon atoms, and examples thereof include, but are not limited to, a phenyl group, 1-naphthyl group, 2-naphthyl group, 1-anthryl group, 2-anthryl group, 9-anthryl group, 1-phenanthryl group, 2-phenanthryl group, 3-phenanthryl group, 4-phenanthryl group, 9-phenanthryl group, 1-naphthacenyl group, 2-naphthacenyl group, 5-naphthacenyl group, 2-chrysenyl group, 1-pyrenyl group, 2-pyrenyl group, pentacenyl group, benzopyrenyl group, and triphenylenyl group, biphenyl-2-yl group (o-biphenylyl group), biphenyl-3-yl group (m-biphenylyl group), biphenyl-4-yl group (p-biphenylyl group), paraterphenyl-4-yl group, metaterphenyl-4-yl group, orthoterphenyl-4-yl group, 1,1'-binaphthyl-2-yl group, and 2,2'-binaphthyl-1-yl group.

The aralkyl group is an alkyl group substituted with an aryl group, and specific examples of the aryl group and the alkyl group are the same as those described above. The aralkyl group preferably has, but is not particularly limited to, 40 or less carbon atoms, more preferably 30 or less carbon atoms, and still more preferably 20 or less carbon atoms.

Specific examples of the aralkyl group include a phenylmethyl group (benzyl group), 2-phenylethylene group, 3-phenyl-n-propyl group, 4-phenyl-n-butyl group, 5-phenyl-n-pentyl group, 6-phenyl-n-hexyl group, 7-phenyl-n-heptyl group, 8-phenyl-n-octyl group, 9-phenyl-n-nonyl group, and 10 phenyl-n-decyl group, but are not limited thereto.

The alkyl halide group, the aryl halide group, and the aralkyl halide group are respectively an alkyl group, an aryl group, and an aralkyl group, substituted with one or more halogen atoms, and specific examples of such an alkyl group, an aryl group, and an aralkyl group include the same groups as those described above.

Examples of the halogen atom include a fluorine atom, a chlorine atom, a bromine atom, and an iodine atom.

The alkyl halide group preferably has, but is not particularly limited to, 40 or less carbon atoms, more preferably 30 or less carbon atoms, still more preferably 20 or less carbon atoms, and yet still more preferably 10 or less carbon atoms.

Specific examples of the alkyl halide group include a monofluoromethyl group, a difluoromethyl group, a trifluoromethyl group, a bromodifluoromethyl group, a 2-chloroethyl group, a 2-bromoethyl group, a 1,1-difluoroethyl group, a 2,2,2-trifluoroethyl group, a 1,1,2,2-tetrafluoroethyl group, a 2-chloro-1,1,2-trifluoroethyl group, a pentafluoroethyl group, a 3-bromopropyl group, a 2,2,3,3-tetrafluoropropyl group, a 1,1,2,3,3,3-hexafluoropropyl group, a 1,1,1,3,3,3-hexafluoropropane-2-yl group, a 3-bromo-2-methylpropyl group, a 4-bromobutyl group, and a perfluoropentyl group, but are not limited thereto.

The aryl halide group preferably has, but is not particularly limited to, 40 or less carbon atoms, more preferably 30 or less carbon atoms, and still more preferably 20 or less carbon atoms.

Specific examples of the aryl halide group include a 2-fluorophenyl group, a 3-fluorophenyl group, a 4-fluorophenyl group, a 2,3-difluorophenyl group, a 2,4-difluorophenyl group, a 2,5-difluorophenyl group, a 2,6-difluorophenyl group, a 3,4-difluorophenyl group, a 3,5-difluorophenyl group, a 2,3,4-trifluorophenyl group, a 2,3,5-trifluorophenyl group, a 2,3,6-trifluorophenyl group, a 2,4,5-trifluorophenyl group, a 2,4,6-trifluorophenyl group, a 3,4,5-trifluorophenyl group, a 2,3,4,5-tetrafluorophenyl group, a 2,3,4,6-tetrafluorophenyl group, a 2,3,5,6-tetrafluorophenyl group, a pentafluorophenyl group, a 2-fluoro-1-naphthyl group, a 3-fluoro-1-naphthyl group, a 4-fluoro-1-naphthyl group, a 6-fluoro-1-naphthyl group, a 7-fluoro-1-naphthyl group, an 8-fluoro-1-naphthyl group, a 4,5-difluoro-1-naphthyl group, a 5,7-difluoro-1-naphthyl group, a 5,8-difluoro-1-naphthyl group, a 5,6,7,8-tetrafluoro-1-naphthyl group, a heptafluoro-1-naphthyl group, a 1-fluoro-2-naphthyl group, a 5-fluoro-2-naphthyl group, a 6-fluoro-2-naphthyl group, a 7-fluoro-2-naphthyl group, a 5,7-difluoro-2-naphthyl group, and a heptafluoro-2-naphthyl group, and groups obtained as fluorine atoms (fluoro groups) of the groups are optionally substituted with chlorine atoms (chloro groups), bromine atoms (bromo groups), and iodine atoms (iodine groups), but are not limited thereto.

The aralkyl halide group preferably has, but is not particularly limited to, 40 or less carbon atoms, more preferably 30 or less carbon atoms, and still more preferably 20 or less carbon atoms.

Specific examples of the aralkyl halide group include a 2-fluorobenzyl group, a 3-fluorobenzyl group, a 4-fluorobenzyl group, a 2,3-difluorobenzyl group, a 2,4-difluorobenzyl group, a 2,5-difluorobenzyl group, a 2,6-difluorobenzyl group, a 3,4-difluorobenzyl group, a 3,5-difluorobenzyl group, a 2,3,4-trifluorobenzyl group, a 2,3,5-trifluorobenzyl group, a 2,3,6-trifluorobenzyl group, a 2,4,5-trifluorobenzyl group, a 2,4,6-trifluorobenzyl group, a 2,3,4,5-tetrafluorobenzyl group, a 2,3,4,6-tetrafluorobenzyl group, a 2,3,5,6-tetrafluorobenzyl group, a 2,3,4,5,6-pentafluorobenzyl group, and groups obtained as fluorine atoms (fluoro groups) of the groups are optionally substituted with chlorine atoms (chloro groups), bromine atoms (bromo groups), and iodine atoms (iodine groups), but are not limited thereto.

The alkoxyalkyl group, the alkoxyaryl group, and the alkoxyaralkyl group are respectively an alkyl group substituted with one or more alkoxy groups, an aryl group substituted with one or more alkoxy groups, and an aralkyl group substituted with one or more alkoxy groups, and specific examples of such an alkyl group, an aryl group, and an aralkyl group include the same groups as those described above.

Examples of the alkoxy group as a substituent group include an alkoxy group having at least one of a linear, branched, or cyclic alkyl moiety having 1 to 20 carbon atoms.

Examples of the linear or branched alkoxy group include a methoxy group, ethoxy group, n-propoxy group, i-propoxy group, n-butoxy group, i-butoxy group, s-butoxy group, t-butoxy group, n-pentyloxy group, 1-methyl-n-butoxy group, 2-methyl-n-butoxy group, 3-methyl-n-butoxy group, 1,1-dimethyl-n-propoxy group, 1,2-dimethyl-n-propoxy group, 2,2-dimethyl-n-propoxy group, 1-ethyl-n-propoxy group, n-hexyloxy group, 1-methyl-n-pentyloxy group, 2-methyl-n-pentyloxy group, 3-methyl-n-pentyloxy group, 4-methyl-n-pentyloxy group, 1,1-dimethyl-n-butoxy group, 1,2-dimethyl-n-butoxy group, 1,3-dimethyl-n-butoxy group, 2,2-dimethyl-n-butoxy group, 2,3-dimethyl-n-butoxy group, 3,3-dimethyl-n-butoxy group, 1-ethyl-n-butoxy group, 2-ethyl-n-butoxy group, 1,1,2-trimethyl-n-propoxy group, 1,2,2-trimethyl-n-propoxy group, 1-ethyl-1-methyl-n-propoxy group, and 1-ethyl-2-methyl-n-propoxy group.

Examples of the cyclic alkoxy group include a cyclopropoxy group, cyclobutoxy group, 1-methyl-cyclopropoxy group, 2-methyl-cyclopropoxy group, cyclopentyloxy group, 1-methyl-cyclobutoxy group, 2-methyl-cyclobutoxy group, 3-methyl-cyclobutoxy group, 1,2-dimethyl-cyclopropoxy group, 2,3-dimethyl-cyclopropoxy group, 1-ethyl-cyclopropoxy group, 2-ethyl-cyclopropoxy group, cyclohexyloxy group, 1-methyl-cyclopentyloxy group, 2-methyl-cyclopentyloxy group, 3-methyl-cyclopentyloxy group, 1-ethyl-cyclobutoxy group, 2-ethyl-cyclobutoxy group, 3-ethyl-cyclobutoxy group, 1,2-dimethyl-cyclobutoxy group, 1,3-dimethyl-cyclobutoxy group, 2,2-dimethyl-cyclobutoxy group, 2,3-dimethyl-cyclobutoxy group, 2,4-dimethyl-cyclobutoxy group, 3,3-dimethyl-cyclobutoxy group, 1-n-propyl-cyclopropoxy group, 2-n-propyl-cyclopropoxy group, 1-i-propyl-cyclopropoxy group, 2-i-propyl-cyclopropoxy group, 1,2,2-trimethyl-cyclopropoxy group, 1,2,3-trimethyl-cyclopropoxy group, 2,2,3-trimethyl-cyclopropoxy group, 1-ethyl-2-methyl-cyclopropoxy group, 2-ethyl-1-methyl-cyclopropoxy group, 2-ethyl-2-methyl-cyclopropoxy group, and 2-ethyl-3-methyl-cyclopropoxy group.

Specific examples of the alkoxyalkyl group include, but are not limited to, lower (about 5 or less carbon atoms) alkyloxy-lower (about 5 or less carbon atoms) alkyl groups such as a methoxymethyl group, an ethoxymethyl group, a 1-ethoxyethyl group, a 2-ethoxyethyl group, and an ethoxymethyl group.

Specific examples of the alkoxyaryl group include, but are not limited to, a 2-methoxyphenyl group, 3-methoxyphenyl group, 4-methoxyphenyl group, 2-(1-ethoxy)phenyl group, 3-(1-ethoxy)phenyl group, 4-(1-ethoxy)phenyl group, 2-(2-ethoxy)phenyl group, 3-(2-ethoxy)phenyl group, 4-(2-ethoxy)phenyl group, 2-methoxynaphthalene-1-yl group, 3-methoxynaphthalene-1-yl group, 4-methoxynaphthalene-1-yl group, 5-methoxynaphthalene-1-yl group, 6-methoxynaphthalene-1-yl group, and 7-methoxynaphthalene-1-yl group.

Specific examples of the alkoxyaralkyl group include, but are not limited to, a 3-(methoxyphenyl)benzyl group and a 4-(methoxyphenyl)benzyl group.

The alkenyl group may be linear or branched, and preferably has, but is not particularly limited to, 40 or less carbon atoms, more preferably 30 or less carbon atoms, still more preferably 20 or less carbon atoms, and yet still more preferably 10 or less carbon atoms.

Specific examples of the alkenyl group include an ethenyl group (vinyl group), a 1-propenyl group, a 2-propenyl group, a 1-methyl-1-ethenyl group, a 1-butenyl group, a 2-butenyl group, a 3-butenyl group, a 2-methyl-1-propenyl group, a 2-methyl-2-propenyl group, a 1-ethylethenyl group, a 1-methyl-1-propenyl group, a 1-methyl-2-propenyl group, a 1-pentenyl group, a 2-pentenyl group, a 3-pentenyl group, a 4-pentenyl group, a 1-n-propylethenyl group, a 1-methyl-1-butenyl group, a 1-methyl-2-butenyl group, a 1-methyl-3-butenyl group, a 2-ethyl-2-propenyl group, a 2-methyl-1-butenyl group, 2-methyl-2-butenyl group, 2-methyl-3-butenyl group, 3-methyl-1-butenyl group, 3-methyl-2-butenyl group, 3-methyl-3-butenyl group, 1,1-dimethyl-2-propenyl group, 1-i-propylethenyl group, a 1,2-dimethyl-1-propenyl group, a 1,2-dimethyl-2-propenyl group, a 1-cyclopentenyl group, a 2-cyclopentenyl group, a 3-cyclopentenyl group, a 1-hexenyl group, a 2-hexenyl group, a 3-hexenyl group, a 4-hexenyl group, a 5-hexenyl group, a 1-methyl-1-pentenyl group, a 1-methyl-2-pentenyl group, a 1-methyl-3-pentenyl group, a 1-methyl-4-pentenyl group, a 1-n-butylethenyl group, a 2-methyl-1-pentenyl group, a 2-methyl-2-pentenyl group, a 2-methyl-3-pentenyl group, a 2-methyl-4-pentenyl group, a 2-n-propyl-2-propenyl group, a 3-methyl-1-pentenyl group, a 3-methyl-2-pentenyl group, a 3-methyl-3-pentenyl group, a 3-methyl-4-pentenyl group, a 3-ethyl-3-butenyl group, a 4-methyl-1-pentenyl group, a 4-methyl-2-pentenyl group, a 4-methyl-3-pentenyl group, a 4-methyl-4-pentenyl group, a 1,1-dimethyl-2-butenyl group, a 1,1-dimethyl-3-butenyl group, a 1,2-dimethyl-1-butenyl group, a 1,2-dimethyl-2-butenyl group, a 1,2-dimethyl-3-butenyl group, a 1-methyl-2-ethyl-2-propenyl group, a 1-s-butylethenyl group, a 1,3-dimethyl-1-butenyl group, a 1,3-dimethyl-2-butenyl group, a 1,3-dimethyl-3-butenyl group, a 1-i-butylethenyl group, a 2,2-dimethyl-3-butenyl group, a 2,3-dimethyl-1-butenyl group, a 2,3-dimethyl-2-butenyl group, a 2,3-dimethyl-3-butenyl group, a 2-i-propyl-2-propenyl group, a 3,3-dimethyl-1-butenyl group, a 1-ethyl-1-butenyl group, a 1-ethyl-2-butenyl group, a 1-ethyl-3-butenyl group, a 1-n-propyl-1-propenyl group, a 1-n-propyl-2-propenyl group, a 2-ethyl-1-butenyl group, a 2-ethyl-2-butenyl group, a 2-ethyl-3-butenyl group, a 1,1,2-trimethyl-2-propenyl group, a 1-t-butylethenyl group, a 1-methyl-1-ethyl-2-propenyl group, a 1-ethyl-2-methyl-1-propenyl group, a 1-ethyl-2-methyl-2-propenyl group, a 1-i-propyl-1-propenyl group, a 1-i-propyl-2-propenyl group, a 1-methyl-2-cyclopentenyl group, a 1-methyl-3-cyclopentenyl group, a 2-methyl-1-cyclopentenyl group, a 2-methyl-2-cyclopentenyl group, a 2-methyl-3-cyclopentenyl group, a 2-methyl-4-cyclopentenyl group, a 2-methyl-5-cyclopentenyl group, a 2-methylene-cyclopentyl group, a 3-methyl-1-cyclopentenyl group, a 3-methyl-2-cyclopentenyl group, a 3-methyl-3-cyclopentenyl group, a 3-methyl-4-cyclopentenyl group, a 3-methyl-5-cyclopentenyl group, a 3-methylene-cyclopentyl group, a 1-cyclohexenyl group, a 2-cyclohexenyl group, and a 3-cyclohexenyl group, and examples thereof also include a bridged cyclic alkenyl group such as a bicycloheptenyl group (norbornyl group).

Examples of the substituent in the aforementioned alkyl group, aryl group, aralkyl group, alkyl halide group, aryl halide group, aralkyl halide group, alkoxyalkyl group, alkoxyaryl group, alkoxyaralkyl group, and alkenyl group include an alkyl group, an aryl group, an aralkyl group, an alkyl halide group, an aryl halide group, an aralkyl halide group, an alkoxyalkyl group, an aryloxy group, an alkoxyaryl group, an alkoxyaralkyl group, an alkenyl group, an alkoxy group, and an aralkyloxy group, and specific examples thereof and the suitable number of carbon atoms thereof are the same as those described above or below.

In addition, the aryloxy group described as the substituent group is a group in which an aryl group is bonded via an oxygen atom (-O-), and specific examples of such an aryl group include the same as those described above. The aryloxy group preferably has, but is not particularly limited to, 40 or less carbon atoms, more preferably 30 or less carbon atoms, and still more preferably 20 or less carbon atoms, and specific examples thereof include a phenoxy group and a naphthalene-2-yloxy group, but are not limited thereto.

In addition, when two or more substituents are present, the substituents may be bonded together to form a ring.

Examples of the organic group having an epoxy group include a glycidoxymethyl group, a glycidoxyethyl group, a glycidoxypropyl group, a glycidoxybutyl group, and an epoxycyclohexyl group.

Examples of the organic group having an acryloyl group include an acryloyl methyl group, an acryloyl ethyl group, and an acryloyl propyl group.

Examples of the organic group having a methacryloyl group include a methacryloyl methyl group, a methacryloyl ethyl group, and a methacryloyl propyl group.

Examples of the organic group having a mercapto group include a mercaptoethyl group, a mercaptobutyl group, a mercaptohexyl group, a mercaptooctyl group, and a mercaptophenyl group.

Examples of the organic group having an amino group include, but are not limited to, an amino group, an aminomethyl group, an aminoethyl group, an aminophenyl, a dimethylaminoethyl group, and a dimethylaminopropyl group. The organic group having an amino group will be described later in more detail.

Examples of the organic group having an alkoxy group include, but are not limited to, a methoxymethyl group and a methoxyethyl group. However, the organic group excludes a group in which an alkoxy group is directly bonded to a silicon atom.

Examples of the organic group having a sulfonyl group include, but are not limited to, a sulfonylalkyl group and a sulfonylaryl group.

Examples of the organic group having a cyano group include a cyanoethyl group, a cyanopropyl group, a cyanophenyl, and a thiocyanate group.

Examples of the organic group having an amino group include an organic group having at least one of a primary amino group, a secondary amino group, and a tertiary amino group. A hydrolytic condensate in which a hydrolyzable silane having a tertiary amino group is hydrolyzed with a strong acid to form a counter cation having a tertiary ammonium group can be preferably used. The organic group may contain a heteroatom such as an oxygen atom or a sulfur atom, in addition to the nitrogen atom forming the amino group.

A preferable example of the organic group having an amino group is a group represented by the following Formula (A1).

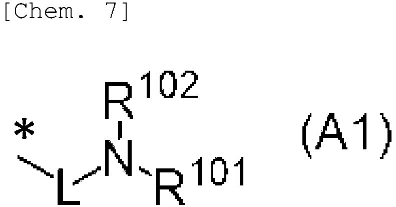

In Formula (A1), R¹⁰¹ and R¹⁰² each independently represent a hydrogen atom or a hydrocarbon group, and L independently represents an alkylene group which may be substituted. * represents a bond.

Examples of the hydrocarbon group include, but are not limited to, an alkyl group, an alkenyl group, and an aryl group. Specific examples of the alkyl group, the alkenyl group, and the aryl group are the same as those described above regarding R³.

The alkylene group may be linear or branched, and the number of carbon atoms of the linear or branched alkylene group is usually 1 to 10, and preferably 1 to 5. Examples of the linear or branched alkylene group include linear alkylene groups such as a methylene group, an ethylene group, a trimethylene group, a tetramethylene group, a pentamethylene group, a hexamethylene group, a heptamethylene group, an octamethylene group, a nonamethylene group, and a decamethylene group.

Examples of the organic group having an amino group include, but are not limited to, an amino group, an aminomethyl group, an aminoethyl group, an aminophenyl, a dimethylaminoethyl group, and a dimethylaminopropyl group.

### <<X in Formula (A-1)>>

Examples of the alkoxy group in X include the alkoxy group exemplified in the description of R³.

Examples of the halogen atom in X include the halogen atom exemplified in the description of R³.

The aralkyloxy group is a monovalent group derived by removing a hydrogen atom from a hydroxy group of aralkyl alcohol, and specific examples of the aralkyl group in the aralkyloxy group are the same as those described above.

The aralkyloxy group has, for example, 40 or less carbon atoms, preferably 30 or less carbon atoms, and more preferably 20 or less carbon atoms, but not particularly limited thereto.

Specific examples of the aralkyloxy group include, but are not limited to, a phenylmethyloxy group (benzyloxy group), 2-phenylethyleneoxy group, 3-phenyl-n-propyloxy group, 4-phenyl-n-butyloxy group, 5-phenyl-n-pentyloxy group, 6-phenyl n-hexyloxy group, 7-phenyl-n-heptyloxy group, 8-phenyl-n-octyloxy group, 9-phenyl-n-nonyloxy group, and 10-phenyl-n-decyloxy group.

The acyloxy group is a monovalent group derived by removing a hydrogen atom from a carboxyl group (-COOH) of a carboxylic acid compound, and examples of the acyloxy group typically include, but are not limited to, an alkylcarbonyloxy group, an arylcarbonyloxy group, or an aralkylcarbonyloxy group, derived by removing a hydrogen atom from a carboxyl group of an alkyl carboxylic acid, an aryl carboxylic acid, or an aralkyl carboxylic acid. Specific examples of the alkyl group, aryl group, and aralkyl group in the alkyl carboxylic acid, aryl carboxylic acid, and aralkyl carboxylic acid are the same as those described above.

Specific examples of the acyloxy group include an acyloxy group having 2 to 20 carbon atoms, and examples thereof include a methylcarbonyloxy group, ethylcarbonyloxy group, n-propylcarbonyloxy group, i-propylcarbonyloxy group, n-butylcarbonyloxy group, i-butylcarbonyloxy group, s-butylcarbonyloxy group, t-butylcarbonyloxy group, n-pentylcarbonyloxy group, 1-methyl-n-butylcarbonyloxy group, 2-methyl-n-butylcarbonyloxy group, 3-methyl-n-butylcarbonyloxy group, 1,1-dimethyl-n-propylcarbonyloxy group, 1,2-dimethyl-n-propylcarbonyloxy group, 2,2-dimethyl-n-propylcarbonyloxy group, 1-ethyl-n-propylcarbonyloxy group, n-hexylcarbonyloxy group, 1-methyl-n-pentylcarbonyloxy group, 2-methyl-n-pentylcarbonyloxy group, 3-methyl-n-pentylcarbonyloxy group, 4-methyl-n-pentylcarbonyloxy group, 1,1-dimethyl-n-butylcarbonyloxy group, 1,2-dimethyl-n-butylcarbonyloxy group, 1,3-dimethyl-n-butylcarbonyloxy group, 2,2-dimethyl-n-butylcarbonyloxy group, 2,3-dimethyl-n-butylcarbonyloxy group, 3,3-dimethyl-n-butylcarbonyloxy group, 1-ethyl-n-butylcarbonyloxy group, 2-ethyl-n-butylcarbonyloxy group, 1,1,2-trimethyl-n-propylcarbonyloxy group, 1,2,2-trimethyl-n-propylcarbonyloxy group, 1-ethyl-1-methyl-n-propylcarbonyloxy group, 1-ethyl-2-methyl-n-propylcarbonyloxy group, phenylcarbonyloxy group, and tosylcarbonyloxy group.

Specific examples of the hydrolyzable silane (A) include the following compounds, but the hydrolyzable silane (A) is not limited to these compounds.

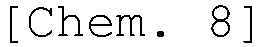

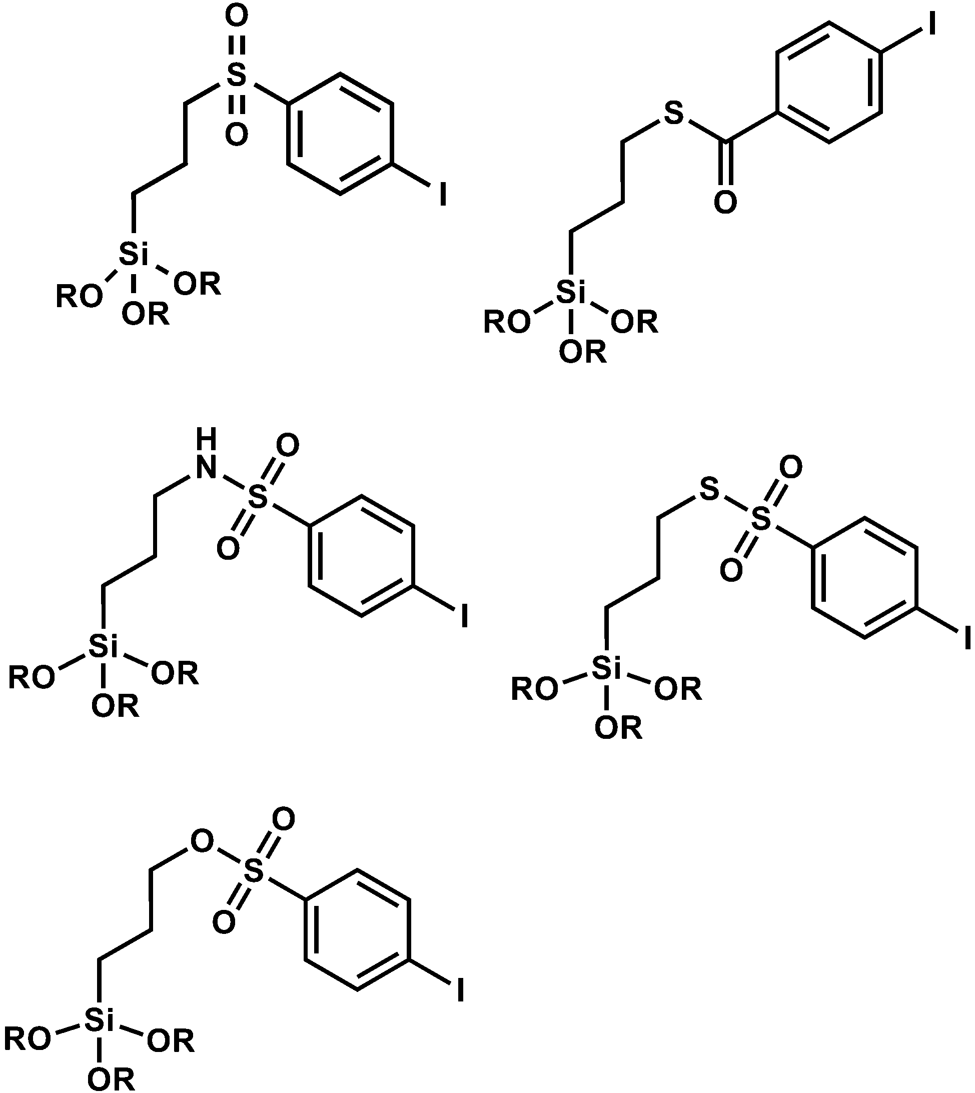

In the formulae, R represents a methyl group or an ethyl group.

The method for synthesizing the hydrolyzable silane (A) is not particularly limited, and the hydrolyzable silane (A) can be produced by, for example, a method for producing a silane compound having a sulfonyl bond as described in WO 2015/198945 A.

In the first embodiment, the amount of the hydrolyzable silane (A) in synthesizing the polysiloxane containing the constituent unit derived from the hydrolyzable silane (A) [A] is preferably 0.01 to 100 parts by mass, or 0.05 to 50 parts by mass, or 0.1 to 30 parts by mass, or 0.1 to 20 parts by mass, or 0.1 to 10 parts by mass, relative to 100 parts by mass of the total amount of the hydrolyzable silane used for synthesizing the polysiloxane, from the viewpoint of more sufficiently achieving the effects of the present invention. Alternatively, the amount is 0.5 to 10 parts by mass, 1 to 8 parts by mass, 2 to 7 parts by mass, and 3 to 6 parts by mass.

In the second embodiment, the content of the hydrolyzable silane (A) as the component [B] in the silicon-containing resist underlayer film-forming composition is preferably 0.01 to 100 parts by mass, or 0.05 to 50 parts by mass, or 0.1 to 30 parts by mass, or 0.1 to 20 parts by mass, or 0.1 to 10 parts by mass, relative to 100 parts by mass of a polysiloxane [A'], from the viewpoint of more sufficiently achieving the effects of the present invention. Alternatively, the amount is 0.5 to 10 parts by mass, 1 to 8 parts by mass, 2 to 7 parts by mass, and 3 to 6 parts by mass.

### <Component [A] and Component [A']: Polysiloxane>

The polysiloxane as the component [A] is not particularly limited as long as it contains the constituent unit derived from the hydrolyzable silane (A) and is a polymer having a siloxane bond.

The polysiloxane as the component [A'] is not particularly limited as long as it is a polymer having a siloxane bond. The polysiloxane as the component [A'] may be the polysiloxane as the component [A].

The polysiloxane may be a modified polysiloxane in which a part of silanol groups is modified, such as a polysiloxane modified product in which a part of silanol groups is alcohol-modified or acetal-protected.

In addition, the polysiloxane may be, as an example, a hydrolytic condensate of a hydrolyzable silane, or may be a modified product in which at least a part of silanol groups of the hydrolytic condensate is alcohol-modified or acetal-protected (hereinafter, sometimes referred to as a "modified product of a hydrolytic condensate"). The hydrolyzable silane corresponding to the hydrolytic condensate may contain one or two or more hydrolyzable silanes.

In addition, the polysiloxane as the component [A] or the component [A'] can have a structure having any of a cage type, a ladder type, a linear type, and a branched type main chain. Furthermore, as the polysiloxane as the component [A'], a commercially available polysiloxane can be used.

In the present invention, the "hydrolytic condensate", that is a product of hydrolysis condensation, of the hydrolyzable silane includes not only a polyorganosiloxane polymer which is a condensate prepared through complete condensation, but also a polyorganosiloxane polymer which is a partial hydrolytic condensate prepared through incomplete condensation. Such a partial hydrolytic condensate is a polymer prepared through hydrolysis and condensation of a hydrolyzable silane compound, as in the case of a condensate prepared through complete condensation. However, the partial hydrolytic condensate contains remaining Si-OH groups, due to partial or incomplete hydrolysis and condensation of the silane compound. In addition, in the silicon-containing resist underlayer film-forming composition, an uncondensed hydrolysate (complete hydrolysate or partial hydrolysate) or a monomer (hydrolyzable silane) may remain, in addition to the hydrolytic condensate.

In the present specification, the "hydrolyzable silane" may also be simply referred to as a "silane compound".

Examples of the polysiloxane as the component [A] include a hydrolytic condensate of a hydrolyzable silane containing the hydrolyzable silane (A) or a modified product thereof.

Examples of the polysiloxane as the component [A] include a hydrolytic condensate of a hydrolyzable silane containing the hydrolyzable silane (A) and at least one hydrolyzable silane represented by the following Formula (1) or a modified product thereof.

Examples of the polysiloxane as the component [A'] include a hydrolytic condensate of a hydrolyzable silane containing at least one hydrolyzable silane represented by the following Formula (1) or a modified product thereof.

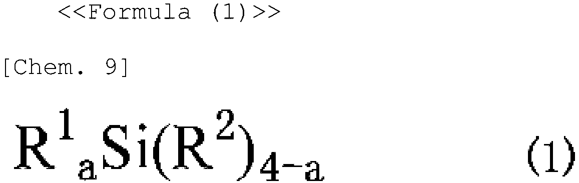

In Formula (1), R¹ is a group bonded to a silicon atom, and each R¹ independently represents an alkyl group which may be substituted, an aryl group which may be substituted, an aralkyl group which may be substituted, an alkyl halide group which may be substituted, an aryl halide group which may be substituted, an aralkyl halide group which may be substituted, an alkoxyalkyl group which may be substituted, an alkoxyaryl group which may be substituted, an alkoxyaralkyl group which may be substituted, or an alkenyl group which may be substituted, or an organic group having an epoxy group, an organic group having an acryloyl group, an organic group having a methacryloyl group, an organic group having a mercapto group, an organic group having an amino group, an organic group having an alkoxy group, an organic group having a sulfonyl group, or an organic group having a cyano group, or a combination of two or more thereof.

R² is a group or atom bonded to a silicon atom, and each R² independently represents an alkoxy group, an aralkyloxy group, an acyloxy group, or a halogen atom.
a represents an integer of 0 to 3.

Specific examples of each of the groups and atoms in R¹ in Formula (1) and the suitable number of carbon atoms thereof include the groups and the number of carbon atoms described above for R³ in Formula (A-1).

Specific examples of each of the groups and atoms in R² in Formula (1) and the suitable number of carbon atoms thereof include the groups, atoms, and the number of carbon atoms described above for X in Formula (A-1).

### <<<Specific Examples of Hydrolyzable Silane Represented by Formula (1)>>>

Specific examples of the hydrolyzable silane represented by Formula (1) include tetramethoxysilane, tetrachlorosilane, tetraacetoxysilane, tetraethoxysilane, tetra-n-propoxysilane, tetra-i-propoxysilane, tetra-n-butoxysilane, methyltrimethoxysilane, methyltrichlorosilane, methyltriacetoxysilane, methyltriethoxysilane, methyltripropoxysilane, methyltributoxysilane, methyltriamyloxysilane, methyltriphenoxysilane, methyltribenzyloxysilane, methyltriphenethyloxysilane, glycidoxymethyltrimethoxysilane, glycidoxymethyltriethoxysilane, α-glycidoxyethyltrimethoxysilane, α-glycidoxyethyltriethoxysilane, β-glycidoxyethyltrimethoxysilane, β-glycidoxyethyltriethoxysilane, α-glycidoxypropyltrimethoxysilane, α-glycidoxypropyltriethoxysilane, β-glycidoxypropyltrimethoxysilane, β-glycidoxypropyltriethoxysilane, γ-glycidoxypropyltrimethoxysilane, γ-glycidoxypropyltriethoxysilane, γ-glycidoxypropyltripropoxysilane, γ-glycidoxypropyltributoxysilane, γ-glycidoxypropyltriphenoxysilane, α-glycidoxybutyltrimethoxysilane, α-glycidoxybutyltriethoxysilane, β-glycidoxybutyltriethoxysilane, γ-glycidoxybutyltrimethoxysilane, γ-glycidoxybutyltriethoxysilane, δ-glycidoxybutyltrimethoxysilane, δ-glycidoxybutyltriethoxysilane, (3,4-epoxycyclohexyl)methyltrimethoxysilane, (3,4-epoxycyclohexyl)methyltriethoxysilane, β-(3,4-epoxycyclohexyl)ethyltrimethoxysilane, β-(3,4-epoxycyclohexyl) ethyltriethoxysilane, β-(3,4-epoxycyclohexyl)ethyltripropoxysilane, β-(3,4-epoxycyclohexyl)ethyltributoxysilane, β-(3,4-epoxycyclohexyl)ethyltriphenoxysilane, γ-(3,4-epoxycyclohexyl)propyltrimethoxysilane, γ-(3,4-epoxycyclohexyl)propyltriethoxysilane, δ-(3,4-epoxycyclohexyl)butyltrimethoxysilane, δ-(3,4-epoxycyclohexyl)butyltriethoxysilane, glycidoxymethylmethyldimethoxysilane, glycidoxymethylmethyldiethoxysilane, α-glycidoxyethylmethyldimethoxysilane, α-glycidoxyethylmethyldiethoxysilane, β-glycidoxyethylmethyldimethoxysilane, β-glycidoxyethylethyldimethoxysilane, α-glycidoxypropylmethyldimethoxysilane, α-glycidoxypropylmethyldiethoxysilane, β-glycidoxypropylmethyldimethoxysilane, β-glycidoxypropylethyldimethoxysilane, γ-glycidoxypropylmethyldimethoxysilane, γ-glycidoxypropylmethyldiethoxysilane, γ-glycidoxypropylmethyldipropoxysilane, γ-glycidoxypropylmethyldibutoxysilane, γ-glycidoxypropylmethyldiphenoxysilane, γ-glycidoxypropylethyldimethoxysilane, γ-glycidoxypropylethyldiethoxysilane, γ-glycidoxypropylvinyldimethoxysilane, γ-glycidoxypropylvinyldiethoxysilane, ethyltrimethoxysilane, ethyltriethoxysilane, vinyltrimethoxysilane, vinyltriethoxysilane, vinyltrichlorosilane, vinyltriacetoxysilane, methylvinyldimethoxysilane, methylvinyldiethoxysilane, methylvinyldichlorosilane, methylvinyldiacetoxysilane, dimethylvinylmethoxysilane, dimethylvinylethoxysilane, dimethylvinylchlorosilane, dimethylvinylacetoxysilane, divinyldimethoxysilane, divinyldiethoxysilane, divinyldichlorosilane, divinyldiacetoxysilane, γ-glycidoxypropylvinyldimethoxysilane, γ-glycidoxypropylvinyldiethoxysilane, allyltrimethoxysilane, allyltriethoxysilane, allyltrichlorosilane, allyltriacetoxysilane, allylmethyldimethoxysilane, allylmethyldiethoxysilane, allylmethyldichlorosilane, allylmethyldiacetoxysilane, allyldimethylmethoxysilane, allyldimethylethoxysilane, allyldimethylchlorosilane, allyldimethylacetoxysilane, diallyldimethoxysilane, diallyldiethoxysilane, diallyldichlorosilane, diallyldiacetoxysilane, 3-allylaminopropyltrimethoxysilane, 3-allylaminopropyltriethoxysilane, p-styryltrimethoxysilane, phenyltrimethoxysilane, phenyltriethoxysilane, phenyltrichlorosilane, phenyltriacetoxysilane, phenylmethyldimethoxysilane, phenylmethyldiethoxysilane, phenylmethyldichlorosilane, phenylmethyldiacetoxysilane, phenyldimethylmethoxysilane, phenyldimethylethoxysilane, phenyldimethylchlorosilane, phenyldimethylacetoxysilane, diphenylmethylmethoxysilane, diphenylmethylethoxysilane, diphenylmethylchlorosilane, diphenylmethylacetoxysilane, diphenyldimethoxysilane, diphenyldiethoxysilane, diphenyldichlorosilane, diphenyldiacetoxysilane, triphenylmethoxysilane, triphenylethoxysilane, triphenylacetoxysilane, triphenylchlorosilane, 3-phenylaminopropyltrimethoxysilane, 3-phenylaminopropyltriethoxysilane, dimethoxymethyl-3-(3-phenoxypropylthiopropyl)silane, triethoxy((2-methoxy-4-(methoxymethyl)phenoxy)methyl) silane, benzyltrimethoxysilane, benzyltriethoxysilane, benzylmethyldimethoxysilane, benzylmethyldiethoxysilane, benzyldimethylmethoxysilane, benzyldimethylethoxysilane, benzyldimethylchlorosilane, phenethyltrimethoxysilane, phenethyltriethoxysilane, phenethyltrichlorosilane, phenethyltriacetoxysilane, phenethylmethyldimethoxysilane, phenethylmethyldiethoxysilane, phenetylmethyldichlorosilane, phenethylmethyldiacetoxysilane, methoxyphenyltrimethoxysilane, methoxyphenyltriethoxysilane, methoxyphenyltriacetoxysilane, methoxyphenyltrichlorosilane, methoxybenzyltrimethoxysilane, methoxybenzyltriethoxysilane, methoxybenzyltriacetoxysilane, methoxybenzyltrichlorosilane, methoxyphenethyltrimethoxysilane, methoxyphenetyltriethoxysilane, methoxyphenetyltriacetoxysilane, methoxyphenethyltrichlorosilane, ethoxyphenyltrimethoxysilane, ethoxyphenyltriethoxysilane, ethoxyphenyltriacetoxysilane, ethoxyphenyltrichlorosilane, ethoxybenzyltrimethoxysilane, ethoxybenzyltriethoxysilane, ethoxybenzyltriacetoxysilane, ethoxybenzyltrichlorosilane, i-propoxyphenyltrimethoxysilane, i-propoxyphenyltriethoxysilane, i-propoxyphenyltriacetoxysilane, i-propoxyphenyltrichlorosilane, i-propoxybenzyltrimethoxysilane, i-propoxybenzyltriethoxysilane, i-propoxybenzyltriacetoxysilane, i-propoxybenzyltrichlorosilane, t-butoxyphenyltrimethoxysilane, t-butoxyphenyltriethoxysilane, t-butoxyphenyltriacetoxysilane, t-butoxyphenyltrichlorosilane, t-butoxybenzyltrimethoxysilane, t-butoxybenzyltriethoxysilane, t-butoxybenzyltriacetoxysilane, t-butoxybenzyltrichlorosilane, methoxynaphthyltrimethoxysilane, methoxynaphthyltriethoxysilane, methoxynaphtyltriacetoxysilane, methoxynaphtyltrichlorosilane, ethoxynaphtyltrimethoxysilane, ethoxynaphthyltriethoxysilane, ethoxynaphthyltriacetoxysilane, ethoxynaphthyltrichlorosilane, γ-chloropropyltrimethoxysilane, γ-chloropropyltriethoxysilane, γ-chloropropyltriacetoxysilane, 3,3,3-trifluoropropyltrimethoxysilane, γ-methacryloxypropyltrimethoxysilane, γ-mercaptopropyltrimethoxysilane, γ-mercaptopropyltriethoxysilane, β-cyanoethyltriethoxysilane, thiocyanate propyltriethoxysilane, chloromethyltrimethoxysilane, chloromethyltriethoxysilane, triethoxysilylpropyldiallyl isocyanurate, bicyclo[2,2,1]heptenyltriethoxysilane, benzenesulfonylpropyltriethoxysilane, benzenesulfoneamidepropyltriethoxysilane, dimethylaminopropyltrimethoxysilane, dimethyldimethoxysilane, phenylmethyldimethoxysilane, dimethyldiethoxysilane, phenylmethyldiethoxysilane, γ-chloropropylmethyldimethoxysilane, γ-chloropropylmethyldiethoxysilane, dimethyldiacetoxysilane, γ-methacryloxypropylmethyldimethoxysilane, γ-methacryloxypropylmethyldiethoxysilane, γ-mercaptopropylmethyldimethoxysilane, γ-mercaptomethyldiethoxysilane, methylvinyldimethoxysilane, methylvinyldiethoxysilane, silanes represented by the following formulae (A-1) to (A-41), and silanes represented by the following formulae (1-1) to (1-294), but are not limited thereto.

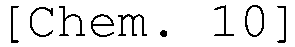

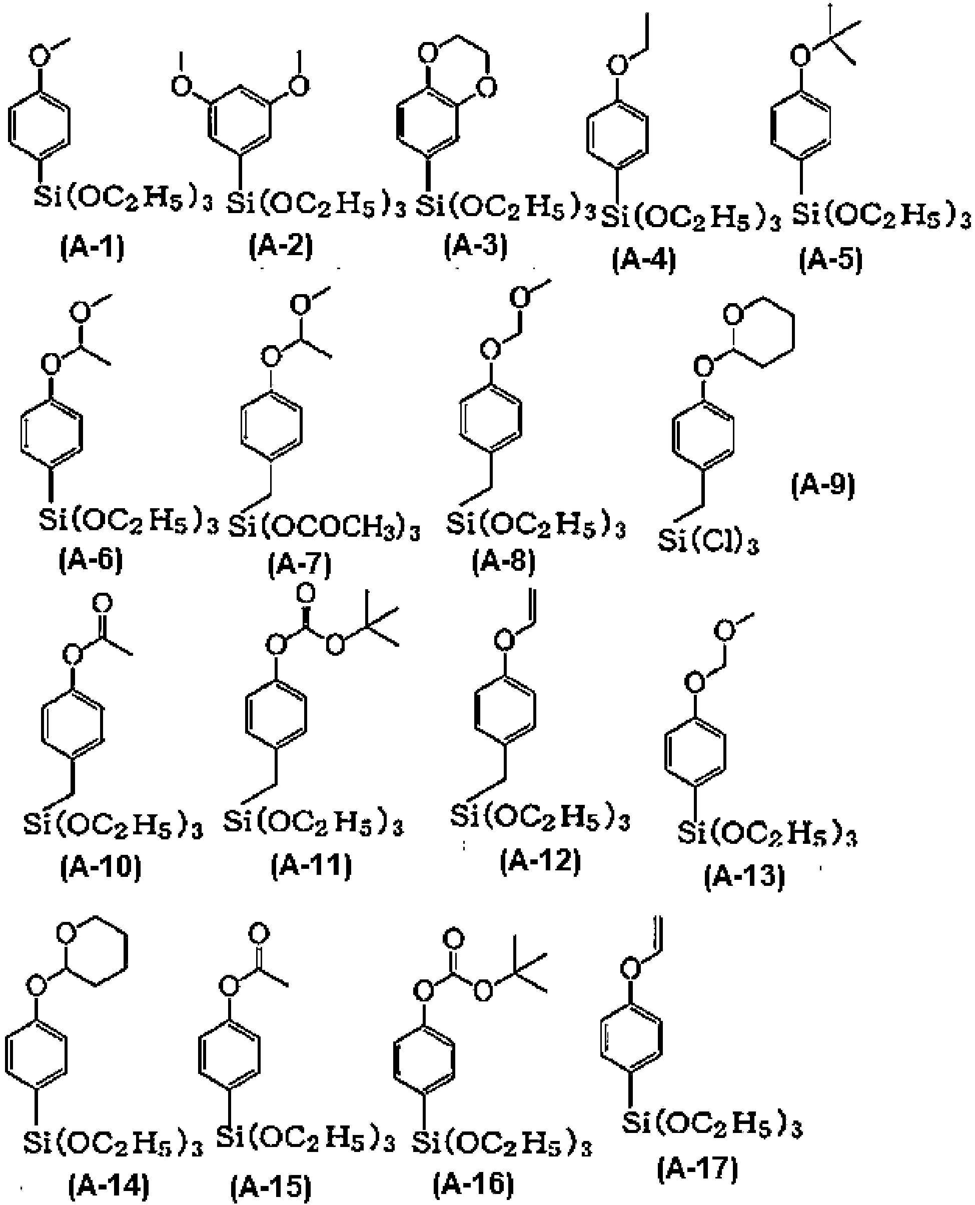

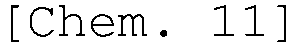

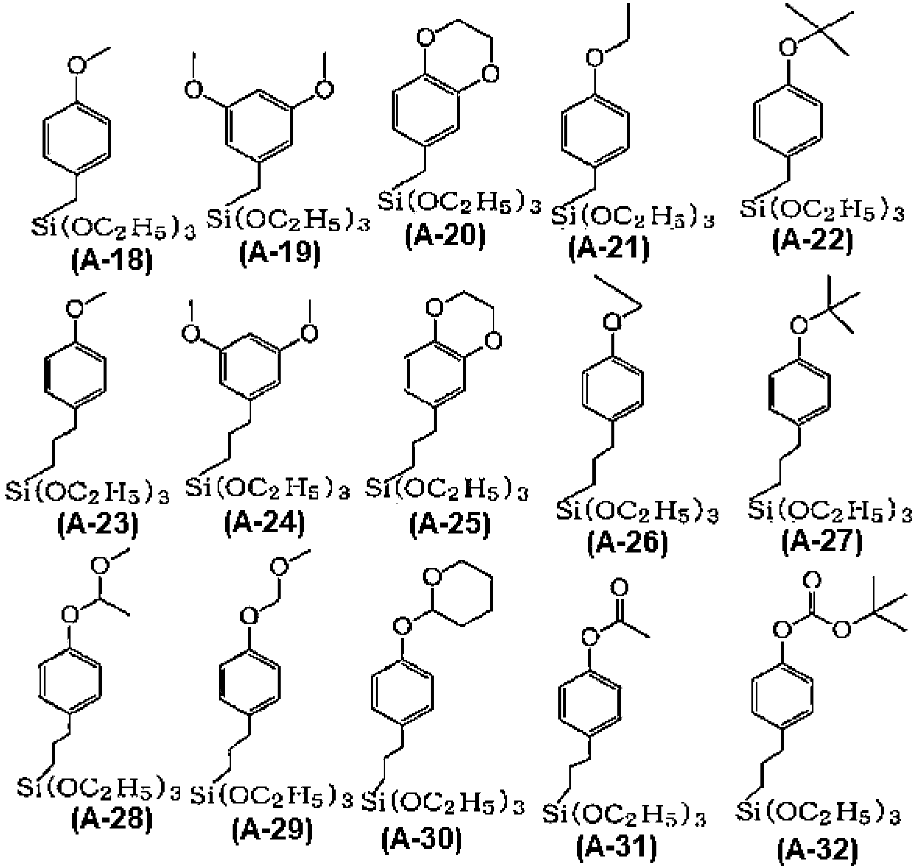

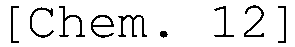

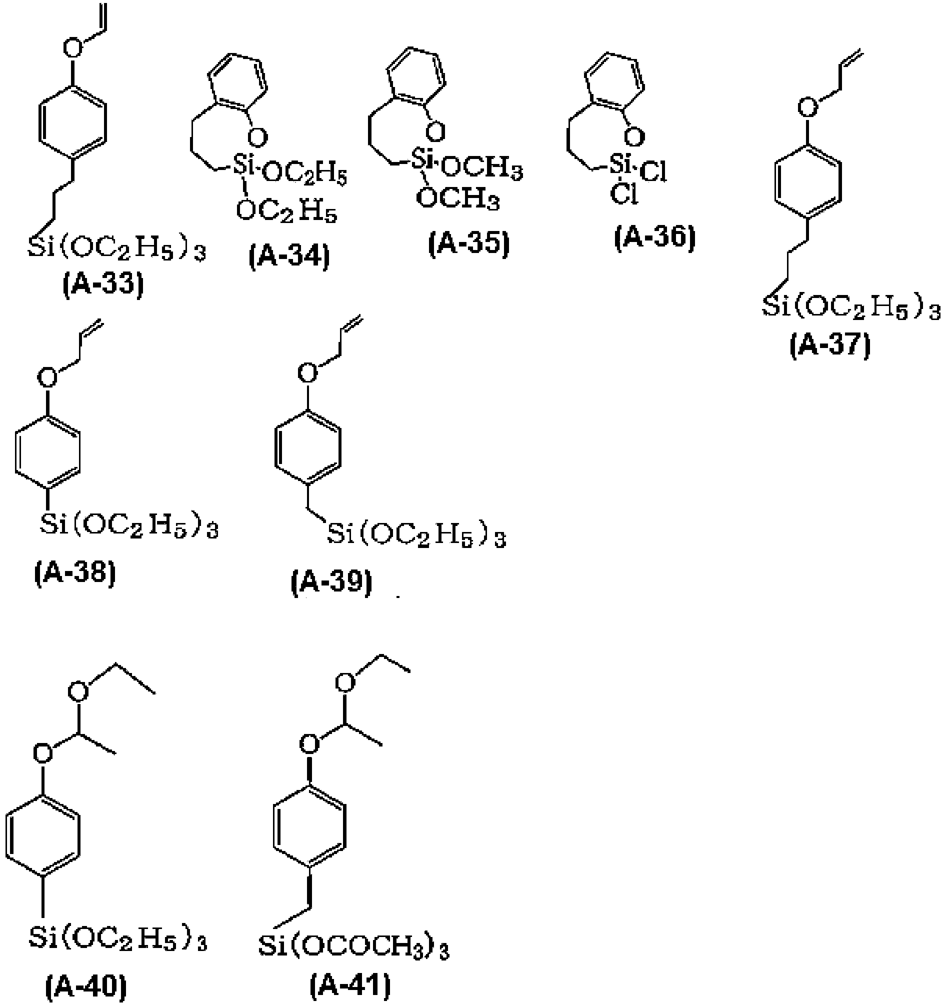

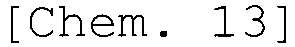

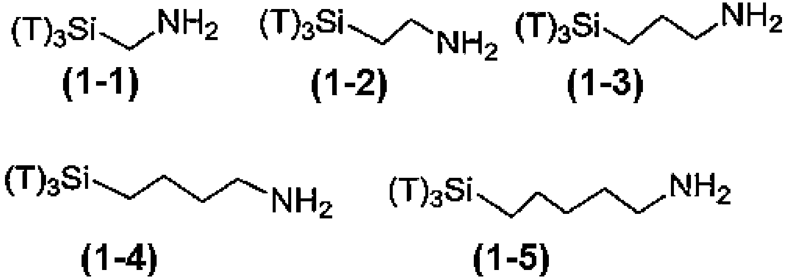

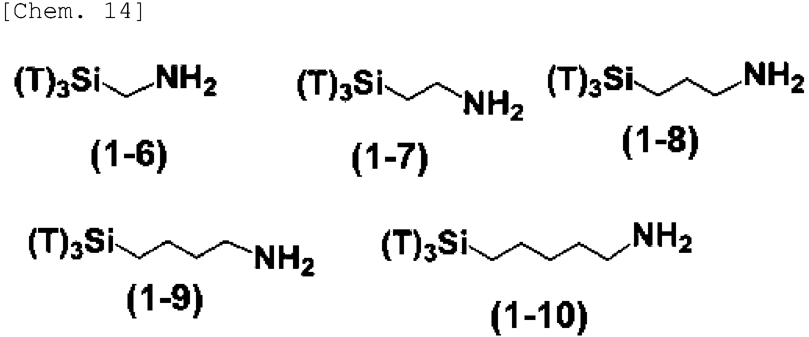

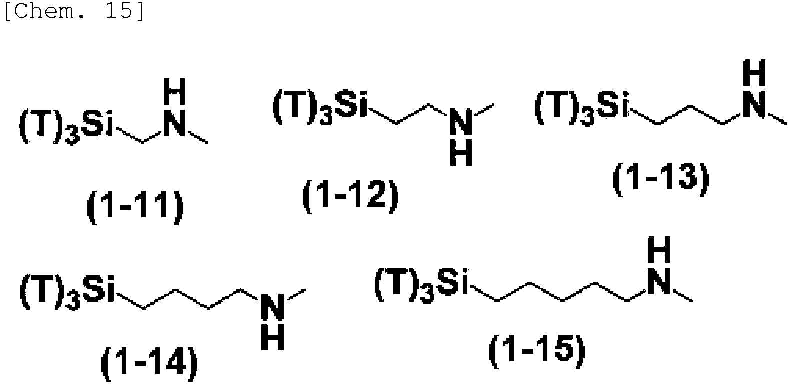

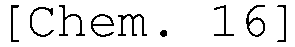

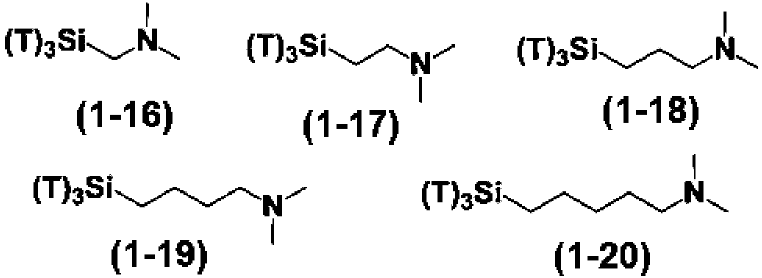

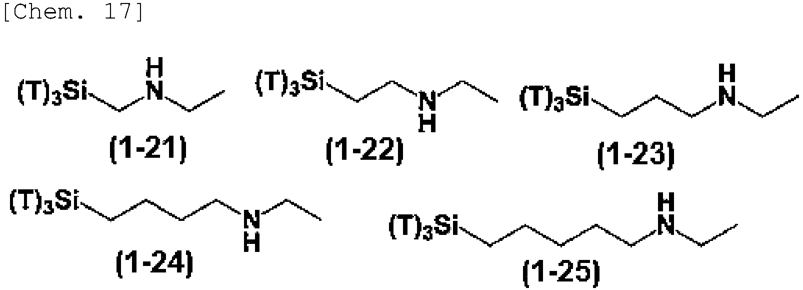

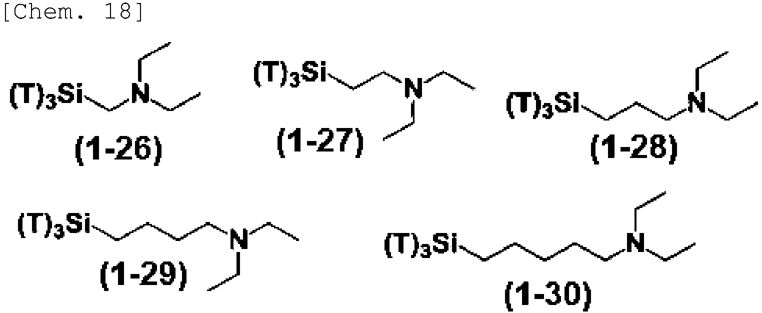

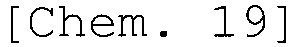

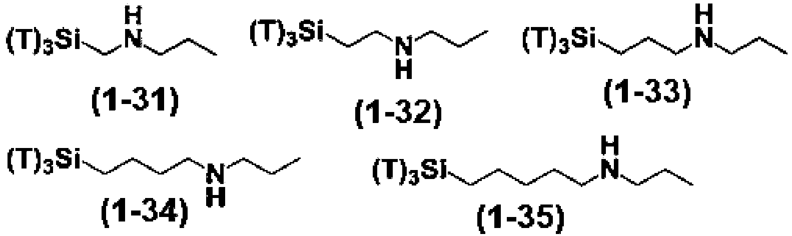

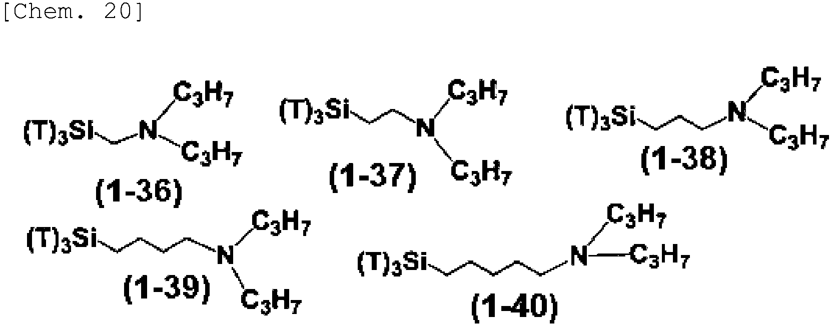

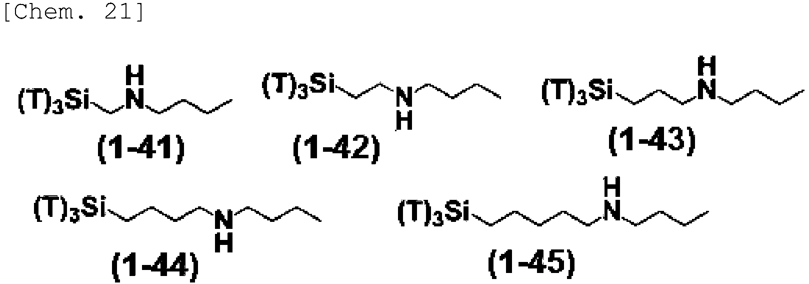

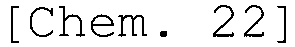

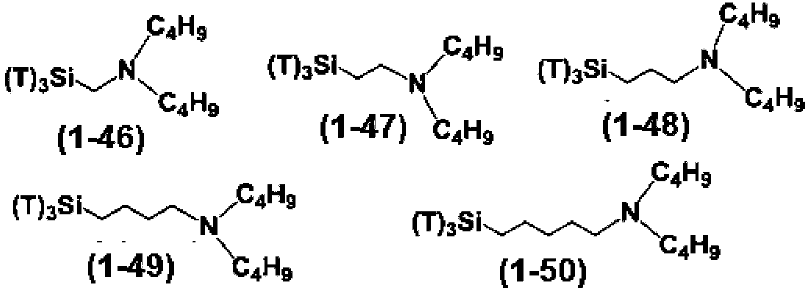

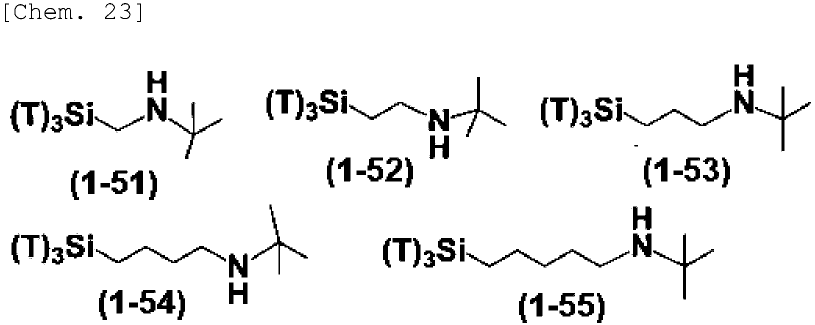

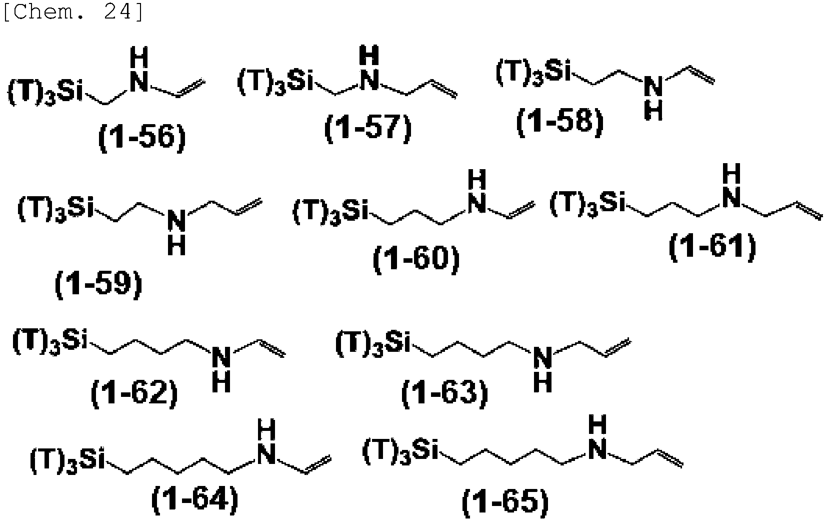

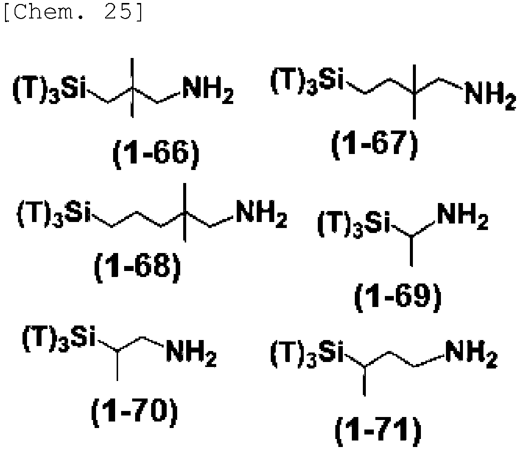

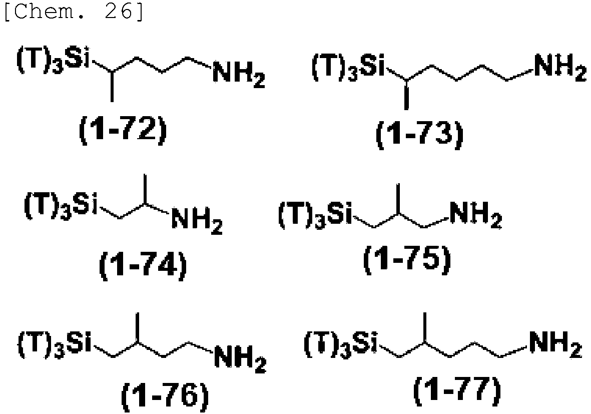

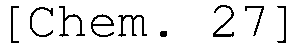

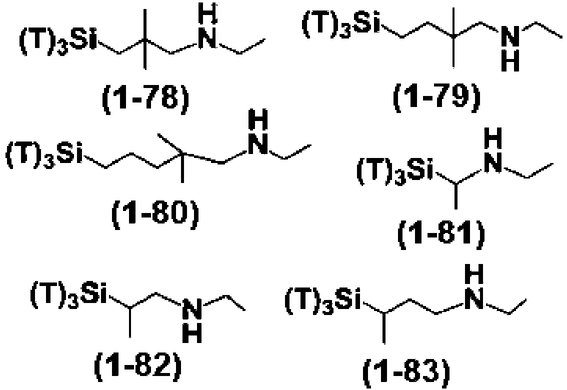

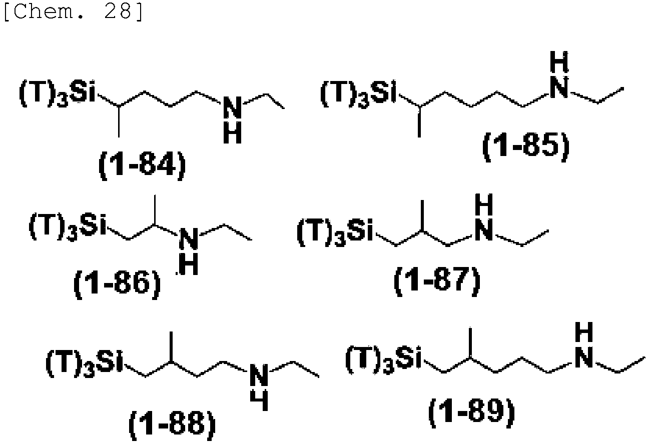

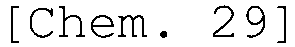

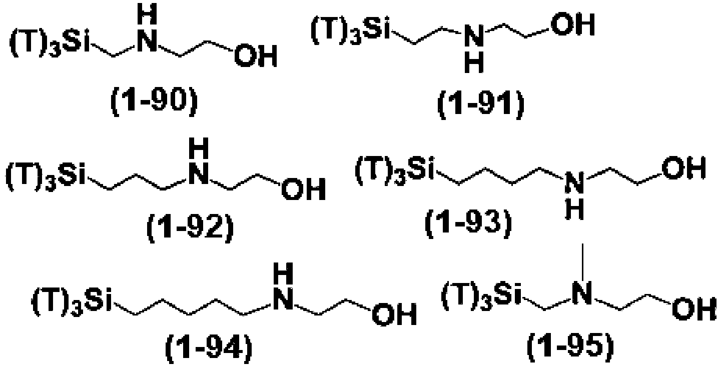

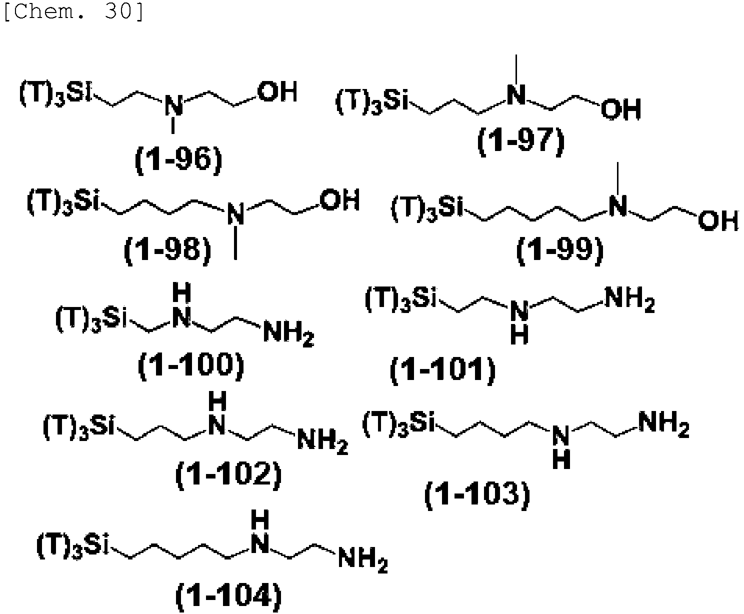

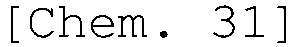

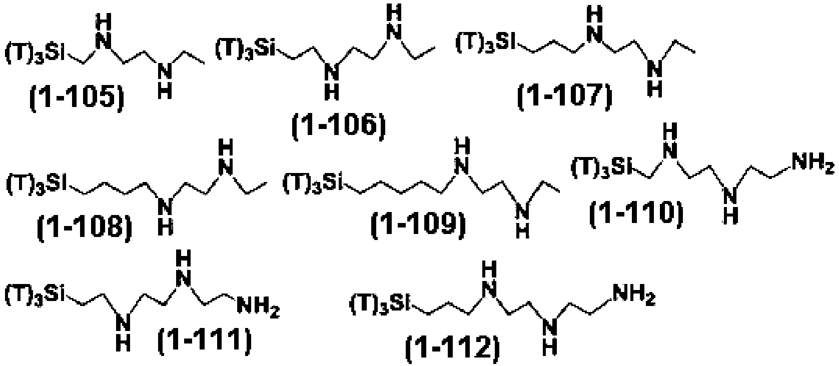

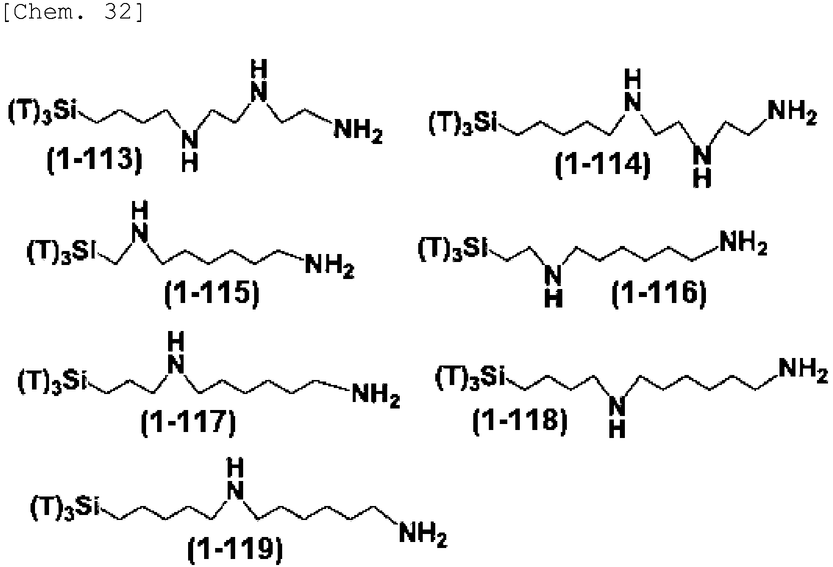

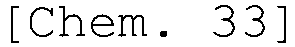

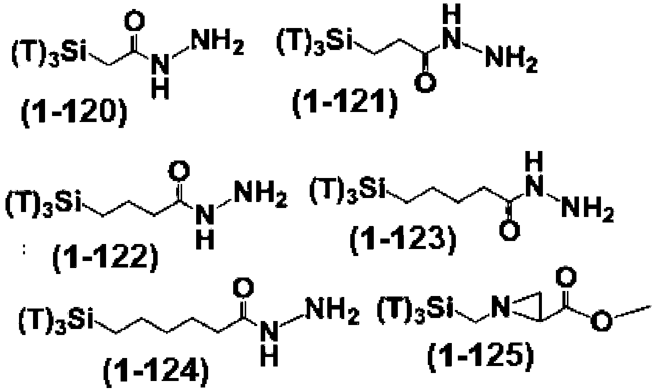

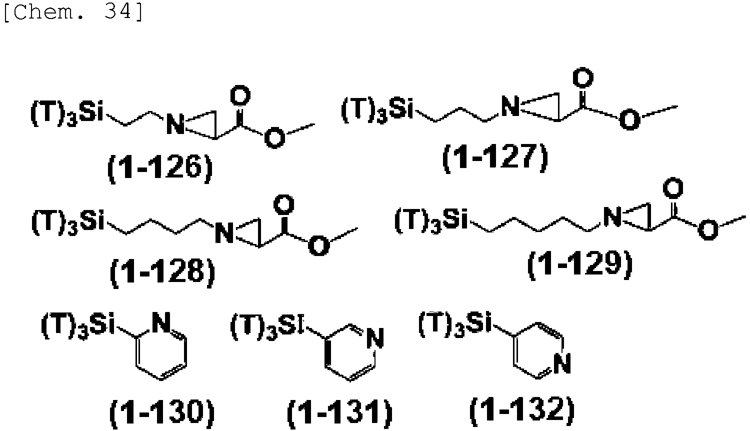

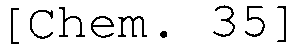

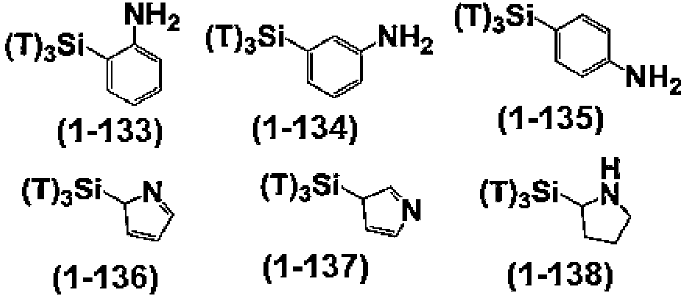

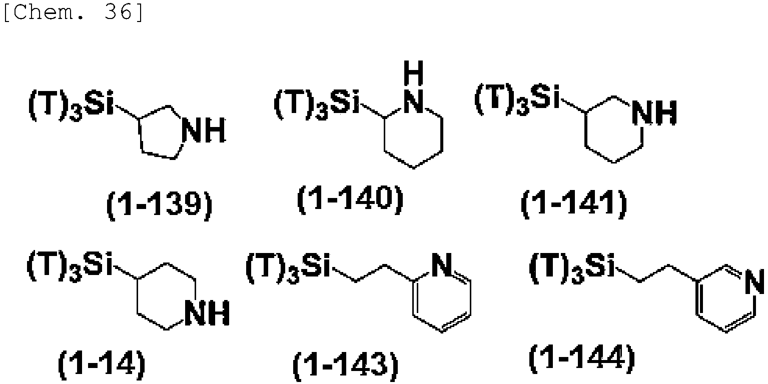

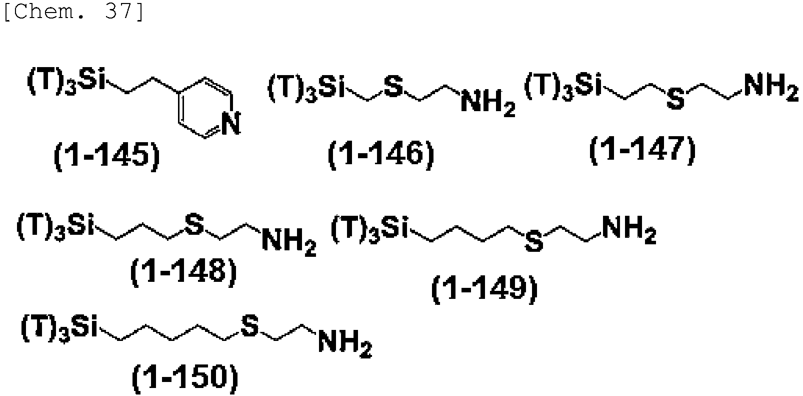

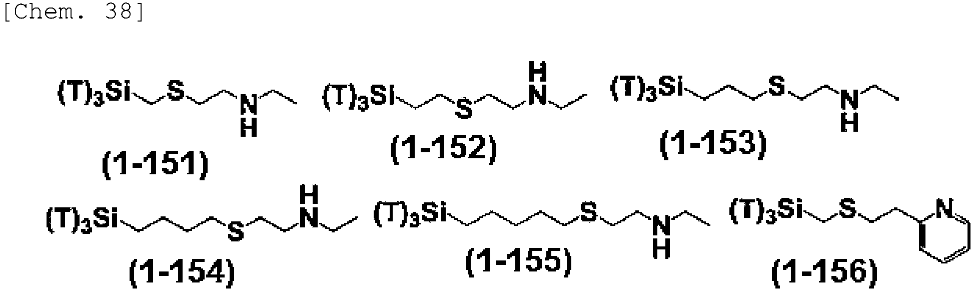

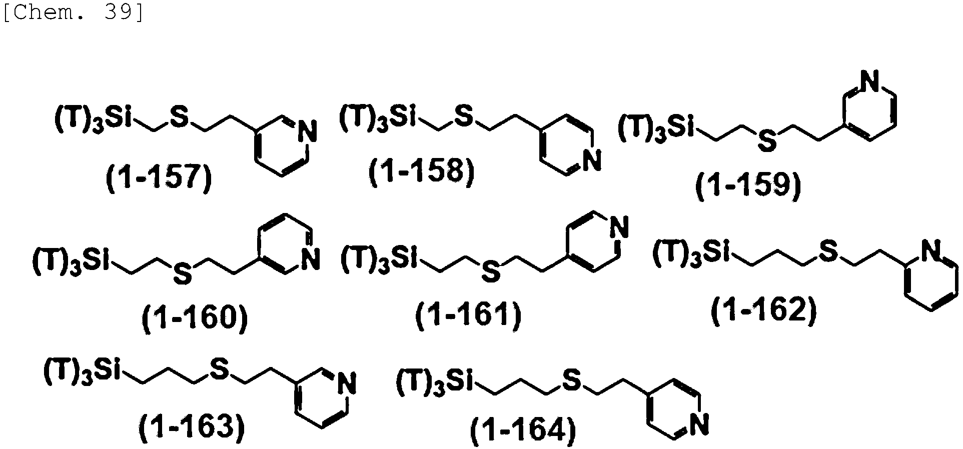

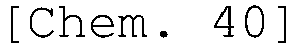

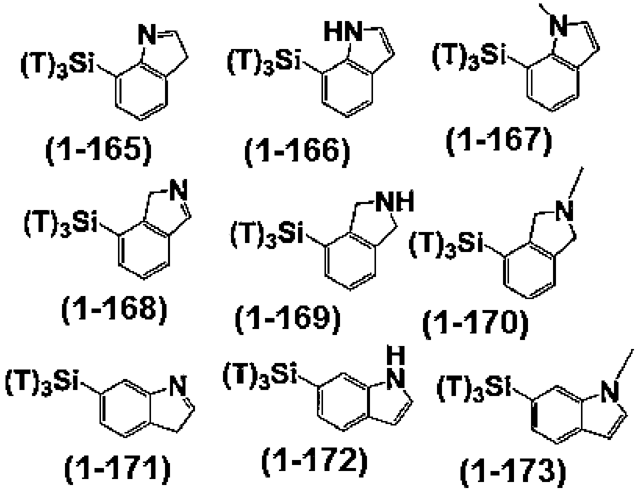

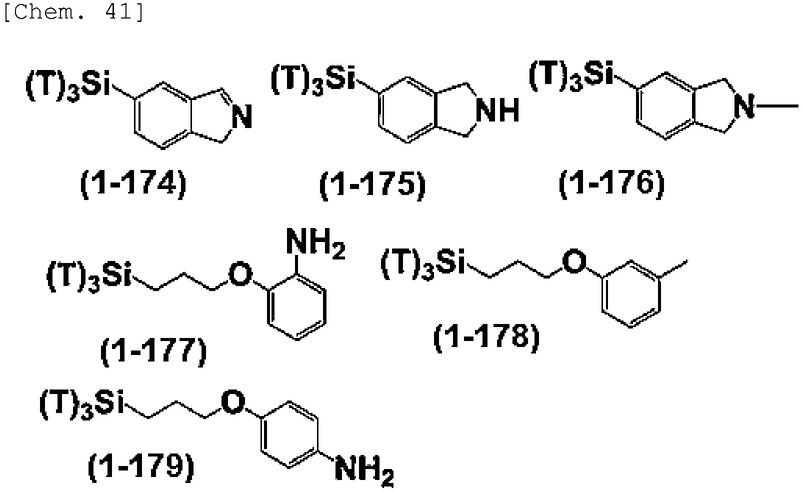

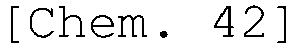

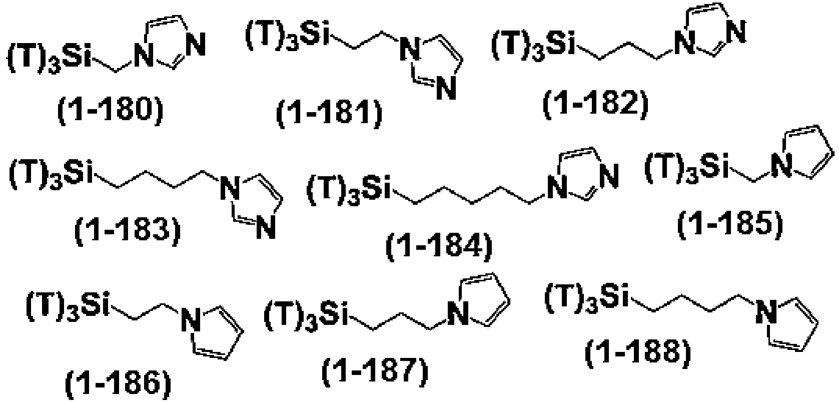

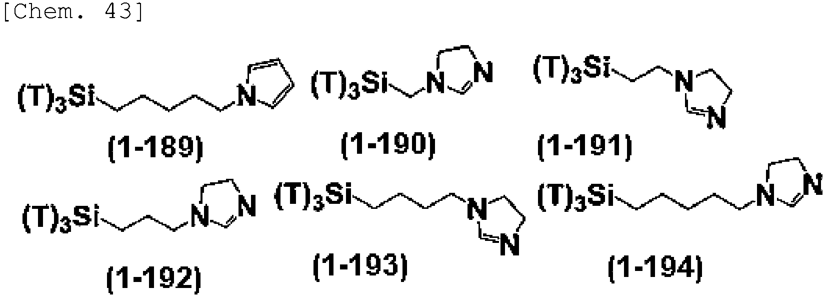

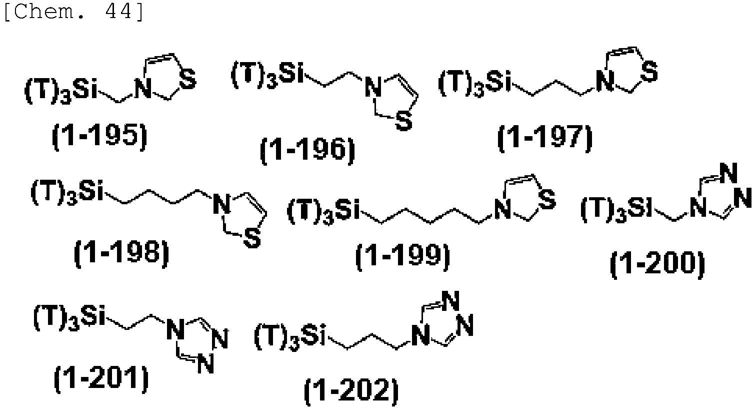

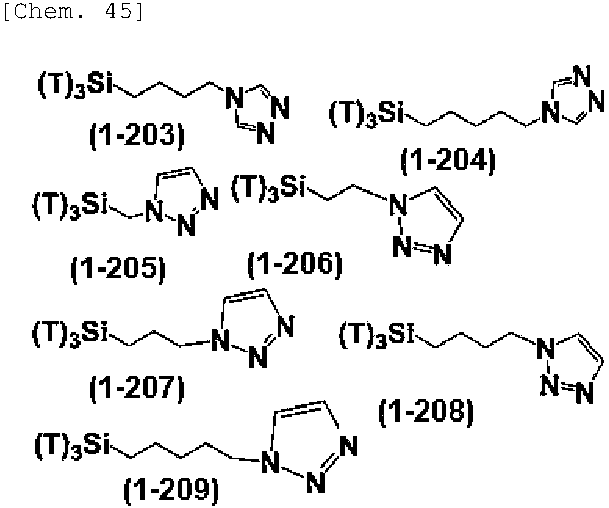

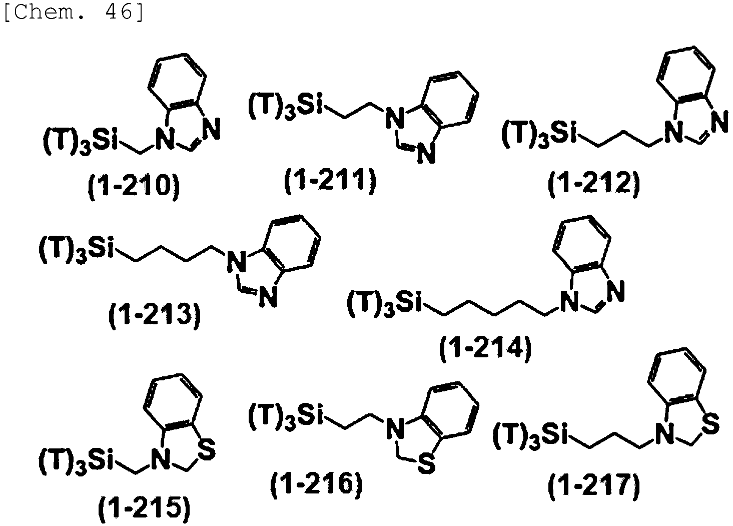

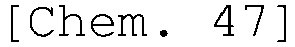

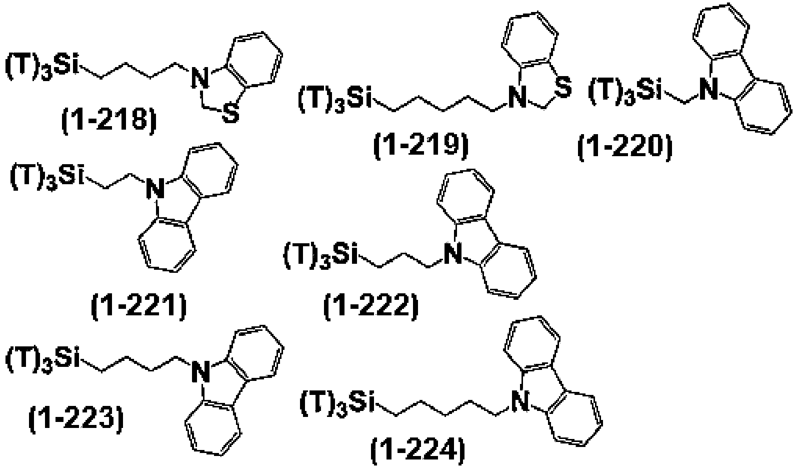

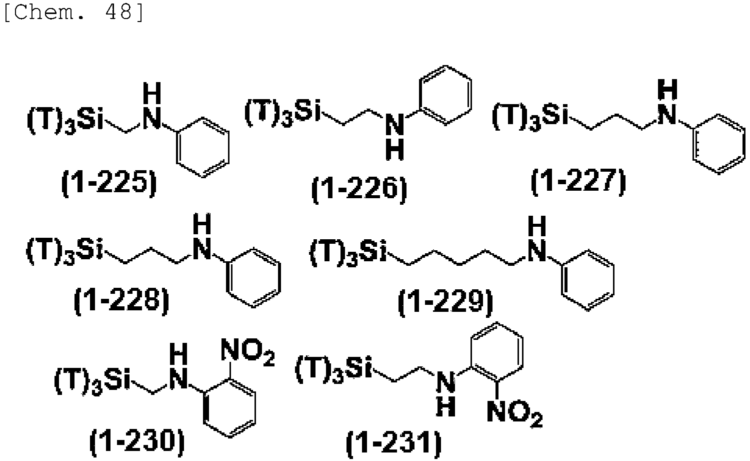

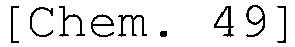

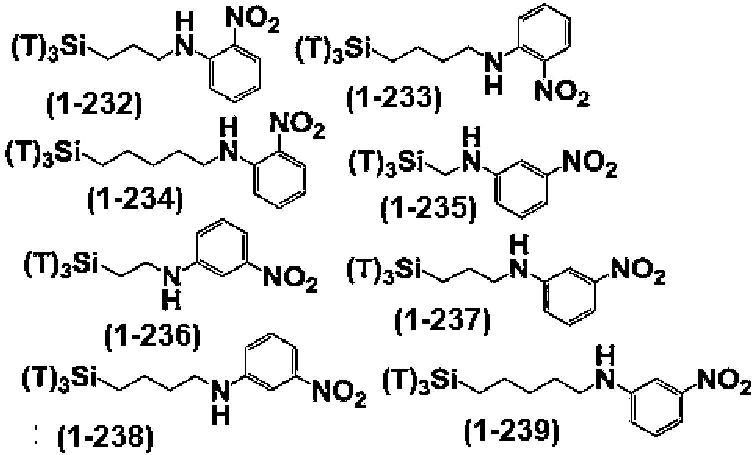

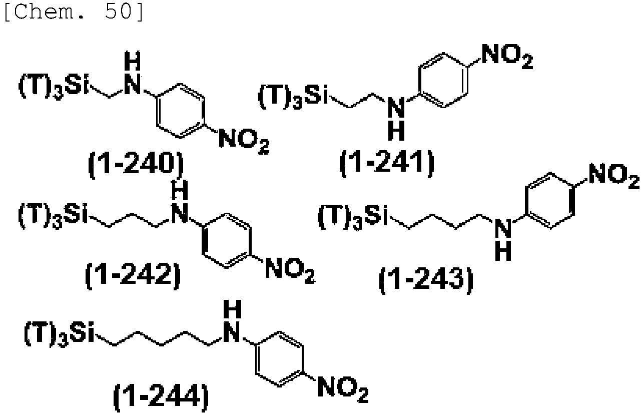

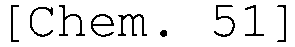

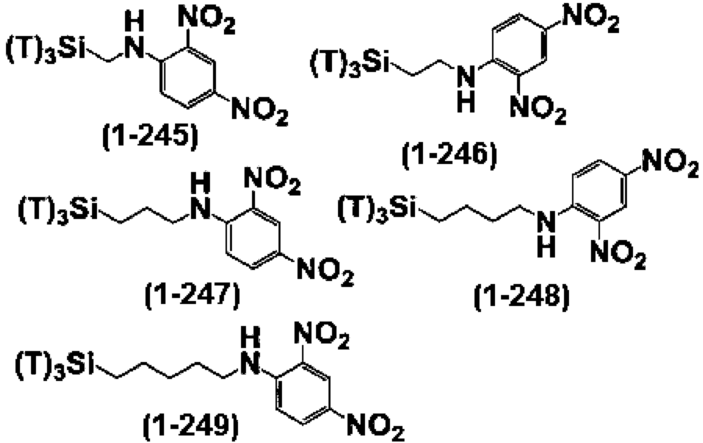

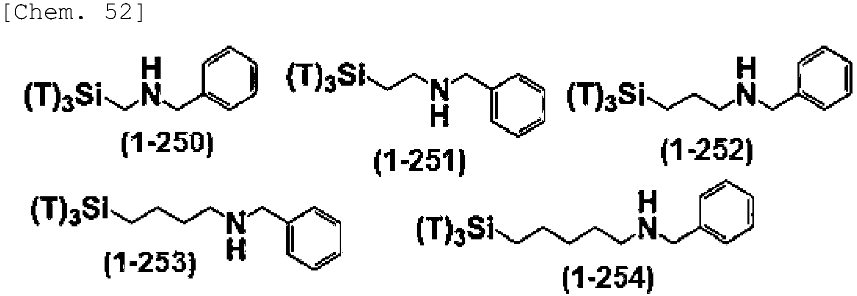

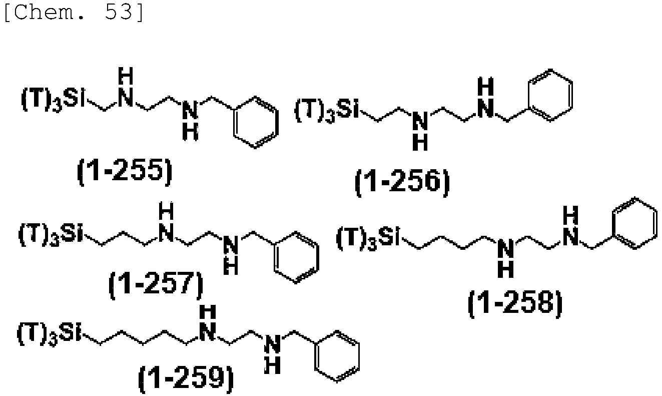

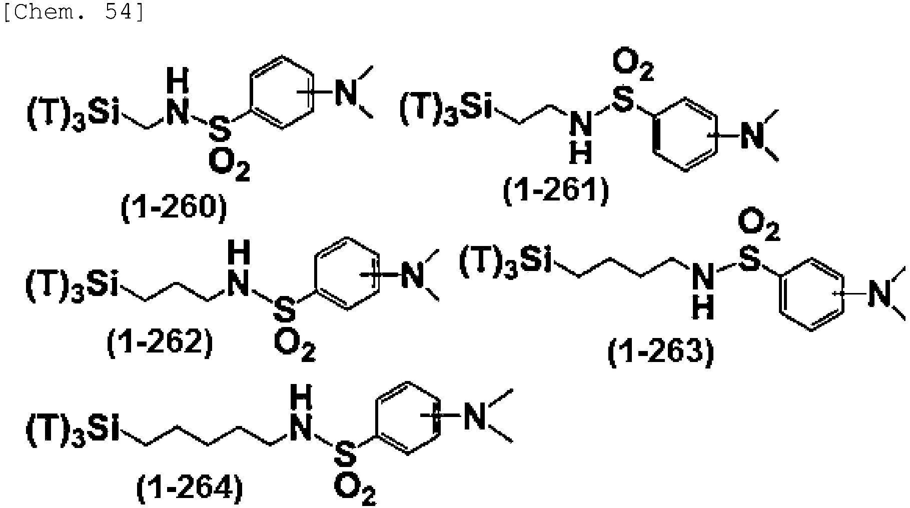

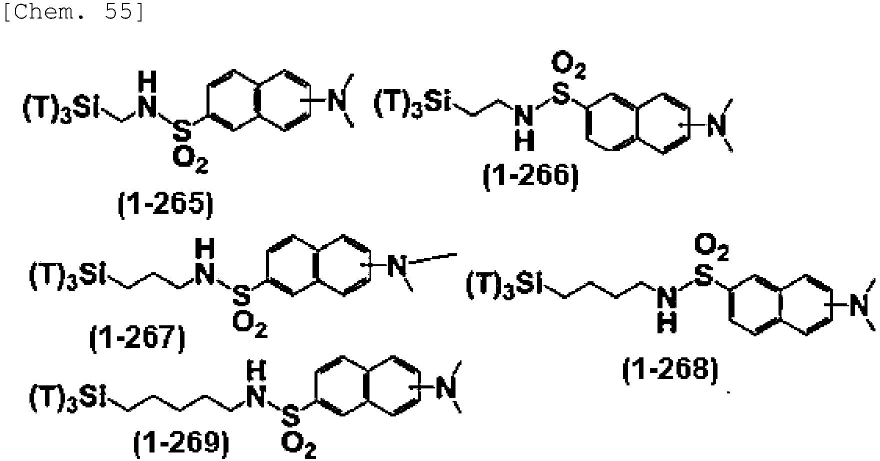

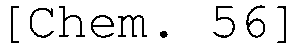

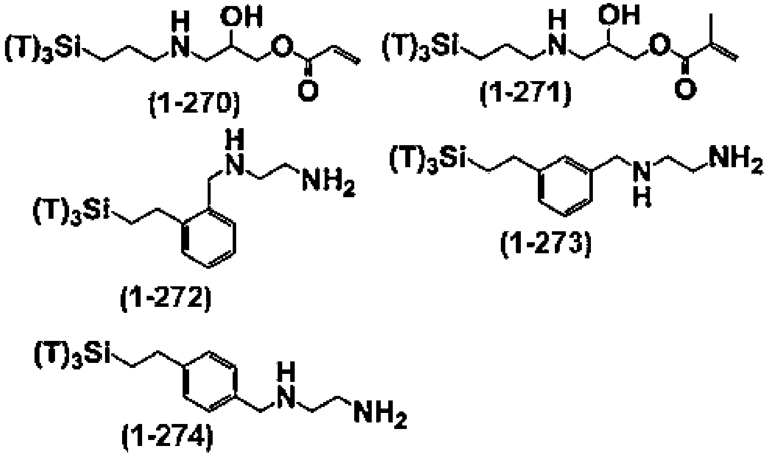

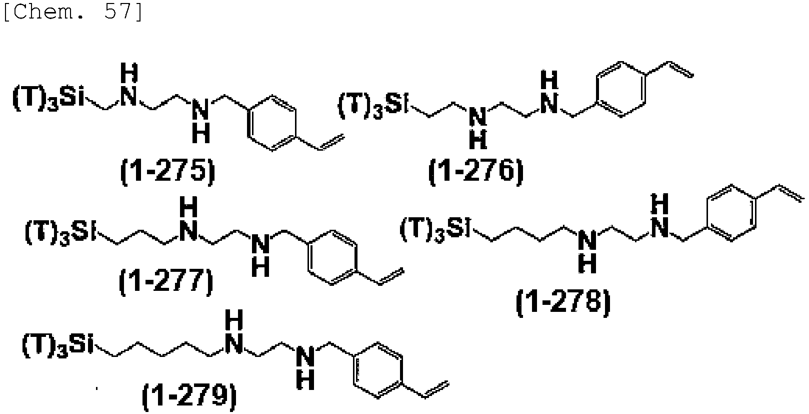

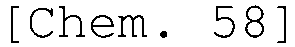

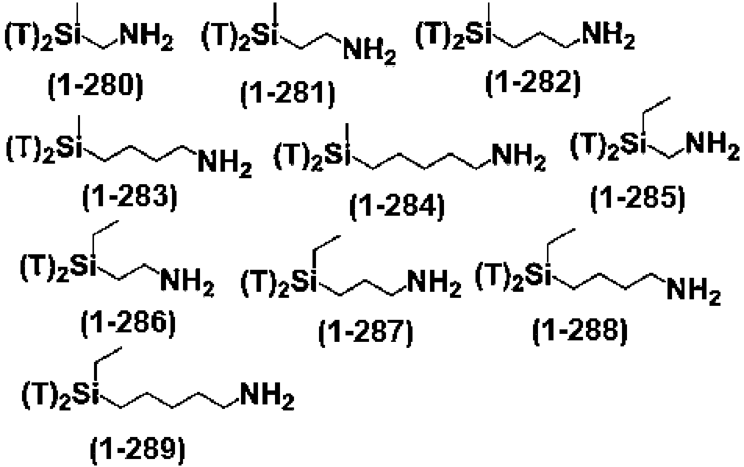

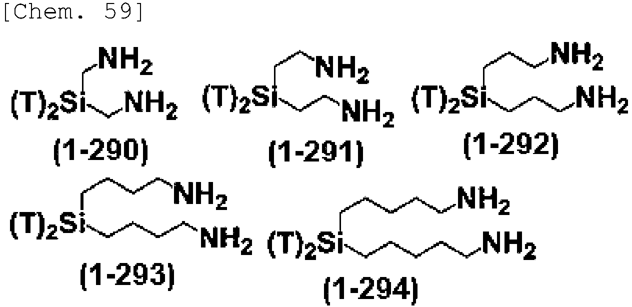

In Formulae (1-1) to (1-294), each T independently represents an alkoxy group, an acyloxy group, or a halogen group, and represents preferably a methoxy group or an ethoxy group, for example.

Examples of the polysiloxane [A] include a hydrolytic condensate of a hydrolyzable silane containing the hydrolyzable silane (A) and a hydrolyzable silane represented by the following Formula (2) or a modified product thereof.

Examples of the polysiloxane [A] include a hydrolytic condensate of a hydrolyzable silane containing the hydrolyzable silane (A), the hydrolyzable silane represented by Formula (1), and the hydrolyzable silane represented by the following Formula (2) or a modified product thereof.

Examples of the polysiloxane [A'] include a hydrolytic condensate of a hydrolyzable silane containing the hydrolyzable silane represented by the following Formula (2) together with the hydrolyzable silane represented by Formula (1) or in place of the hydrolyzable silane represented by Formula (1), or a modified product thereof.

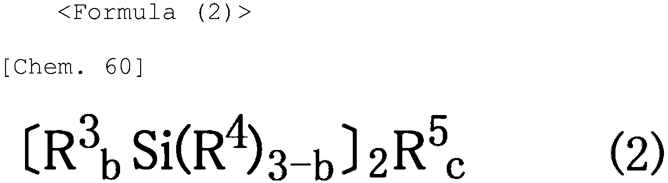

In Formula (2), R³ is a group bonded to a silicon atom, and each R³ independently represents an alkyl group which may be substituted, an aryl group which may be substituted, an aralkyl group which may be substituted, an alkyl halide group which may be substituted, an aryl halide group which may be substituted, an aralkyl halide group which may be substituted, an alkoxyalkyl group which may be substituted, an alkoxyaryl group which may be substituted, an alkoxyaralkyl group which may be substituted, or an alkenyl group which may be substituted, or an organic group having an epoxy group, an organic group having an acryloyl group, an organic group having a methacryloyl group, an organic group having a mercapto group, an organic group having an amino group, an organic group having an alkoxy group, an organic group having a sulfonyl group, or an organic group having a cyano group, or a combination of two or more thereof.

R⁴ is a group or atom bonded to a silicon atom, and each R⁴ independently represents an alkoxy group, an aralkyloxy group, an acyloxy group, or a halogen atom.

R⁵ is a group bonded to a silicon atom, and each R⁵ independently represents an alkylene group or an arylene group.

b represents 0 or 1, and c represents 0 or 1.

Specific examples of each of the groups and atoms in R³ and the suitable number of carbon atoms thereof include the groups and the number of carbon atoms described above for R³ in Formula (A-1).

Specific examples of each of the groups and atoms in R⁴ and the suitable number of carbon atoms thereof include the groups, atoms, and the number of carbon atoms described above for X in Formula (A-1).

Specific examples of the alkylene group in R⁵ include, but are not limited to, alkylene groups, for example, linear alkylene groups such as a methylene group, an ethylene group, a trimethylene group, a tetramethylene group, a pentamethylene group, a hexamethylene group, a heptamethylene group, an octamethylene group, a nonamethylene group, a decamethylene group; branched alkylene groups, such as a 1-methyltrimethylene group, a 2-methyltrimethylene group, a 1,1-dimethylethylene group, a 1-methyltetramethylene group, a 2-methyltetramethylene group, a 1,1-dimethyltrimethylene group, a 1,2-dimethyltrimethylene group, a 2,2-dimethyltrimethylene group, a 1-ethyltrimethylene group; and alkanetriyl groups, such as a methanetriyl group, an ethane-1,1,2-triyl group, an ethane-1,2,2-triyl group, an ethane-2,2,2-triyl group, a propane-1,1,1-triyl group; a propane-1,1,2-triyl group, a propane-1,2,3-triyl group, a propane-1,2,2-triyl group, a propane-1,1,3-triyl group, a butane-1,1,1-triyl group, a butane-1,1,2-triyl group, a butane-1,1,3-triyl group, a butane-1,2,3-triyl group, a butane-1,2,4-triyl group, a butane-1,2,2-triyl group, a butane-2,2,3-triyl group, a 2-methylpropane-1,1,1-triyl group, a 2-methylpropane-1,1,2-triyl group, and a 2-methylpropane-1,1,3-triyl group.

Specific examples of the arylene group in R⁵ include, but are not limited to, a 1,2-phenylene group, a 1,3-phenylene group, and a 1,4-phenylene group; groups derived by removing two hydrogen atoms on the aromatic ring of a condensed ring aromatic hydrocarbon compound such as a 1,5-naphthalenediyl group, a 1,8-naphthalenediyl group, a 2,6-naphthalenediyl group, a 2,7-naphthalenediyl group, a 1,2-anthracenediyl group, a 1,3-anthracenediyl group, a 1,4-anthracenediyl group, a 1,5-anthracenediyl group, a 1,6-anthracenediyl group, a 1,7-anthracenediyl group, a 1,8-anthracenediyl group, a 2,3-anthracenediyl group, a 2,6-anthracenediyl group, a 2,7-anthracenediyl group, a 2,9-anthracenediyl group, a 2,10-anthracenediyl group, and a 9,10-anthracenediyl group; and a group derived by removing two hydrogen atoms on the aromatic rings of a ring-linked aromatic hydrocarbon compound such as a 4,4'-biphenyldiyl group and a 4,4"-p-terphenyldiyl group.

b is preferably 0.

c is preferably 1.

Specific examples of the hydrolyzable silane represented by Formula (2) include, but are not limited to, methylenebistrimethoxysilane, methylenebistrichlorosilane, methylenebistriacetoxysilane, ethylenebistriethoxysilane, ethylenebistrichlorosilane, ethylenebistriacetoxysilane, propylenebistriethoxysilane, butylenebistrimethoxysilane, phenylenebistrimethoxysilane, phenylenebistriethoxysilane, phenylenebismethyldiethoxysilane, phenylenebismethyldimethoxysilane, naphthylenebistrimethoxysilane, bistrimethoxydisilane, bistriethoxydisilane, bisethyldiethoxydisilane, and bismethyldimethoxydisilane.

Examples of the polysiloxane [A] include a hydrolytic condensate of a hydrolyzable silane containing the hydrolyzable silane (A), the hydrolyzable silane represented by Formula (1), and/or the hydrolyzable silane represented by Formula (2) and other hydrolyzable silanes described below, or a modified product thereof.

Examples of polysiloxane [A'] include a hydrolytic condensate of a hydrolyzable silane containing the hydrolyzable silane represented by Formula (1) and/or the hydrolyzable silane represented by Formula (2) and other hydrolyzable silanes described below, or a modified product thereof.

Examples of other hydrolyzable silanes include, but are not limited to, silane compounds having an onium group in the molecule, silane compounds having a sulfone group, silane compounds having a sulfonamide group, and silane compounds having a cyclic urea skeleton in the molecule.

### <<Silane Compound (Hydrolyzable Organosilane) Having Onium Group in Molecule>>

The silane compound having an onium group in the molecule is expected to effectively and efficiently promote a crosslinking reaction of the hydrolyzable silane.

A suitable example of the silane compound having an onium group in the molecule is represented by Formula (3).

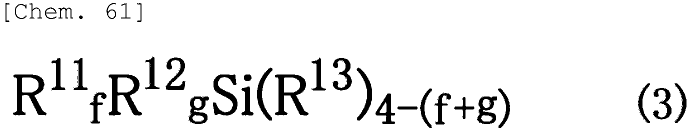

R¹¹ is a group bonded to a silicon atom, and represents an onium group or an organic group having the onium group.

R¹² is a group bonded to a silicon atom, and each R¹² independently represents an alkyl group which may be substituted, an aryl group which may be substituted, an aralkyl group which may be substituted, an alkyl halide group which may be substituted, an aryl halide group which may be substituted, an aralkyl halide group which may be substituted, an alkoxyalkyl group which may be substituted, an alkoxyaryl group which may be substituted, an alkoxyaralkyl group which may be substituted, or an alkenyl group which may be substituted, or an organic group having an epoxy group, an organic group having an acryloyl group, an organic group having a methacryloyl group, an organic group having a mercapto group, an organic group having an amino group, or an organic group having a cyano group, or a combination of two or more thereof.

R¹³ is a group or atom bonded to a silicon atom, and each R¹³ independently represents an alkoxy group, an aralkyloxy group, an acyloxy group, or a halogen atom.

f represents 1 or 2, g represents 0 or 1, and 1 ≤ f + g ≤ 2 is satisfied.

Specific examples of an alkyl group, an aryl group, an aralkyl group, an alkyl halide group, an aryl halide group, an aralkyl halide group, an alkoxyalkyl group, an alkoxyaryl group, an alkoxyaralkyl group, an alkenyl group, and an organic group having an epoxy group, an organic group having an acryloyl group, an organic group having a methacryloyl group, an organic group having a mercapto group, an organic group having an amino group, an organic group having a cyano group, an alkoxy group, an aralkyloxy group, an acyloxy group, and a halogen atom, and specific examples of substituent groups of an alkyl group, an aryl group, an aralkyl group, an alkyl halide group, an aryl halide group, an aralkyl halide group, an alkoxyalkyl group, an alkoxyaryl group, an alkoxyaralkyl group, and an alkenyl group, and the suitable number of carbon atoms thereof include, for R¹², those described above for R³ in Formula (A-1) and, for R¹³, those described above for X in Formula (A-1).

More specifically, specific examples of the onium group include a cyclic ammonium group or a chain ammonium group, and a tertiary ammonium group or a quaternary ammonium group is preferable.

That is, preferred specific examples of the onium group or the organic group having the onium group include a cyclic ammonium group, a chain ammonium group, or an organic group containing at least one of the cyclic ammonium group or the chain ammonium group, and a tertiary ammonium group or a quaternary ammonium group or an organic group containing at least one of the tertiary ammonium group or the quaternary ammonium group is preferable.

When the onium group is a cyclic ammonium group, a nitrogen atom forming the ammonium group also serves as a ring-forming atom. At this time, a nitrogen atom and a silicon atom constituting the ring may be bonded directly or via a divalent linking group, or a carbon atom and a silicon atom constituting the ring may be bonded directly or via a divalent linking group.

In an example of a preferred embodiment, R¹¹, which is a group bonded to a silicon atom, is a heteroaromatic cyclic ammonium group represented by the following Formula (S1).

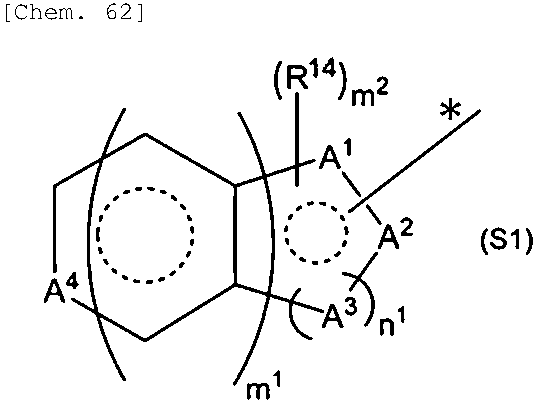

In Formula (S1), A¹, A², A³, and A⁴ each independently represent a group represented by any one of the following Formulae (J1) to (J3), and at least one of A¹ to A⁴ is a group represented by the following Formula (J2), and the bond between each of A¹ to A⁴ and the atom adjacent thereto and constituting the ring is determined to be a single bond or a double bond according to which of A¹ to A⁴ the silicon atom in Formula (3) is bonded, such that the constituted ring exhibits aromaticity. * represents a bond.

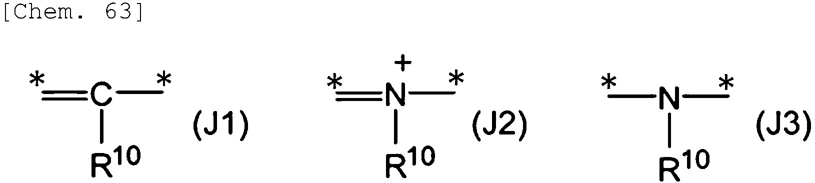

In Formulae (J1) to (J3), each R¹⁰ independently represents a single bond, a hydrogen atom, an alkyl group, an aryl group, an aralkyl group, an alkyl halide group, an aryl halide group, an aralkyl halide group or an alkenyl group, and specific examples of the alkyl group, the aryl group, the aralkyl group, the alkyl halide group, the aryl halide group, the aralkyl halide group, and the alkenyl group, and the suitable number of carbon atoms thereof are the same as those described above. * represents a bond.

In Formula (S1), R¹⁴ each independently represents an alkyl group, an aryl group, an aralkyl group, an alkyl halide group, an aryl halide group, an aralkyl halide group, an alkenyl group or a hydroxy group, and when two or more R¹⁴s are present, the two R¹⁴s may be bonded to each other to form a ring. A ring formed by two R¹⁴s may have a crosslinked ring structure, and in such a case, the cyclic ammonium group has an adamantane ring, a norbornene ring, a spiro ring or the like.

Specific examples of such an alkyl group, an aryl group, an aralkyl group, an alkyl halide group, an aryl halide group, an aralkyl halide group, and an alkenyl group, and the suitable number of carbon atoms thereof are the same as those described above.

In Formula (S1), n¹ is an integer of 1 to 8, m¹ is 0 or 1, and m² is 0 or a positive integer ranging from 1 to the maximum number that can be substituted on a monocyclic ring or a polycyclic ring.

When m¹ is 0, a (4 + n¹)-membered ring including A¹ to A⁴ is formed. That is, when n¹ is 1, a 5-membered ring is formed; when n¹ is 2, a 6-membered ring is formed; when n¹ is 3, a 7-membered ring is formed; when n¹ is 4, an 8-membered ring is formed; when n¹ is 5, a 9-membered ring is formed; when n¹ is 6, a 10-membered ring is formed; when n¹ is 7, a 11-membered ring is formed; and when n¹ is 8, a 12-membered ring is formed.

When m¹ is 1, a condensed ring is formed by condensation between a (4 + n¹)-membered ring including A¹ to A³ and a 6-membered ring including A⁴.

Since each of A¹ to A⁴ is any of the groups of Formulae (J1) to (J3), the ring-forming atom has or does not have a hydrogen atom. In each of A¹ to A⁴, when the ring-forming atom has a hydrogen atom, the hydrogen atom may be substituted with R¹⁴. Alternatively, a ring-forming atom other than the ring-forming atom in each of A¹ to A⁴ may be substituted with R¹⁴. Under such circumstances, as described above, m² is selected from 0 or an integer ranging from 1 to the maximum number that can be substituted on a monocyclic ring or a polycyclic ring.

The bond of the heteroaromatic cyclic ammonium group represented by Formula (S1) is present at any carbon atom or nitrogen atom present in such a monocyclic ring or a condensed ring, and is directly bonded to a silicon atom, or a linking group is bonded to form an organic group having cyclic ammonium, which is bonded to a silicon atom.

Examples of the linking group include, but are not limited to, an alkylene group, an arylene group, and an alkenylene group.

Specific examples of the alkylene group and the arylene group and the suitable number of carbon atoms are the same as those described above.

The alkenylene group is a divalent group derived by further removing one hydrogen atom from the alkenyl group, and specific examples of the alkenyl group are the same as those described above. The alkenylene group preferably has, but is not particularly limited to, 40 or less carbon atoms, more preferably 30 or less carbon atoms, and still more preferably 20 or less carbon atoms.

Specific examples thereof include, but are not limited to, vinylene, 1-methylvinylene, propenylene, 1-butenylene, 2-butenylene, 1-pentenylene, and 2-pentenylene group.

Specific examples of the silane compound (hydrolyzable organosilane) represented by Formula (3) having a heteroaromatic cyclic ammonium group represented by Formula (S1) include silanes represented by the following Formulae (I-1) to (I-50), but are not limited thereto.

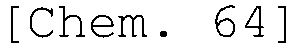

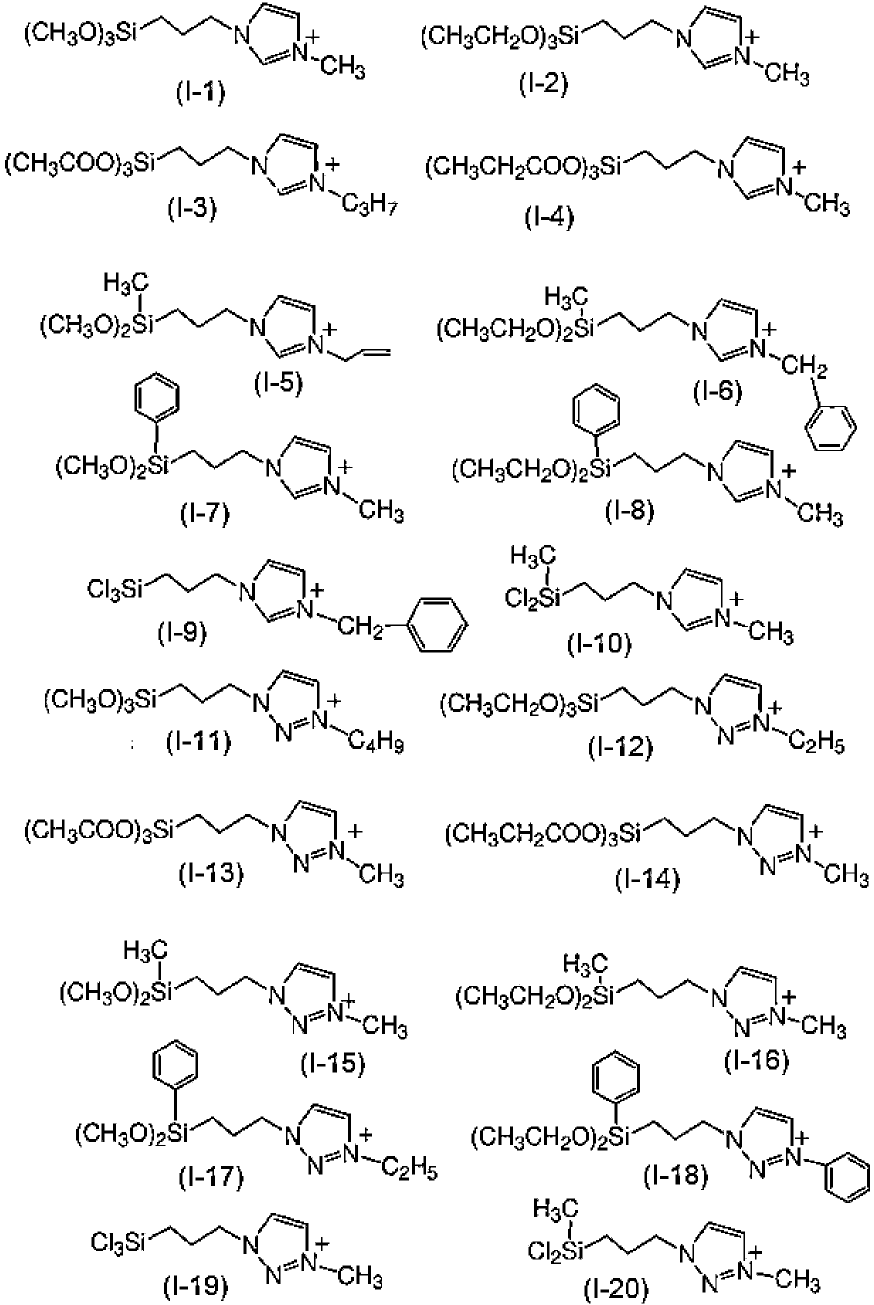

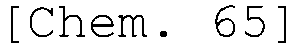

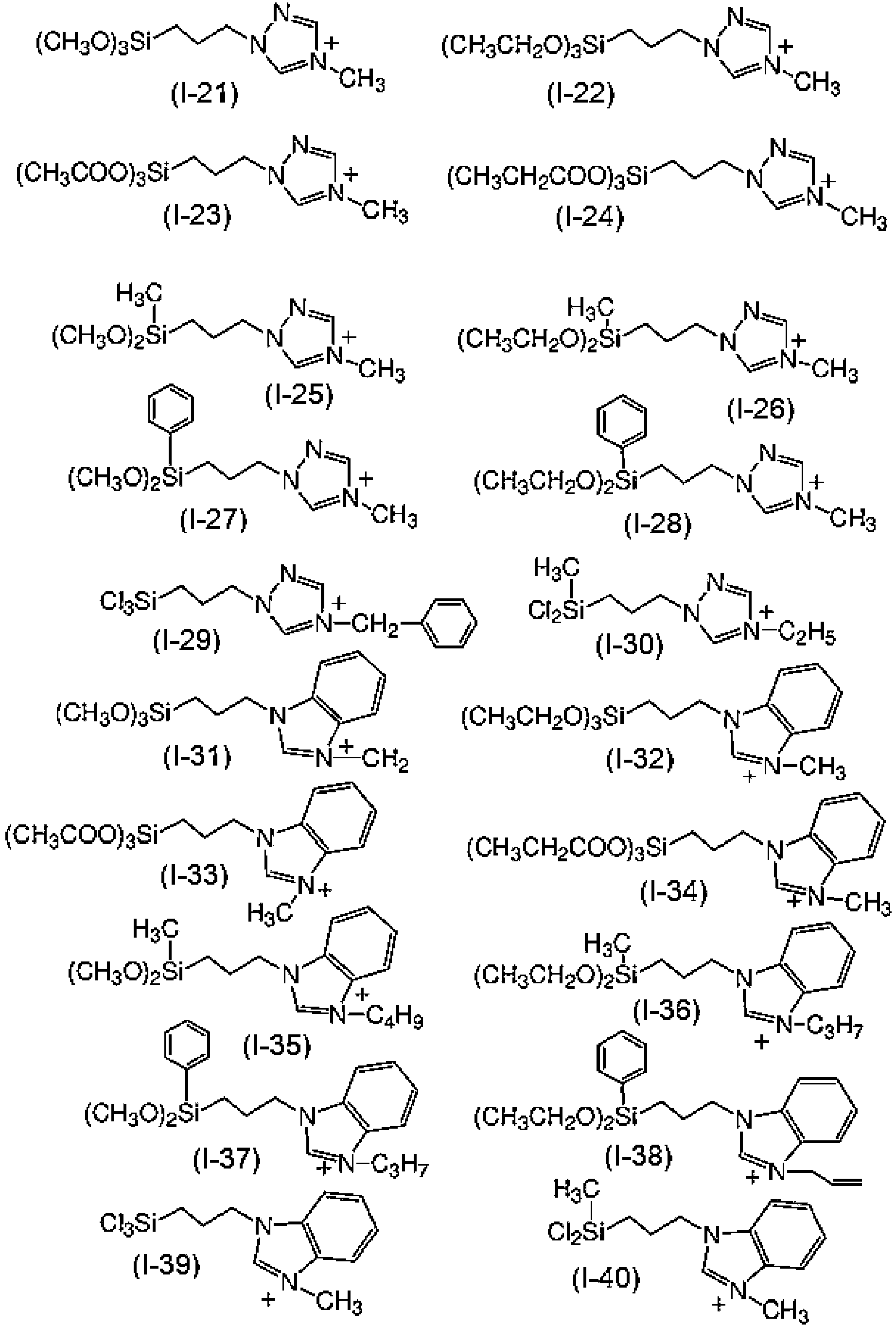

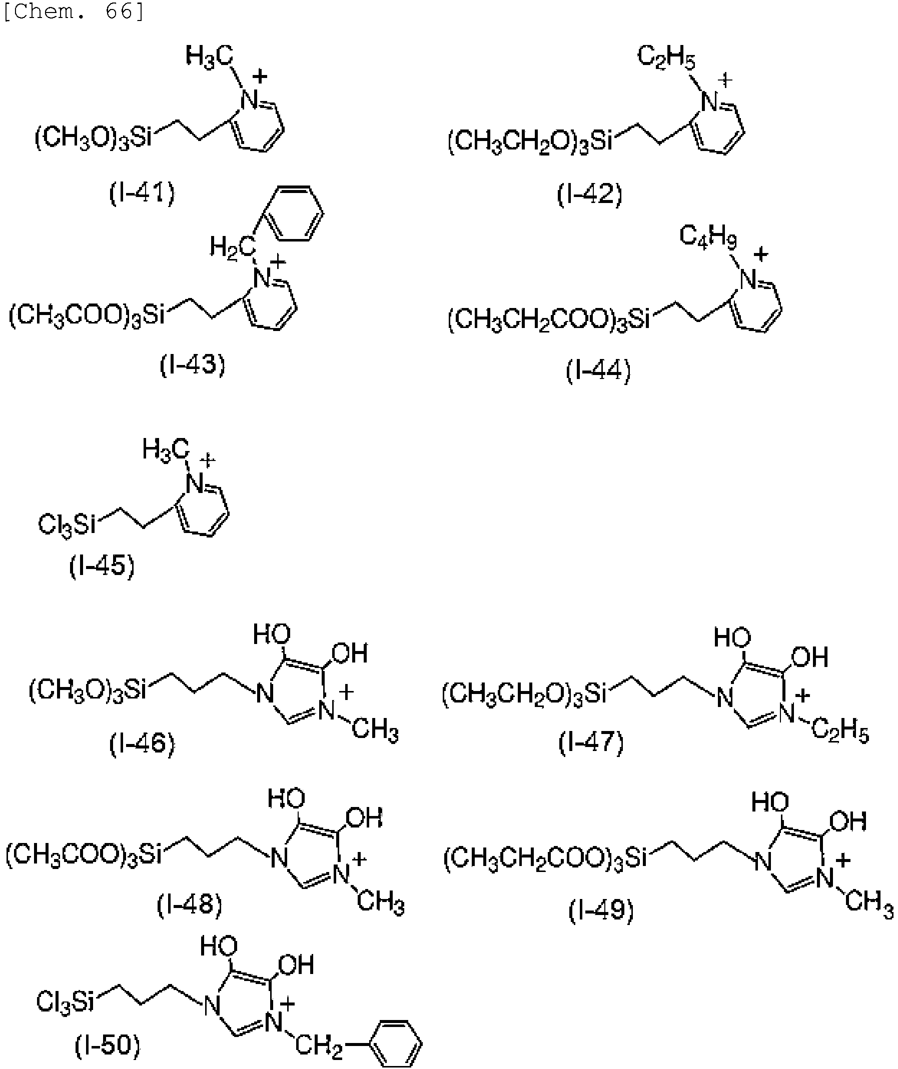

In addition, in another example, R¹¹, which is a group bonded to a silicon atom in Formula (3), can be a heteroaliphatic cyclic ammonium group represented by the following Formula (S2).

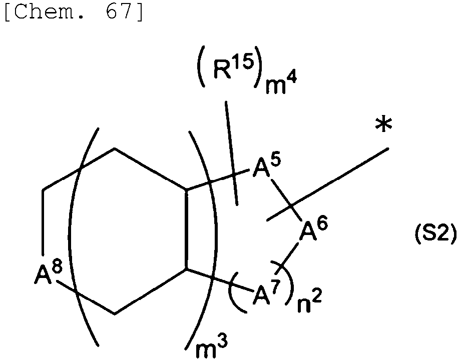

In Formula (S2), A⁵, A⁶, A⁷, and A⁸ each independently represent a group represented by any one of the following Formulae (J4) to (J6), and at least one of A⁵ to A⁸ is a group represented by Formula (J5) described below. Depending on which of A⁵ to A⁸ a silicon atom in Formula (3) is bonded to, it is determined whether a bond between any one of A⁵ to A⁸ and a ring-forming atom adjacent to the any one is a single bond or a double bond so that the ring to be formed exhibits non-aromaticity. * represents a bond.

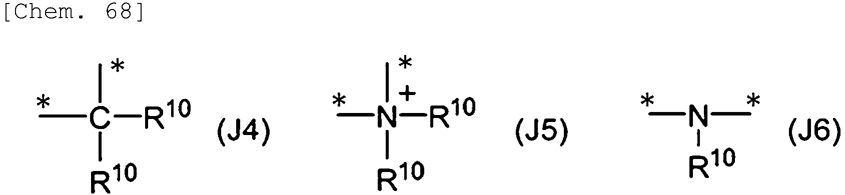

In Formulae (J4) to (J6), each R¹⁰ independently represents a single bond, a hydrogen atom, an alkyl group, an aryl group, an aralkyl group, an alkyl halide group, an aryl halide group, an aralkyl halide group or an alkenyl group. Specific examples of the alkyl group, the aryl group, the aralkyl group, the alkyl halide group, the aryl halide group, the aralkyl halide group, and the alkenyl group, and the suitable number of carbon atoms thereof are the same as those described above. * represents a bond.

In Formula (S2), each R¹⁵ independently represents an alkyl group, an aryl group, an aralkyl group, an alkyl halide group, an aryl halide group, an aralkyl halide group, an alkenyl group or a hydroxy group, and when two or more R¹⁵s are present, the two R¹⁵s may be bonded to each other to form a ring, a ring formed by two R¹⁵s may have a crosslinked ring structure, and in such a case, the cyclic ammonium group has an adamantane ring, a norbornene ring, a spiro ring or the like.

Specific examples of the alkyl group, the aryl group, the aralkyl group, the alkyl halide group, the aryl halide group, the aralkyl halide group, and the alkenyl group, and the suitable number of carbon atoms thereof are the same as those described above.

In Formula (S2), n² is an integer of 1 to 8, m³ is 0 or 1, and m⁴ is 0 or a positive integer ranging from 1 to the maximum number that can be substituted on a monocyclic ring or a polycyclic ring.

When m³ is 0, a (4 + n²)-membered ring including A⁵ to A⁸ is formed. That is, when n² is 1, a 5-membered ring is formed; when n² is 2, a 6-membered ring is formed; when n² is 3, a 7-membered ring is formed; when n² is 4, an 8-membered ring is formed; when n² is 5, a 9-membered ring is formed; when n² is 6, a 10-membered ring is formed; when n² is 7, a 11-membered ring is formed; and when n² is 8, a 12-membered ring is formed.

When m³ is 1, a condensed ring is formed by condensation between a (4 + n²)-membered ring including A⁵ to A⁷ and a 6-membered ring including A⁸.

Depending on whether each of A⁵ to A⁸ is any of Formulae (J4) to (J6), the ring-forming atom has a hydrogen atom or no hydrogen atom, and in each of A⁵ to A⁸, when the ring-forming atom has a hydrogen atom, the hydrogen atom may be substituted with R¹⁵. Alternatively, a ring-forming atom other than the ring-forming atom in each of A⁵ to A⁸ may be substituted with R¹⁵.

Under such circumstances, as described above, m⁴ is selected from an integer of 0 or from 1 to the maximum number that can be substituted on a monocyclic ring or a polycyclic ring.

A bond of the heteroaliphatic cyclic ammonium group represented by Formula (S2) is present on any carbon atom or nitrogen atom present in such a monocyclic ring or condensed ring, and is directly bonded to a silicon atom. Alternatively, the bond is bonded to a linking group to form an organic group containing the cyclic ammonium group, and the organic group is bonded to a silicon atom.

Such a linking group is, for example, an alkylene group, an arylene group, or an alkenylene group, and specific examples of the alkylene group, the arylene group, and the alkenylene group and the suitable number of carbon atoms are the same as those described above.

Specific examples of the silane compound (hydrolyzable organosilane) represented by Formula (3) having a heteroaliphatic cyclic ammonium group represented by Formula (S2) include silanes represented by the following Formulae (II-1) to (II-30), but are not limited thereto.

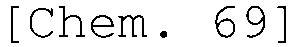

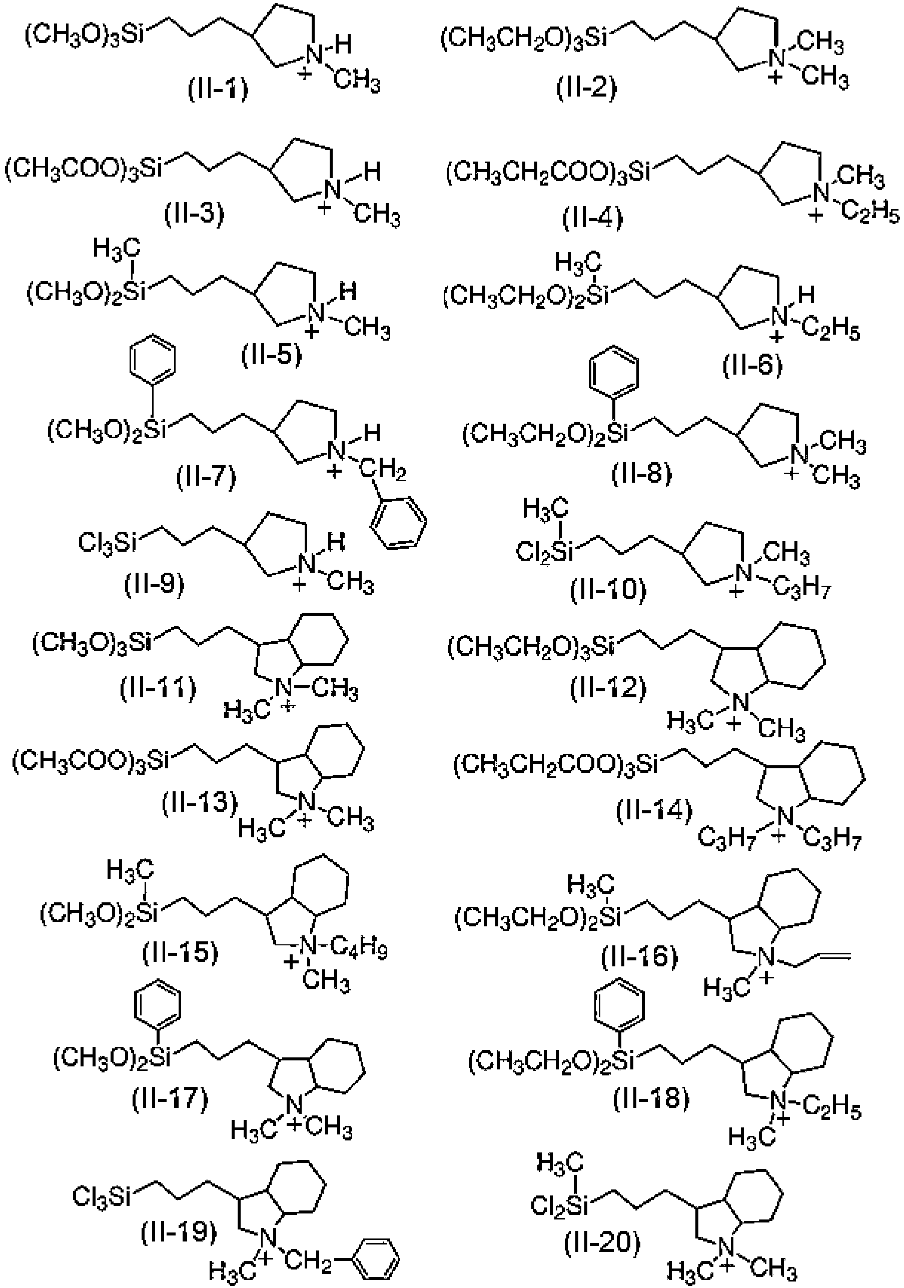

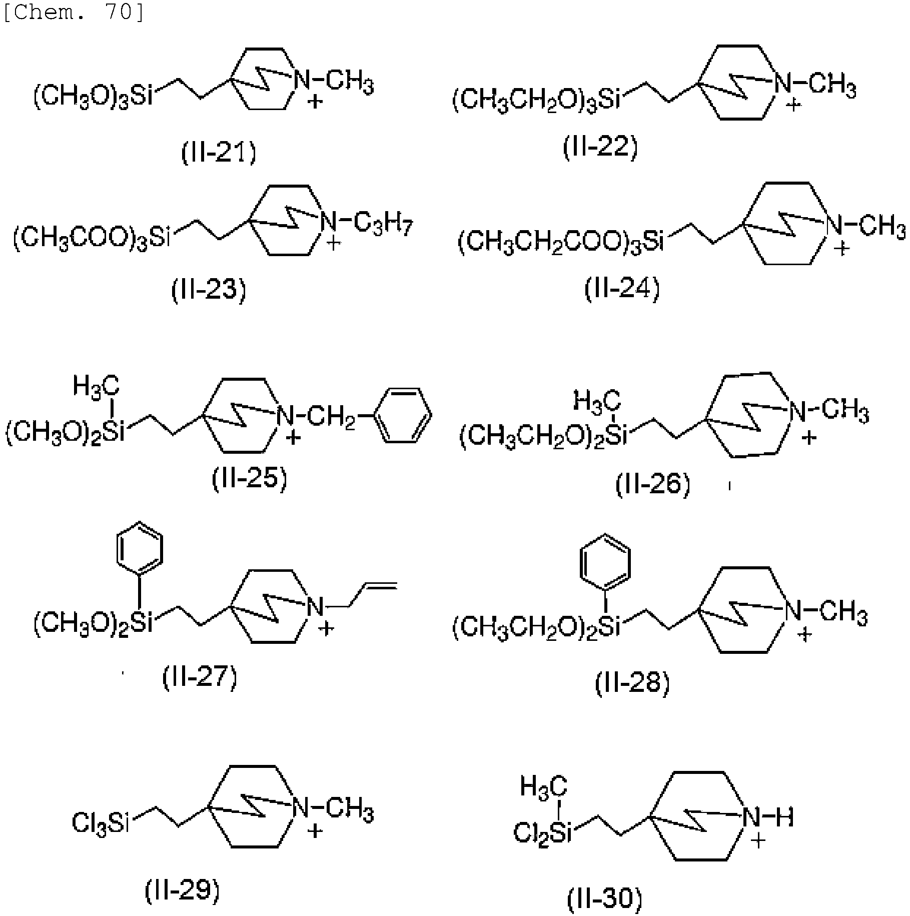

Furthermore, in another example, R¹¹, which is a group bonded to a silicon atom in Formula (3), can be a chain ammonium group represented by the following Formula (S3).

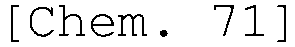

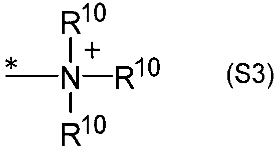

In Formula (S3), each R¹⁰ independently represents a hydrogen atom, an alkyl group, an aryl group, an aralkyl group, an alkyl halide group, an aryl halide group, an aralkyl halide group or an alkenyl group, and specific examples of the alkyl group, the aryl group, the aralkyl group, the alkyl halide group, the aryl halide group, the aralkyl halide group, and the alkenyl group, and the suitable number of carbon atoms thereof are the same as those described above. * represents a bond.

The chain ammonium group represented by Formula (S3) is directly bonded to a silicon atom, or a linking group is bonded to form an organic group having a chain ammonium group, which is bonded to a silicon atom.

Examples of such a linking group include an alkylene group, an arylene group, and an alkenylene group, and specific examples of the alkylene group, the arylene group, and the alkenylene group include the same as described above.

Specific examples of the silane compound (hydrolyzable organosilane) represented by Formula (3) having a chain ammonium group represented by Formula (S3) include silanes represented by the following Formulae (III-1) to (III-28), but are not limited thereto.

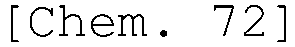

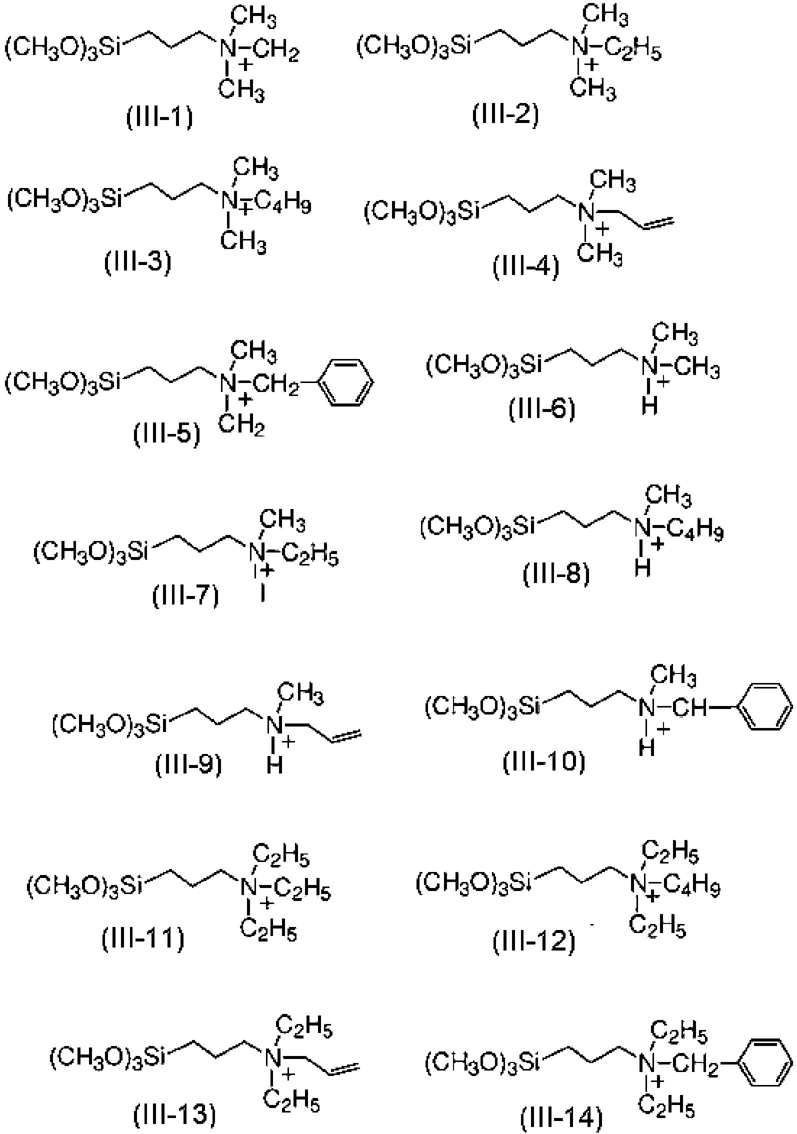

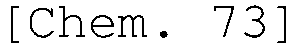

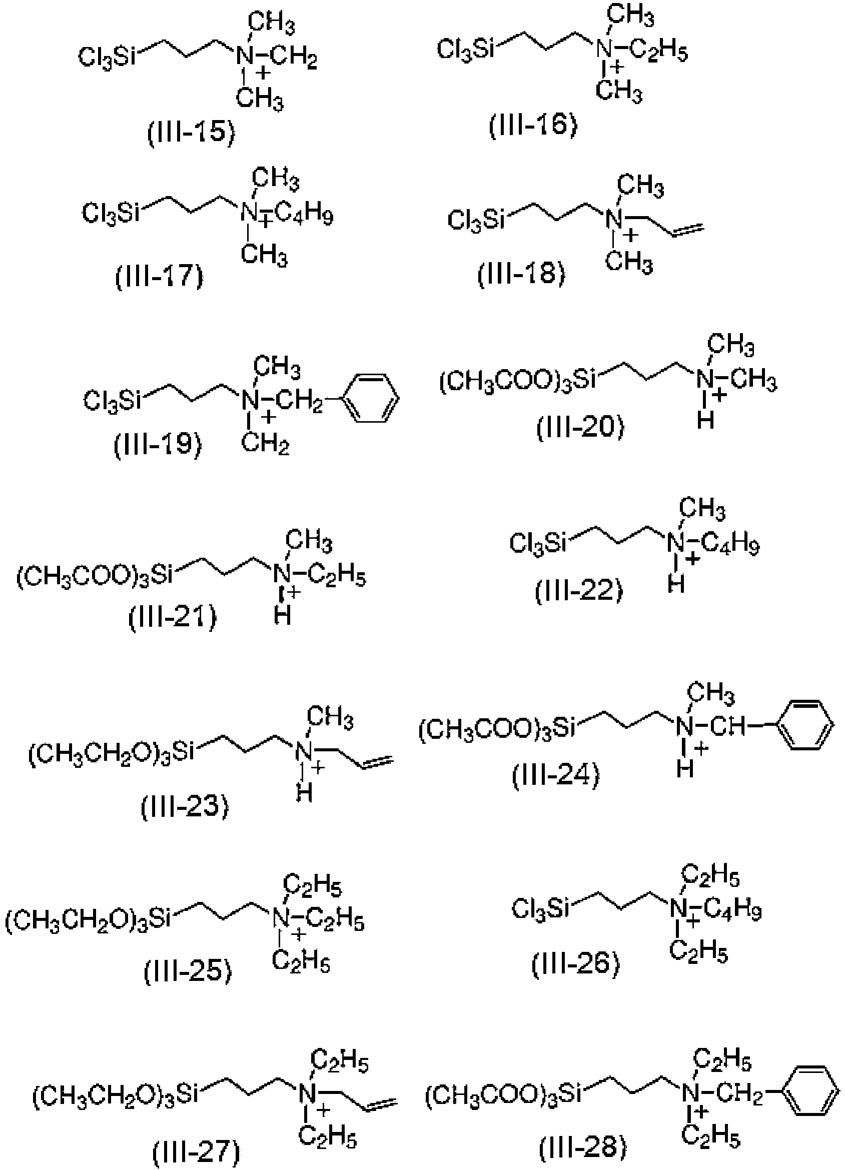

### <<Silane Compound (Hydrolyzable Organosilane) Having Sulfone Group or Sulfonamide Group>>

Examples of a silane compound having a sulfone group and a silane compound having a sulfonamide group include, but are not limited to, compounds represented by the following Formulae (B-1) to (B-36).

In the following Formulae, Me represents a methyl group, and Et represents an ethyl group.

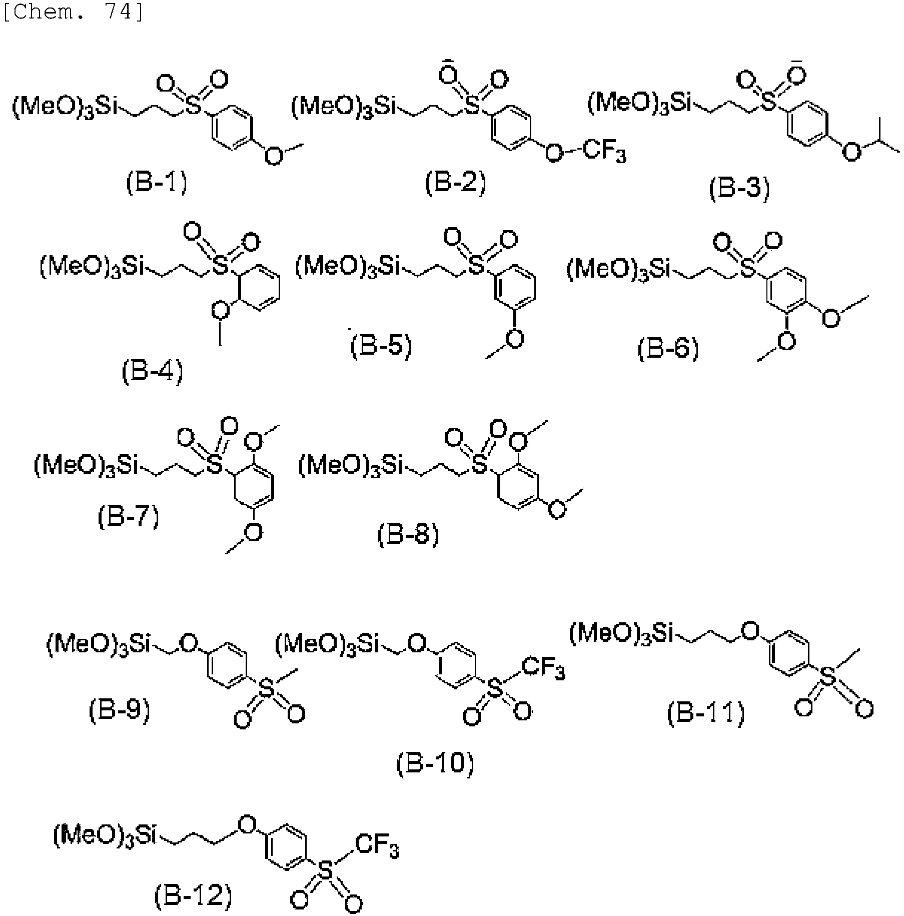

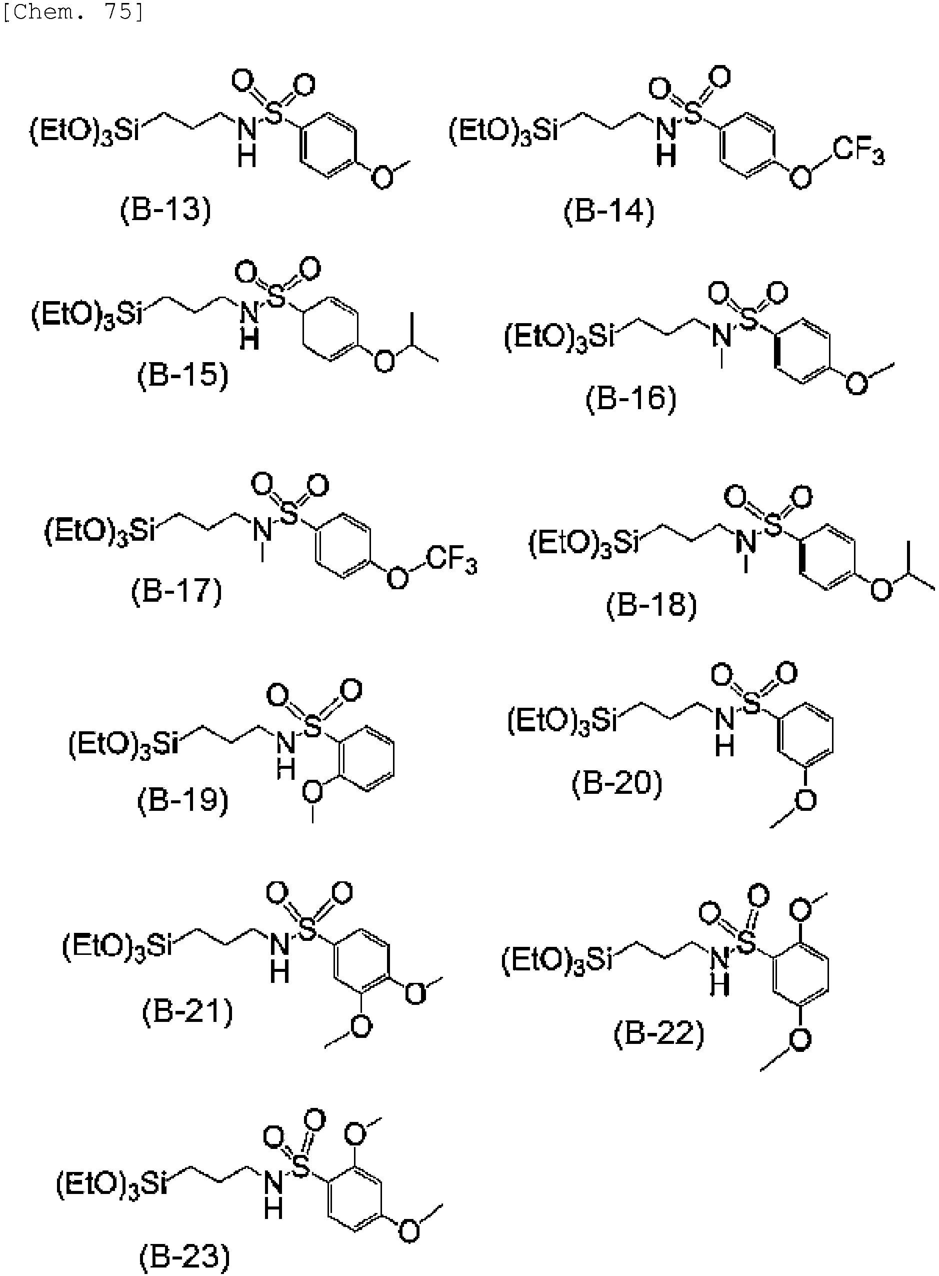

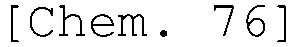

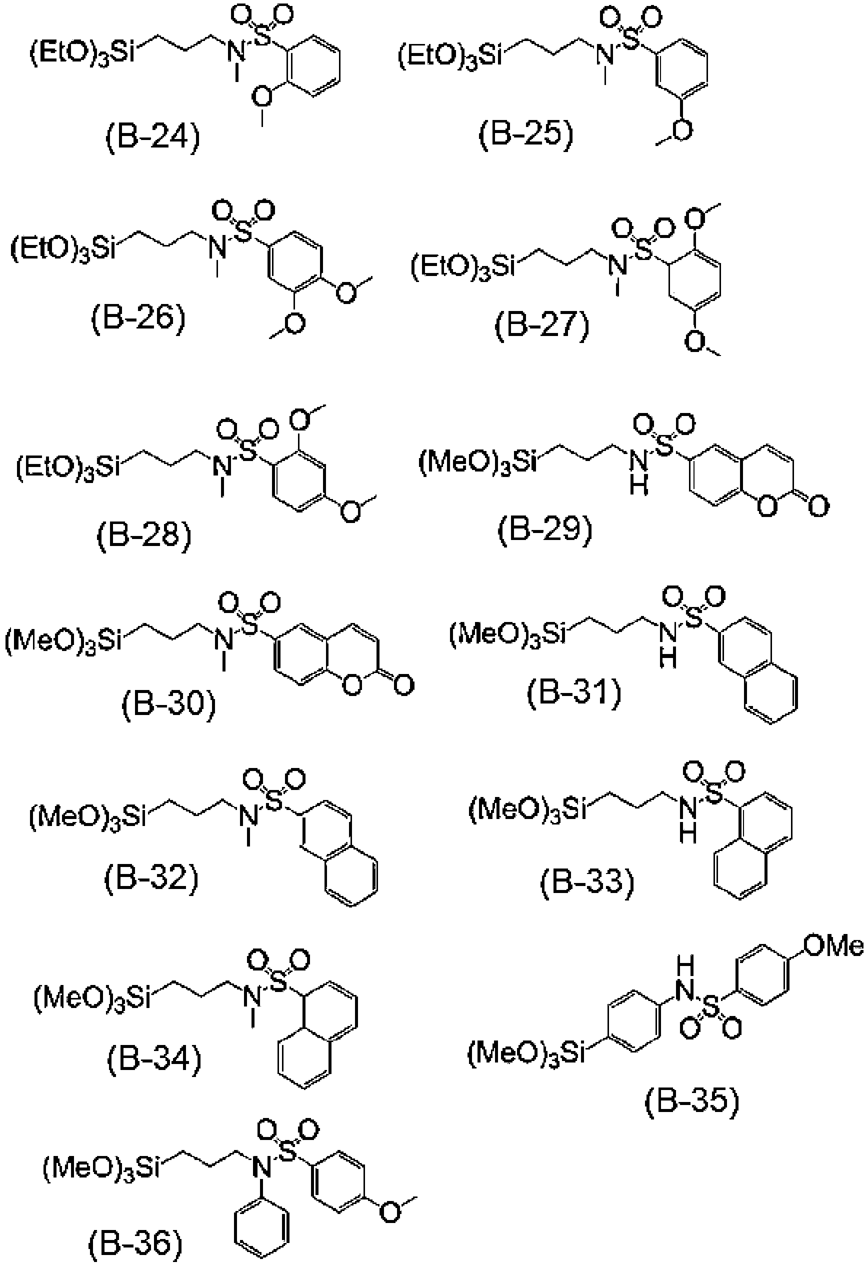

### <<Silane Compound (Hydrolyzable Organosilane) Having Cyclic Urea Skeleton in Molecule>>

Examples of a hydrolyzable organosilane having a cyclic urea skeleton in the molecule include hydrolyzable organosilanes represented by the following Formula (4-1).

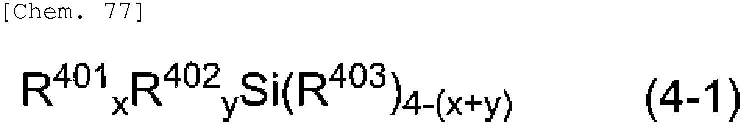

In Formula (4-1), R⁴⁰¹ is a group bonded to a silicon atom, and each R⁴⁰¹ independently represents a group represented by the following Formula (4-2).

R⁴⁰² is a group bonded to a silicon atom, and represents an alkyl group which may be substituted, an aryl group which may be substituted, an aralkyl group which may be substituted, an alkyl halide group which may be substituted, an aryl halide group which may be substituted, an aralkyl halide group which may be substituted, an alkoxyalkyl group which may be substituted, an alkoxyaryl group which may be substituted, an alkoxyaralkyl group which may be substituted, or an alkenyl group which may be substituted, or represents an organic group having an epoxy group, an organic group having an acryloyl group, an organic group having a methacryloyl group, an organic group having a mercapto group, or an organic group having a cyano group, or a combination of two or more of these groups.

R⁴⁰³ is a group or atom bonded to a silicon atom, and each R⁴⁰³ independently represents an alkoxy group, an aralkyloxy group, an acyloxy group, or a halogen atom.

x is 1 or 2, y is 0 or 1, and x + y ≤ 2 is satisfied.

Specific examples of the alkyl group, the aryl group, the aralkyl group, the alkyl halide group, the aryl halide group, the aralkyl halide group, the alkoxyalkyl group, the alkoxyaryl group, the alkoxyaralkyl group, the alkenyl group, the organic group having an epoxy group, the organic group having an acryloyl group, the organic group having a methacryloyl group, the organic group having a mercapto group, and the organic group having a cyano group of R⁴⁰², and the alkoxy group, the aralkyloxy group, the acyloxy group, and the halogen atom of R⁴⁰³, and substituent groups thereof, the suitable number of carbon atoms, and the like include those described above for R³ and X in Formula (A-1). 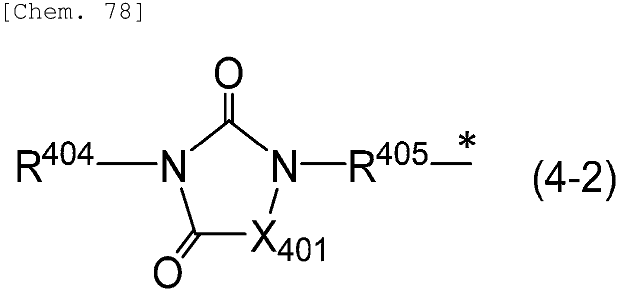 In Formula (4-2), each R⁴⁰⁴ independently represents a hydrogen atom, an alkyl group which may be substituted, an alkenyl group which may be substituted, or an organic group having an epoxy group or an organic group having a sulfonyl group, and each R⁴⁰⁵ independently represents an alkylene group, a hydroxyalkylene group, a sulfide bond (-S-), an ether bond (-O-), or an ester bond (-CO-O- or -O-CO-). * represents a bond.

Specific examples and the suitable numbers of carbon atoms of the alkyl group which may be substituted, the alkenyl group which may be substituted, and the organic group having an epoxy group of R⁴⁰⁴ are the same as those described above for R³ in Formula (A-1), but besides these, as the alkyl group which may be substituted of R⁴⁰⁴, an alkyl group in which a terminal hydrogen atom is substituted with a vinyl group is preferable, and specific examples thereof include an allyl group, a 2-vinylethyl group, a 3-vinylpropyl group, and a 4-vinylbutyl group.

The organic group having a sulfonyl group is not particularly limited as long as it contains a sulfonyl group, and examples thereof include an alkylsulfonyl group which may be substituted, an arylsulfonyl group which may be substituted, an aralkylsulfonyl group which may be substituted, an alkylsulfonyl halide group which may be substituted, an arylsulfonyl halide group which may be substituted, an aralkylsulfonyl halide group which may be substituted, an alkoxyalkylsulfonyl group which may be substituted, an alkoxyarylsulfonyl group which may be substituted, an alkoxyaralkylsulfonyl group which may be substituted, and an alkenylsulfonyl group which may be substituted.

Specific examples and the suitable numbers of carbon atoms of the alkyl group, the aryl group, the aralkyl group, the alkyl halide group, the aryl halide group, the aralkyl halide group, the alkoxyalkyl group, the alkoxyaryl group, the alkoxyaralkyl group, and the alkenyl group of these groups, and the substituent groups thereof may be the same as those described above for R³ in Formula (A-1).

The alkylene group is a divalent group derived by further removing one hydrogen atom from the alkyl group, and may be linear, branched, or cyclic, and specific examples of such an alkylene group are the same as those described above. The alkylene group preferably has, but is not particularly limited to, 40 or less carbon atoms, more preferably 30 or less carbon atoms, still more preferably 20 or less carbon atoms, and yet still more preferably 10 or less carbon atoms.

In addition, the alkylene group of R⁴⁰⁵ may have one or two or more selected from a sulfide bond, an ether bond, and an ester bond at the terminal or in the middle, preferably in the middle.

Specific examples of the alkylene group include, but are not limited to, linear alkylene groups such as a methylene group, an ethylene group, a trimethylene group, a tetramethylene group, a pentamethylene group, a hexamethylene group, a heptamethylene group, an octamethylene group, a nonamethylene group and a decamethylene group; branched alkylene groups such as a methylethylene group, a 1-methyltrimethylene group, a 2-methyltrimethylene group, a 1,1-dimethylethylene group, a 1-methyltetramethylene group, a 2-methyltetramethylene group, a 1,1-dimethyltrimethylene group, a 1,2-dimethyltrimethylene group, a 2,2-dimethyltrimethylene group and a 1-ethyltrimethylene group; cyclic alkylene groups such as a 1,2-cyclopropanediyl group, a 1,2-cyclobutanediyl group, a 1,3-cyclobutanediyl group, a 1,2-cyclohexanediyl group and a 1,3-cyclohexanediyl group; and ether groups such as -CH₂OCH₂-, -CH₂CH₂OCH₂-, -CH₂CH₂OCH₂CH₂-, -CH₂CH₂CH₂OCH₂CH₂-, -CH₂CH₂OCH₂CH₂CH₂-, -CH₂CH₂CH₂OCH₂CH₂CH₂-, - CH₂SCH₂-, -CH₂CH₂SCH₂-, -CH₂CH₂SCH₂CH₂-, -CH₂CH₂CH₂SCH₂CH₂-, - CH₂CH₂SCH₂CH₂CH₂-, -CH₂CH₂CH₂SCH₂CH₂CH₂-, and -CH₂OCH₂CH₂SCH₂-.

The hydroxyalkylene group is a group in which at least one hydrogen atom of the aforementioned alkylene group is substituted with a hydroxy group, and specific examples of the hydroxyalkylene group include, but are not limited to, a hydroxymethylene group, a 1-hydroxyethylene group, a 2-hydroxyethylene group, a 1,2-dihydroxyethylene group, a 1-hydroxytrimethylene group, a 2-hydroxytrimethylene group, a 3-hydroxytrimethylene group, a 1-hydroxytetramethylene group, a 2-hydroxytetramethylene group, a 3-hydroxytetramethylene group, a 4-hydroxytetramethylene group, a 1,2-dihydroxytetramethylene group, a 1,3-dihydroxytetramethylene group, a 1,4-dihydroxytetramethylene group, a 2,3-dihydroxytetramethylene group, a 2,4-dihydroxytetramethylene group, and a 4,4-dihydroxytetramethylene group.

In Formula (4-2), each X₄₀₁ independently represents any one of groups represented by the following Formulae (4-3) to (4-5), and a carbon atom of a ketone group in the following Formulae (4-4) and (4-5) is bonded to a nitrogen atom to which R⁴⁰⁵ in Formula (4-2) is bonded.

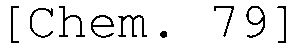

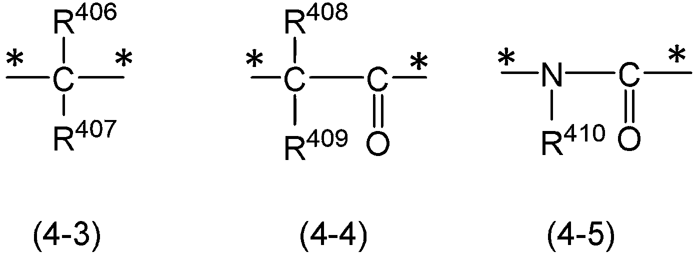

In Formulae (4-3) to (4-5), R⁴⁰⁶ to R⁴¹⁰ each independently represents a hydrogen atom, an alkyl group which may be substituted, an alkenyl group which may be substituted, or an organic group having an epoxy group or a sulfonyl group. Specific examples and the suitable numbers of carbon atoms of the alkyl group which may be substituted, the alkenyl group which may be substituted, and the organic group having an epoxy group or a sulfonyl group include those described above for R³ in Formula (A-1). Specific examples of the organic group having a sulfonyl group and the suitable number of carbon atoms are the same as those described above with regard to R⁴⁰⁴. * represents a bond.

Among them, from the viewpoint of achieving excellent lithography characteristics with good reproducibility, X₄₀₁ is preferably a group represented by Formula (4-5).

From the viewpoint of achieving excellent lithographic characteristics with good reproducibility, at least one of R⁴⁰⁴ and R⁴⁰⁶ to R⁴¹⁰ is preferably an alkyl group in which a terminal hydrogen atom is substituted with a vinyl group.

As the hydrolyzable organosilane represented by Formula (4-1), a commercially available product may be used, and the hydrolyzable organosilane can also be synthesized by a known method described in WO 2011/102470 A or the like.

Hereinafter, specific examples of the hydrolyzable organosilane represented by Formula (4-1) include, but are not limited to, silanes represented by the following Formulae (4-1-1) to (4-1-29).

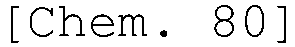

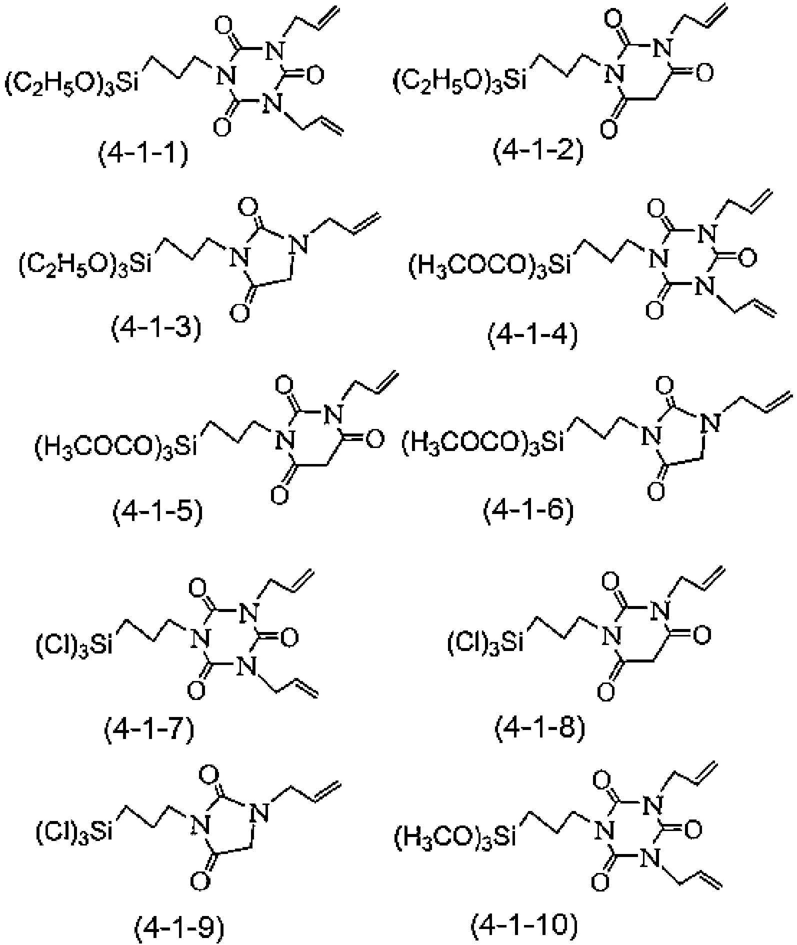

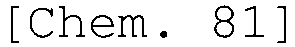

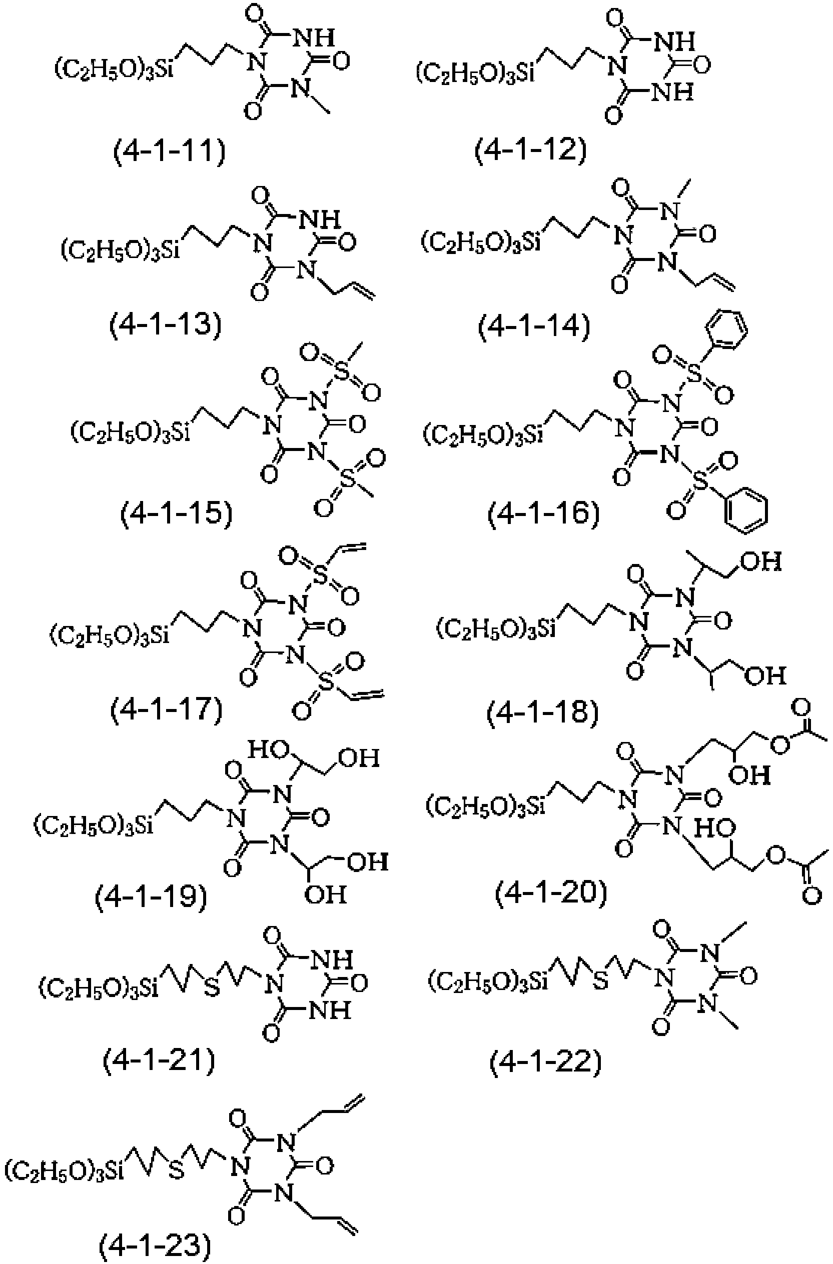

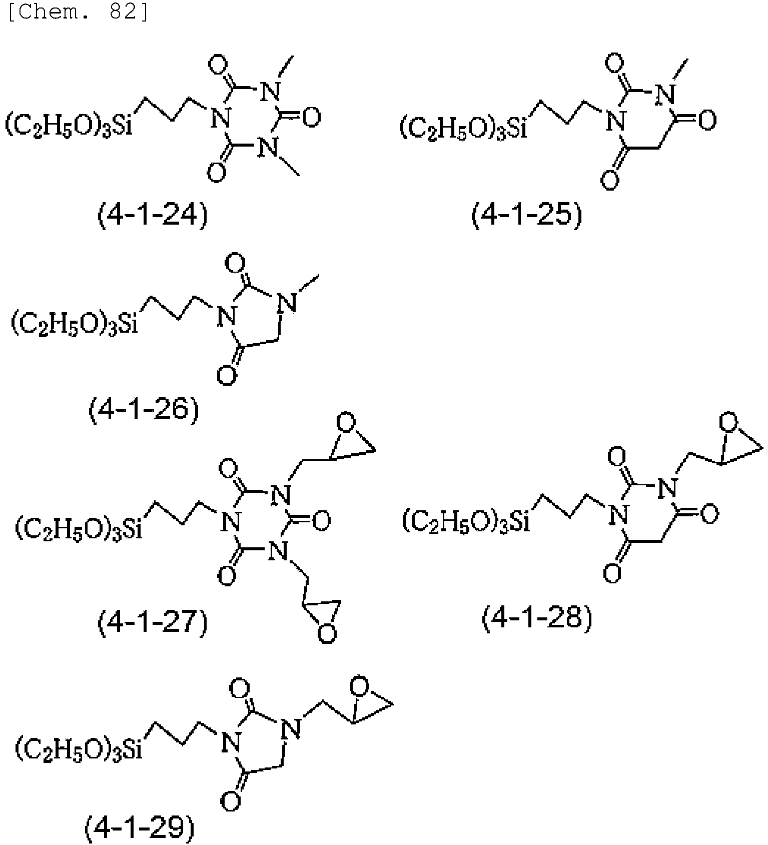

The polysiloxane [A] and the polysiloxane [A'] each may be a hydrolytic condensate of a hydrolyzable silane containing a silane compound other than those exemplified above or a modified product thereof as long as the effects of the present invention are not impaired.

As described above, as polysiloxane [A] and polysiloxane [A'], a modified product in which at least a part of silanol groups of the hydrolytic condensate is modified can be used. For example, a modified product in which a part of silanol groups is alcohol-modified or acetal-protected can be used.

Examples of the polysiloxane as the modified product include a reaction product obtained by a reaction between at least a part of silanol groups of a hydrolytic condensate and a hydroxy group of an alcohol in the condensate of the hydrolyzable silane described above, a dehydration reaction product between the condensate and an alcohol, and a modified product obtained by protecting at least a part of silanol groups of the condensate with an acetal group.

As the alcohol, a monohydric alcohol can be used, and examples of the monohydric alcohol include methanol, ethanol, 2-propanol, 1-butanol, 2-butanol, isobutyl alcohol, tert-butyl alcohol, 1-pentanol, 2-pentanol, 3-pentanol, 1-heptanol, 2-heptanol, tert-amyl alcohol, neopentyl alcohol, 2-methyl-1-propanol, 2-methyl-1-butanol, 3-methyl-1-butanol, 3-methyl-3-pentanol, cyclopentanol, 1-hexanol, 2-hexanol, 3-hexanol, 2,3-dimethyl-2-butanol, 3,3-dimethyl-1-butanol, 3,3-dimethyl-2-butanol, 2-diethyl-1-butanol, 2-methyl-1-pentanol, 2-methyl-2-pentanol, 2-methyl-3-pentanol, 3-methyl-1-pentanol, 3-methyl-2-pentanol, 3-methyl-3-pentanol, 4-methyl-1-pentanol, 4-methyl-2-pentanol, 4-methyl-3-pentanol, and cyclohexanol.

In addition, for example, alkoxy group-containing alcohols such as 3-methoxybutanol, ethylene glycol monomethyl ether, ethylene glycol monoethyl ether, diethylene glycol monomethyl ether, diethylene glycol monoethyl ether, propylene glycol monomethyl ether(1-methoxy-2-propanol), propylene glycol monoethyl ether (1-ethoxy-2-propanol), and propylene glycol monobutyl ether(1-butoxy-2-propanol) can be used.

Regarding the reaction between the silanol group of the hydrolytic condensate and the hydroxy group of the alcohol, the hydrolytic condensate and the alcohol are brought into contact with each other and reacted at a temperature of 40°C to 160°C, for example, 60°C, for 0.1 to 48 hours, for example, 24 hours, whereby a modified product in which the silanol group is capped is obtained. In this case, the alcohol serving as a capping agent may be used as a solvent in the composition containing the polysiloxane.

The dehydration reaction product between the hydrolytic condensate of hydrolyzable silane and the alcohol can be produced by reacting the hydrolytic condensate with the alcohol in the presence of an acid as a catalyst, capping silanol groups with the alcohol, and removing water generated through the dehydration to the outside of the reaction system.

As the acid, an organic acid having an acid dissociation constant (pka) of -1 to 5, preferably 4 to 5 can be used. Examples of the acid include trifluoroacetic acid, maleic acid, benzoic acid, isobutyric acid, and acetic acid, and among them, benzoic acid, isobutyric acid, acetic acid, and the like can be exemplified.

As the acid, an acid having a boiling point of 70 to 160°C can be used, and examples thereof include trifluoroacetic acid, isobutyric acid, acetic acid, and nitric acid.

As described above, the acid preferably has a physical property of an acid dissociation constant (pka) of 4 to 5 or a boiling point of 70°C to 160°C. That is, one having a low acidity or one having a low boiling point even though the acidity is high can be used.

Then, as the acid, any property can be used from the properties of the acid dissociation constant and the boiling point.

For acetal protection of the silanol group of the hydrolytic condensate, a vinyl ether, for example, a vinyl ether represented by the following Formula (5), can be used, and a partial structure represented by the following Formula (6) can be introduced into a polysiloxane by the reaction.

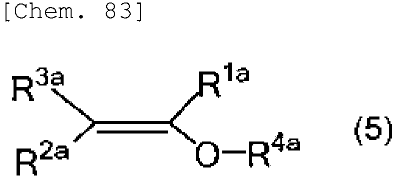

In Formula (5), R^{1a}, R^{2a}, and R^{3a} each represent a hydrogen atom or an alkyl group having 1 to 10 carbon atoms, R^{4a} represents an alkyl group having 1 to 10 carbon atoms, and R^{2a} and R^{4a} may be bonded together to form a ring. Examples of the alkyl group include the examples described above.

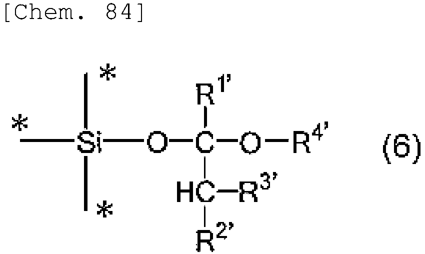

In Formula (6), R¹', R²', and R³' each represent a hydrogen atom or an alkyl group having 1 to 10 carbon atoms, R⁴' represents an alkyl group having 1 to 10 carbon atoms, and R²' and R⁴' may be bonded together to form a ring. In Formula (6), * represents a bond to an adjacent atom. The adjacent atom is, for example, an oxygen atom of a siloxane bond, an oxygen atom of a silanol group, or a carbon atom derived from R¹ of Formula (1). Examples of the alkyl group include the examples described above.

Examples of the vinyl ether represented by Formula (5) include aliphatic vinyl ether compounds such as methyl vinyl ether, ethyl vinyl ether, isopropyl vinyl ether, normal butyl vinyl ether, 2-ethylhexyl vinyl ether, tert-butyl vinyl ether, and cyclohexyl vinyl ether, and cyclic vinyl ether compounds such as 2,3-dihydrofuran, 4-methyl-2,3-dihydrofuran, and 3,4-dihydro-2H-pyran. In particular, ethyl vinyl ether, propyl vinyl ether, butyl vinyl ether, ethylhexyl vinyl ether, cyclohexyl vinyl ether, 3,4-dihydro-2H-pyran, or 2,3-dihydrofuran may be preferably used.

The acetal protection of the silanol group can be performed using a hydrolytic condensate, a vinyl ether, and an aprotic solvent such as propylene glycol monomethyl ether acetate, ethyl acetate, dimethylformamide, tetrahydrofuran, or 1,4-dioxane as a solvent, and using a catalyst such as a pyridium para-toluenesulfonic acid, a trifluoromethanesulfonic acid, a para-toluenesulfonic acid, a methanesulfonic acid, a hydrochloric acid, or a sulfuric acid.

The capping of silanol groups with an alcohol or the acetal protection of silanol groups may be performed simultaneously with the hydrolysis and condensation of the hydrolyzable silane described later.

The hydrolytic condensate of hydrolyzable silane or a modified product of the hydrolytic condensate may have a weight-average molecular weight of, for example, 500 to 1,000,000. From the viewpoint of suppressing precipitation of a hydrolytic condensate s or a modified product thereof in the composition, or the like, the weight-average molecular weight can be preferably 500,000 or less, more preferably 250,000 or less, and still more preferably 100,000 or less, and from the viewpoint of achieving both storage stability and coatability, or the like, the weight-average molecular weight can be preferably 700 or more, and more preferably 1,000 or more.

The weight-average molecular weight is determined by GPC analysis in terms of polystyrene. The GPC analysis can be performed using, for example, a GPC apparatus (trade name: HLC-8220GPC, manufactured by Tosoh Corporation), a GPC column (trade name: Shodex (registered trademark) KF803L, KF802, KF801, manufactured by Showa Denko K.K.), at a column temperature of 40°C, with tetrahydrofuran as an eluent (elution solvent), at a flow amount (flow rate) of 1.0 mL/min, with polystyrene (Shodex (registered trademark) manufactured by Showa Denko K.K.) as a standard sample.

The hydrolytic condensate of hydrolyzable silane is prepared by hydrolysis and condensation of the aforementioned silane compound (hydrolyzable silane).

The aforementioned silane compound (hydrolyzable silane) contains an alkoxy group, aralkyloxy group, acyloxy group, or halogen atom directly bonded to a silicon atom; that is, an alkoxysilyl group, an aralkyloxysilyl group, an acyloxysilyl group, or a silyl halide group (hereinafter, such a group is referred to as "hydrolyzable group").

For the hydrolysis of the hydrolyzable group, water is used in an amount of usually 0.1 to 100 mol, for example, 0.5 to 100 mol, and preferably 1 to 10 mol per mol of the hydrolyzable group.

During hydrolysis and condensation, a hydrolysis catalyst may be used for the purpose of promoting the reaction, or the hydrolysis and condensation may be performed without use of a hydrolysis catalyst. When the hydrolysis catalyst is used, the hydrolysis catalyst can be used in an amount of usually 0.0001 to 10 mol, and preferably 0.001 to 1 mol per mol of the hydrolyzable group.

The reaction temperature for the hydrolysis and condensation is usually equal to or higher than room temperature, or equal to or lower than the reflux temperature at normal pressure of an organic solvent usable for hydrolysis, and the reaction temperature may be, for example, 20°C to 110°C, or, for example, 20°C to 80°C.

The hydrolysis may be performed completely; that is, all hydrolyzable groups may be converted into silanol groups, or may be performed partially; that is, unreacted hydrolyzable groups may remain.

Examples of the hydrolysis catalyst usable for the hydrolysis and condensation include a metal chelate compound, an organic acid, an inorganic acid, an organic base, and an inorganic base.

Examples of the metal chelate compound as the hydrolysis catalyst include, but are not limited to, titanium chelate compounds such as triethoxy-mono(acetylacetonate)titanium, tri-n-propoxy-mono(acetylacetonate)titanium, tri-i-propoxy-mono(acetylacetonate)titanium, tri-n-butoxy-mono(acetylacetonate)titanium, tri-sec-butoxy-mono(acetylacetonate)titanium, tri-t-butoxy-mono(acetylacetonate)titanium, diethoxy-bis(acetylacetonate)titanium, di-n-propoxy-bis(acetylacetonate)titanium, di-i-propoxy-bis(acetylacetonate)titanium, di-n-butoxy-bis(acetylacetonate)titanium, di-sec-butoxy-bis(acetylacetonate)titanium, di-t-butoxy-bis(acetylacetonate)titanium, monoethoxy-tris(acetylacetonate)titanium, mono-n-propoxy-tris(acetylacetonate)titanium, mono-i-propoxy-tris(acetylacetonate)titanium, mono-n-butoxy-tris(acetylacetonate)titanium, mono-sec-butoxy-tris(acetylacetonate)titanium, mono-t-butoxy-tris(acetylacetonate)titanium, tetrakis(acetylacetonate)titanium, triethoxy-mono(ethyl acetoacetate) titanium, tri-n-propoxy-mono(ethyl acetoacetate) titanium, tri-i-propoxy-mono(ethyl acetoacetate) titanium, tri-n-butoxy-mono(ethyl acetoacetate) titanium, tri-sec-butoxy-mono(ethyl acetoacetate) titanium, tri-t-butoxy-mono(ethyl acetoacetate) titanium, diethoxy-bis(ethyl acetoacetate) titanium, di-n-propoxy-bis(ethyl acetoacetate) titanium, di-i-propoxy-bis(ethyl acetoacetate) titanium, di-n-butoxy-bis(ethyl acetoacetate) titanium, di-sec-butoxy-bis(ethyl acetoacetate) titanium, di-t-butoxy-bis(ethyl acetoacetate) titanium, monoethoxy-tris(ethyl acetoacetate) titanium, mono-n-propoxy-tris(ethyl acetoacetate) titanium, mono-i-propoxy-tris(ethyl acetoacetate) titanium, mono-n-butoxy-tris(ethyl acetoacetate) titanium, mono-sec-butoxy-tris(ethyl acetoacetate) titanium, mono-t-butoxy-tris(ethyl acetoacetate) titanium, tetrakis(ethyl acetoacetate) titanium, mono(acetylacetonate)tris(ethyl acetoacetate) titanium, bis(acetylacetonate)bis(ethyl acetoacetate) titanium, and tris(acetylacetonate)mono(ethyl acetoacetate)titanium; zirconium chelate compounds such as triethoxy-mono(acetylacetonate) zirconium, tri-n-propoxy-mono(acetylacetonate) zirconium, tri-i-propoxy-mono(acetylacetonate) zirconium, tri-n-butoxy-mono(acetylacetonate) zirconium, tri-sec-butoxy-mono(acetylacetonate) zirconium, tri-t-butoxy-mono(acetylacetonate) zirconium, diethoxy-bis(acetylacetonate)zirconium, di-n-propoxy-bis(acetylacetonate)zirconium, di-i-propoxy-bis(acetylacetonate)zirconium, di-n-butoxy-bis(acetylacetonate)zirconium, di-sec-butoxy-bis(acetylacetonate)zirconium, di-t-butoxy-bis(acetylacetonate)zirconium, monoethoxy-tris(acetylacetonate)zirconium, mono-n-propoxy-tris(acetylacetonato)zirconium, mono-i-propoxy-tris(acetylacetonate)zirconium, mono-n-butoxy-tris(acetylacetonate)zirconium, mono-sec-butoxy-tris(acetylacetonate)zirconium, mono-t-butoxy-tris(acetylacetonate)zirconium, tetrakis(acetylacetonate)zirconium, triethoxy-mono(ethyl acetoacetate) zirconium, tri-n-propoxy-mono(ethyl acetoacetate) zirconium, tri-i-propoxy-mono(ethyl acetoacetate) zirconium, tri-n-butoxy-mono(ethyl acetoacetate) zirconium, tri-sec-butoxy-mono(ethyl acetoacetate) zirconium, tri-t-butoxy-mono(ethyl acetoacetate) zirconium, diethoxy-bis(ethyl acetoacetate) zirconium, di-n-propoxy-bis(ethyl acetoacetate) zirconium, di-i-propoxy-bis(ethyl acetoacetate) zirconium, di-n-butoxy-bis(ethyl acetoacetate) zirconium, di-sec-butoxy-bis(ethyl acetoacetate) zirconium, di-t-butoxy-bis(ethyl acetoacetate) zirconium, monoethoxy-tris(ethyl acetoacetate) zirconium, mono-n-propoxy-tris(ethyl acetoacetate) zirconium, mono-i-propoxy-tris(ethyl acetoacetate) zirconium, mono-n-butoxy-tris(ethyl acetoacetate) zirconium, mono-sec-butoxy-tris(ethyl acetoacetate) zirconium, mono-t-butoxy-tris(ethyl acetoacetate) zirconium, tetrakis(ethyl acetoacetate) zirconium, mono(acetylacetonate)tris(ethyl acetoacetate) zirconium, bis(acetylacetonate)bis(ethyl acetoacetate) zirconium, and tris(acetylacetonate)mono(ethyl acetoacetate) zirconium; and aluminum chelate compounds such as tris(acetylacetonate)aluminum and tris(ethyl acetoacetate)aluminum.

Examples of the organic acid as the hydrolysis catalyst include, but are not limited to, acetic acid, propionic acid, butanoic acid, pentanoic acid, hexanoic acid, heptanoic acid, octanoic acid, nonanoic acid, decanoic acid, oxalic acid, maleic acid, methylmalonic acid, adipic acid, sebacic acid, gallic acid, butyric acid, mellitic acid, arachidonic acid, 2-ethylhexanoic acid, oleic acid, stearic acid, linoleic acid, linolenic acid, salicylic acid, benzoic acid, p-aminobenzoic acid, p-toluenesulfonic acid, benzenesulfonic acid, monochloroacetic acid, dichloroacetic acid, trichloroacetic acid, trifluoroacetic acid, formic acid, malonic acid, sulfonic acid, phthalic acid, fumaric acid, citric acid, and tartaric acid.

Examples of the inorganic acid as the hydrolysis catalyst include, but are not limited to, hydrochloric acid, nitric acid, sulfuric acid, hydrofluoric acid, and phosphoric acid.

Examples of the organic base as the hydrolysis catalyst include, but are not limited to, pyridine, pyrrole, piperazine, pyrrolidine, piperidine, picoline, trimethylamine, triethylamine, monoethanolamine, diethanolamine, dimethylmonoethanolamine, monomethyldiethanolamine, triethanolamine, diazabicyclooctane, diazabicyclononane, diazabicycloundecene, tetramethylammonium hydroxide, tetraethylammonium hydroxide, tetrapropylammonium hydroxide, tetrabutylammonium hydroxide, trimethylphenylammonium hydroxide, benzyltrimethylammonium hydroxide, and benzyltriethylammonium hydroxide.

Examples of the inorganic base as the hydrolysis catalyst include, but are not limited to, ammonia, sodium hydroxide, potassium hydroxide, barium hydroxide, and calcium hydroxide.

Among these catalysts, metal chelate compounds, organic acids, and inorganic acids are preferable, and these may be used singly or in combination of two or more kinds thereof.

Among them, in the present invention, a nitric acid can be suitably used as the hydrolysis catalyst. By using a nitric acid, the storage stability of the reaction solution after hydrolysis and condensation can be improved, and in particular, a change in the molecular weight of the hydrolytic condensate or its modified product can be suppressed. The stability of the hydrolytic condensate or its modified product in the solution has been found to depend on the pH of the solution. As a result of intensive studies, it has been found that the pH of the reaction solution falls in a stable range by use of an appropriate amount of a nitric acid.

As described above, a nitric acid can also be used for preparation of a modified product of the hydrolytic condensate; for example, for capping of silanol groups with an alcohol. Thus, nitric acid is preferred from the viewpoint that it can contribute to the reactions of hydrolysis and condensation of the hydrolyzable silane, as well as the reaction of capping of the hydrolytic condensate with an alcohol.

When hydrolysis and condensation are performed, an organic solvent may be used as a solvent, and specific examples thereof include, but are not limited to, aliphatic hydrocarbon-based solvents such as n-pentane, i-pentane, n-hexane, i-hexane, n-heptane, i-heptane, 2,2,4-trimethylpentane, n-octane, i-octane, cyclohexane, and methylcyclohexane; aromatic hydrocarbon-based solvents such as benzene, toluene, xylene, ethylbenzene, trimethylbenzene, methylethylbenzene, n-propylbenzene, i-propylbenzene, diethylbenzene, i-butylbenzene, triethylbenzene, di-i-propylbenzene, and n-amylnaphthalene; monoalcohol-based solvents such as methanol, ethanol, n-propanol, i-propanol, n-butanol, i-butanol, sec-butanol, t-butanol, n-pentanol, i-pentanol, 2-methylbutanol, sec-pentanol, t-pentanol, 3-methoxybutanol, n-hexanol, 2-methylpentanol, sec-hexanol, 2-ethylbutanol, n-heptanol, sec-heptanol, 3-heptanol, n-octanol, 2-ethylhexanol, sec-octanol, n-nonyl alcohol, 2,6-dimethyl-4-heptanol, n-decanol, sec-undecyl alcohol, trimethylnonyl alcohol, sec-tetradecyl alcohol, sec-heptadecyl alcohol, phenol, cyclohexanol, methylcyclohexanol, 3,3,5-trimethylcyclohexanol, benzyl alcohol, phenylmethylcarbinol, diacetone alcohol, and cresol; polyhydric alcohol-based solvents such as ethylene glycol, propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, and glycerin; ketone-based solvents such as acetone, methyl ethyl ketone, methyl-n-propyl ketone, methyl-n-butyl ketone, diethyl ketone, methyl-i-butyl ketone, methyl-n-pentyl ketone, ethyl-n-butyl ketone, methyl-n-hexyl ketone, di-i-butyl ketone, trimethylnonanone, cyclohexanone, methylcyclohexanone, 2,4-pentanedione, acetonylacetone, diacetone alcohol, acetophenone, and fenchon; ether-based solvents such as ethyl ether, i-propyl ether, n-butyl ether, n-hexyl ether, 2-ethylhexyl ether, ethylene oxide, 1,2-propylene oxide, dioxolane, 4-methyldioxolane, dioxane, dimethyldioxane, ethylene glycol monomethyl ether, ethylene glycol monoethyl ether, ethylene glycol diethyl ether, ethylene glycol mono-n-butyl ether, ethylene glycol mono-n-hexyl ether, ethylene glycol monophenyl ether, ethylene glycol mono-2-ethyl butyl ether, ethylene glycol dibutyl ether, diethylene glycol monomethyl ether, diethylene glycol monoethyl ether, diethylene glycol diethyl ether, diethylene glycol mono-n-butyl ether, diethylene glycol din-butyl ether, diethylene glycol mono-n-hexyl ether, ethoxy triglycol, tetraethylene glycol di-n-butyl ether, propylene glycol monomethyl ether (1-methoxy-2-propanol), propylene glycol monoethyl ether (1-ethoxy-2-propanol), propylene glycol monopropyl ether, propylene glycol monobutyl ether, propylene glycol monomethyl ether acetate (1-methoxy-2-propanol monoacetate), dipropylene glycol monomethyl ether, dipropylene glycol monoethyl ether, dipropylene glycol monopropyl ether, dipropylene glycol monobutyl ether, tripropylene glycol monomethyl ether, tetrahydrofuran, and 2-methyltetrahydrofuran; ester-based solvents such as diethyl carbonate, methyl acetate, ethyl acetate, γ-butyrolactone, γ-valerolactone, n-propyl acetate, i-propyl acetate, n-butyl acetate, i-butyl acetate, sec-butyl acetate, n-pentyl acetate, sec-pentyl acetate, 3-methoxybutyl acetate, methylpentyl acetate, 2-ethylbutyl acetate, 2-ethylhexyl acetate, benzyl acetate, cyclohexyl acetate, methylcyclohexyl acetate, n-nonyl acetate, methyl acetoacetate, ethyl acetoacetate, ethylene glycol monomethyl ether acetate, ethylene glycol monoethyl ether acetate, diethylene glycol monomethyl ether acetate, diethylene glycol monoethyl ether acetate, diethylene glycol mono-n-butyl ether acetate, propylene glycol monomethyl ether acetate, propylene glycol monoethyl ether acetate, propylene glycol monopropyl ether acetate, propylene glycol monobutyl ether acetate, dipropylene glycol monomethyl ether acetate, dipropylene glycol monoethyl ether acetate, glycol diacetate, methoxytriglycol acetate, ethylene glycol diacetate, triethylene glycol methyl ether acetate, ethyl propionate, n-butyl propionate, i-amyl propionate, diethyl oxalate, di-n-butyl oxalate, methyl lactate, ethyl lactate, n-butyl lactate, n-amyl lactate, diethyl malonate, dimethyl phthalate, and diethyl phthalate; nitrogen-containing solvents such as N-methylformamide, N,N-dimethylformamide, N,N-diethylformamide, acetamide, N-methylacetamide, N,N-dimethylacetamide, N-methylpropionamide, and N-methyl-2-pyrrolidone; and sulfur-containing solvents such as dimethyl sulfide, diethyl sulfide, thiophene, tetrahydrothiophene, dimethyl sulfoxide, sulfolane, and 1,3-propane sultone. These solvents can be used singly or in combination of two or more kinds thereof.

After completion of the hydrolysis and condensation reaction, the reaction solution is used as it is, or diluted or concentrated, and the resultant reaction solution is neutralized, and treated using an ion exchange resin, whereby the hydrolysis catalyst such as an acid or a base used for hydrolysis and condensation can be removed. In addition, before or after such treatment, alcohol and water as by-products, the hydrolysis catalyst used, and the like can be removed from the reaction solution by distillation under reduced pressure or the like.

The thus-obtained hydrolytic condensate or a modified product thereof (hereinafter, also referred to as a polysiloxane) is obtained in the form of a polysiloxane varnish dissolved in an organic solvent, and can be used as it is for preparing a silicon-containing resist underlayer film-forming composition. That is, the reaction solution may be used as is (or diluted) for preparation of the silicon-containing resist underlayer film-forming composition, and in this case, the hydrolysis catalyst used for the hydrolysis and condensation, by-products, and the like may remain in the reaction solution, so long as the effects of the present invention is not impaired. For example, the nitric acid used as a hydrolysis catalyst or used for capping of silanol groups with an alcohol may remain in a polymer varnish solution in an amount of about 100 ppm to 5,000 ppm.

The resultant polysiloxane varnish may be subjected to solvent replacement, or may be appropriately diluted with a solvent. In a case where the storage stability of the resultant polysiloxane varnish is not poor, the organic solvent may be distilled off to achieve a film-forming component concentration of 100%. The film-forming component refers to a component resulted from the removal of a solvent component from all the components of the composition.

The organic solvent used for solvent replacement, dilution, or the like of the polysiloxane varnish may be identical to or different from the organic solvent used for the hydrolysis and condensation reactions of the hydrolyzable silane. The solvent for dilution is not particularly limited, and one or two or more kinds of solvents may be optionally selected and used.

### <Component [C]: Solvent>

In the first embodiment, for the solvent as the component [C], any solvent can be used without particular limitation as long as it is a solvent capable of dissolving and mixing the component [A] and, as necessary, other components contained in the silicon-containing resist underlayer film-forming composition.

In the second embodiment, the solvent as the component [C] can be used without particular limitation as long as it is a solvent capable of dissolving and mixing the component [A'] and the component [B] and, as necessary, other components contained in the silicon-containing resist underlayer film-forming composition.

The solvent [C] is preferably an alcohol-based solvent, more preferably an alkylene glycol monoalkyl ether, which is an alcohol-based solvent, and still more preferably a propylene glycol monoalkyl ether. Since these solvents are also capping agents for silanol groups of the hydrolytic condensate, it is possible to prepare a silicon-containing resist underlayer film-forming composition from a solution obtained by preparing the polysiloxane [A] or the polysiloxane [A'] without requiring solvent replacement or the like.

Examples of the alkylene glycol monoalkyl ether include ethylene glycol monomethyl ether, ethylene glycol monoethyl ether, ethylene glycol monopropyl ether, ethylene glycol monobutyl ether, propylene glycol monomethyl ether (1-methoxy-2-propanol), propylene glycol monoethyl ether (1-ethoxy-2-propanol), methyl isobutyl carbinol, and propylene glycol monobutyl ether.

Specific examples of the other solvent [C] include methyl cellosolve acetate, ethyl cellosolve acetate, propylene glycol monomethyl ether acetate (1-methoxy-2-propanol monoacetate), propylene glycol monoethyl ether acetate, propylene glycol monopropyl ether acetate, propylene glycol monobutyl ether acetate, toluene, xylene, methyl ethyl ketone, cyclopentanone, cyclohexanone, ethyl 2-hydroxypropionate, ethyl 2-hydroxy-2-methylpropionate, ethyl ethoxyacetate, ethyl hydroxyacetate, methyl 2-hydroxy-3-methylbutanoate, methyl 3-methoxypropionate, ethyl 3-methoxypropionate, ethyl 3-ethoxypropionate, methyl 3-ethoxypropionate, methyl pyruvate, ethyl pyruvate, ethylene glycol monomethyl ether acetate, ethylene glycol monoethyl ether acetate, ethylene glycol monopropyl ether acetate, ethylene glycol monobutyl ether acetate, diethylene glycol dimethyl ether, diethylene glycol diethyl ether, diethylene glycol dipropyl ether, diethylene glycol dibutyl ether, propylene glycol monomethyl ether, propylene glycol dimethyl ether, propylene glycol diethyl ether, propylene glycol dipropyl ether, propylene glycol dibutyl ether, ethyl lactate, propyl lactate, isopropyl lactate, butyl lactate, isobutyl lactate, methyl formate, ethyl formate, propyl formate, isopropyl formate, butyl formate, isobutyl formate, amyl formate, isoamyl formate, methyl acetate, ethyl acetate, amyl acetate, isoamyl acetate, hexyl acetate, methyl propionate, ethyl propionate, propyl propionate, isopropyl propionate, butyl propionate, isobutyl propionate, methyl butyrate, ethyl butyrate, propyl butyrate, isopropyl butyrate, butyl butyrate, isobutyl butyrate, ethyl hydroxyacetate, ethyl 2-hydroxy-2-methylpropionate, methyl 3-methoxy-2-methylpropionate, methyl 2-hydroxy-3-methybutyrate, ethyl methoxyacetate, ethyl ethoxyacetate, methyl 3-methoxypropionate, ethyl 3-ethoxypropionate, ethyl 3-methoxypropionate, 3-methoxybutyl acetate, 3-methoxypropyl acetate, 3-methyl-3-methoxybutyl acetate, 3-methyl-3-methoxybutyl propionate, 3-methyl-3-methoxybutyl butyrate, methyl acetoacetate, toluene, xylene, methyl ethyl ketone, methyl propyl ketone, methyl butyl ketone, 2-heptanone, 3-heptanone, 4-heptanone, cyclohexanone, N,N-dimethylformamide, N-methylacetamide, N,N-dimethylacetamide, N-methyl-2-pyrrolidone, 4-methyl-2-pentanol, and γ-butyrolactone, and these solvents can be used singly or in combination of two or more kinds thereof.

The silicon-containing resist underlayer film-forming composition of the present invention may contain water as a solvent. When water is contained as the solvent, the content thereof may be, for example, 30 mass% or less, preferably 20 mass% or less, and still more preferably 15 mass% or less relative to the total mass of the solvent contained in the composition.

### <Component [D]: Curing Catalyst>

The silicon-containing resist underlayer film-forming composition can be a composition containing no curing catalyst, but preferably contains a curing catalyst (component [D]).

The curing catalyst may be, for example, an ammonium salt, phosphines, a phosphonium salt, or a sulfonium salt. The salt described below as an example of a curing catalyst may be added in the form of a salt, or may be a compound that forms a salt in the composition (that is, a compound that forms a salt in the system, but is in a form different from the salt during addition).

Examples of the ammonium salt include:
a quaternary ammonium salt having a structure represented by Formula (D-1), 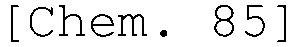 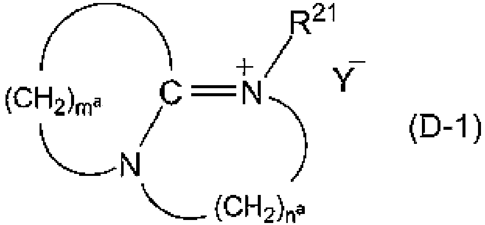
where m^{a} represents an integer of 2 to 11, n^{a} represents an integer of 2 to 3, R²¹ represents an alkyl group, an aryl group, or an aralkyl group, and Y⁻ represents an anion;
a quaternary ammonium salt having a structure represented by Formula (D-2),
   [Chem. 86]

   R²²R²³R²⁴R²⁵N⁺Y⁻ (D-2)
where R²², R²³, R²⁴, and R²⁵ each independently represent an alkyl group, an aryl group, or an aralkyl group, Y-represents an anion, and R²², R²³, R²⁴, and R²⁵ are each bonded to a nitrogen atom;
a quaternary ammonium salt having a structure represented by Formula (D-3), 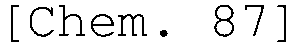 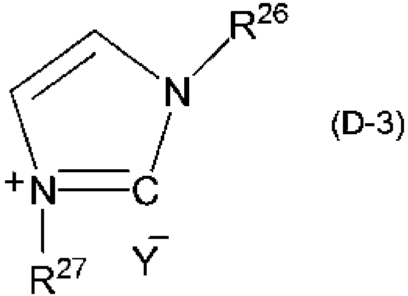
where R²⁶ and R²⁷ each independently represent an alkyl group, an aryl group, or an aralkyl group, and Y⁻ represents an anion;
a quaternary ammonium salt having a structure represented by Formula (D-4), 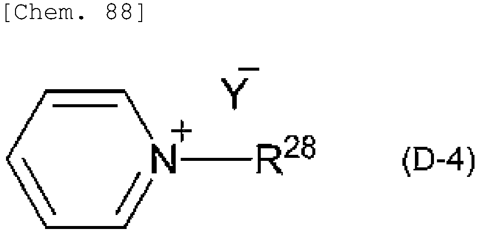
where R²⁸ represents an alkyl group, an aryl group, or an aralkyl group, and Y⁻ represents an anion;
a quaternary ammonium salt having a structure represented by Formula (D-5): 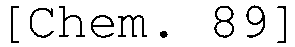 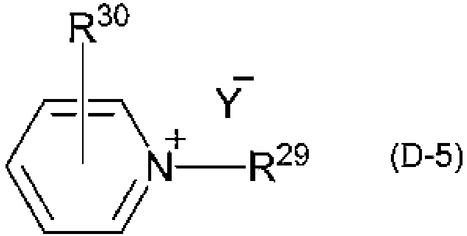
where R²⁹ and R³⁰ each independently represent an alkyl group, an aryl group, or an aralkyl group, and Y⁻ represents an anion; and
a tertiary ammonium salt having a structure represented by Formula (D-6): 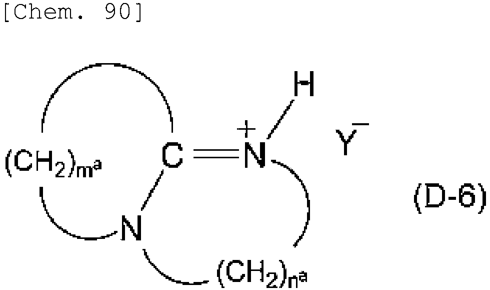
where m^{a} represents an integer of 2 to 11, n^{a} represents an integer of 2 to 3, and Y⁻ represents an anion.
Examples of the phosphonium salt include a quaternary phosphonium salt represented by Formula (D-7),
   [Chem. 91]

   R³¹R³²R³³R³⁴P⁺Y⁻ (D-7)
where R³¹, R³², R³³, and R³⁴ each independently represent an alkyl group, an aryl group, or an aralkyl group, Y⁻ represents an anion, and R³¹, R³², R³³, and R³⁴ are each bonded to a phosphorus atom.
Examples of the sulfonium salt include a tertiary sulfonium salt represented by Formula (D-8),
   [Chem. 92]

   R³⁵R³⁶R³⁷S⁺Y⁻ (D-8)
where R³⁵, R³⁶, and R³⁷ each independently represent an alkyl group, an aryl group, or an aralkyl group, Y⁻ represents an anion, and R³⁵, R³⁶, and R³⁷ are each bonded to a sulfur atom.

The compound of Formula (D-1) is a quaternary ammonium salt derived from an amine, where m^{a} represents an integer of 2 to 11, and n^{a} represents an integer of 2 to 3. R²¹ of the quaternary ammonium salt represents, for example, an alkyl group having 1 to 18 carbon atoms, preferably 2 to 10 carbon atoms, an aryl group having 6 to 18 carbon atoms, or an aralkyl group having 7 to 18 carbon atoms, and examples thereof include linear alkyl groups such as an ethyl group, a propyl group, and a butyl group; a benzyl group, a cyclohexyl group, a cyclohexylmethyl group, and a dicyclopentadienyl group. In addition, examples of the anion (Y⁻) include halide ions such as a chlorine ion (Cl⁻), a bromine ion (Br⁻), and an iodine ion (I⁻), and acid groups such as carboxylate (-COO⁻), sulfonate (-SO₃⁻), and alcoholate (-O⁻).

The compound of Formula (D-2) is a quaternary ammonium salt represented by R²²R²³R²⁴R²⁵N⁺Y⁻. R²², R²³, R²⁴, and R²⁵ of the quaternary ammonium salt are each, for example, an alkyl group having 1 to 18 carbon atoms, such as ethyl group, propyl group, butyl group, cyclohexyl group, and cyclohexylmethyl group, an aryl group having 6 to 18 carbon atoms, such as phenyl group, or an aralkyl group having 7 to 18 carbon atoms, such as benzyl group. Examples of the anion (Y⁻) include halide ions such as a chlorine ion (Cl⁻), a bromine ion (Br⁻), and an iodine ion (I⁻), and acid groups such as carboxylate (-COO⁻), sulfonate (-SO₃⁻), and alcoholate (-O⁻). The quaternary ammonium salt is commercially available, and examples of the quaternary ammonium salt include tetramethylammonium acetate, tetrabutylammonium acetate, triethylbenzylammonium chloride, triethylbenzylammonium bromide, trioctylmethylammonium chloride, tributylbenzylammonium chloride, and trimethylbenzylammonium chloride.

The compound of Formula (D-3) is a quaternary ammonium salt derived from 1-substituted imidazole, the number of carbon atoms of each of R²⁶ and R²⁷ is, for example, 1 to 18, and the total number of carbon atoms of R²⁶ and R²⁷ is preferably 7 or more. Examples of R²⁶ include an alkyl group such as a methyl group, an ethyl group, and a propyl group, an aryl group such as a phenyl group, and an aralkyl group such as a benzyl group, and examples of R²⁷ include an aralkyl group such as a benzyl group, and an alkyl group such as an octyl group and an octadecyl group. Examples of the anion (Y⁻) include halide ions such as a chlorine ion (Cl⁻), a bromine ion (Br⁻), and an iodine ion (I⁻), and acid groups such as carboxylate (-COO⁻), sulfonate (-SO₃⁻), and alcoholate (-O⁻). This compound can also be obtained as a commercially available product, but can be produced by allowing an imidazole-based compound such as 1-methylimidazole or 1-benzylimidazole to react with an aralkyl halide, an alkyl halide, or an aryl halide such as benzyl bromide, methyl bromide, or benzene bromide.

The compound of Formula (D-4) is a quaternary ammonium salt derived from pyridine, and R²⁸ is, for example, an alkyl group having 1 to 18 carbon atoms, preferably 4 to 18 carbon atoms, an aryl group having 6 to 18 carbon atoms, or an aralkyl group having 7 to 18 carbon atoms, and examples thereof include a butyl group, an octyl group, a benzyl group, and a lauryl group. Examples of the anion (Y⁻) include halide ions such as a chlorine ion (Cl⁻), a bromine ion (Br⁻), and an iodine ion (I⁻), and acid groups such as carboxylate (-COO⁻), sulfonate (-SO₃⁻), and alcoholate (-O⁻). Although this compound is commercially available, the compound may be produced through, for example, reaction between pyridine and an alkyl halide or an aryl halide, such as lauryl chloride, benzyl chloride, benzyl bromide, methyl bromide, or octyl bromide. Examples of the compound include N-laurylpyridinium chloride and N-benzylpyridinium bromide.

The compound of formula (D-5) is a quaternary ammonium salt derived from a substituted pyridine represented by picoline or the like, and R²⁹ is, for example, an alkyl group having 1 to 18 carbon atoms, preferably 4 to 18 carbon atoms, an aryl group having 6 to 18 carbon atoms, or an aralkyl group having 7 to 18 carbon atoms, and examples thereof include a methyl group, an octyl group, a lauryl group, and a benzyl group. R³⁰ is, for example, an alkyl group having 1 to 18 carbon atoms, an aryl group having 6 to 18 carbon atoms, or an aralkyl group having 7 to 18 carbon atoms. For example, R³⁰ is a methyl group when the compound represented by Formula (D-5) is a quaternary ammonium derived from picoline. Examples of the anion (Y⁻) include halide ions such as a chlorine ion (Cl⁻), a bromine ion (Br⁻), and an iodine ion (I⁻), and acid groups such as carboxylate (-COO⁻), sulfonate (-SO₃⁻), and alcoholate (-O⁻). Although this compound is commercially available, the compound may be produced through, for example, reaction between a substituted pyridine such as picoline and an alkyl halide or an aryl halide, such as methyl bromide, octyl bromide, lauryl chloride, benzyl chloride, or benzyl bromide. Examples of this compound include N-benzylpicolinium chloride, N-benzylpicolinium bromide, and N-laurylpicolinium chloride.

The compound of Formula (D-6) is a tertiary ammonium salt derived from an amine, where m^{a} represents an integer of 2 to 11, and n^{a} represents 2 or 3. In addition, examples of the anion (Y⁻) include halide ions such as a chlorine ion (Cl⁻), a bromine ion (Br⁻), and an iodine ion (I⁻), and acid groups such as carboxylate (-COO⁻), sulfonate (-SO₃⁻), and alcoholate (-O⁻). The compound may be produced through reaction between an amine and a weak acid, such as a carboxylic acid or phenol. Examples of the carboxylic acid include formic acid and acetic acid. When formic acid is used, the anion (Y⁻) is (HCOO⁻). When acetic acid is used, the anion (Y⁻) is (CH₃COO⁻). When phenol is used, the anion (Y⁻) is (C₆H₅O⁻).

The compound of Formula (D-7) is a quaternary phosphonium salt having a structure of R³¹R³²R³³R³⁴P⁺Y⁻. R³¹, R³², R³³, and R³⁴ are each, for example, an alkyl group having 1 to 18 carbon atoms, such as ethyl group, propyl group, butyl group, or cyclohexylmethyl, an aryl group having 6 to 18 carbon atoms, such as phenyl group, or an aralkyl group having 7 to 18 carbon atoms, such as benzyl group. Three of four substituents of R³¹ to R³⁴ are each preferably an unsubstituted phenyl group or a substituted phenyl group. Examples thereof include a phenyl group or a tolyl group. The remaining one substituent is an alkyl group having 1 to 18 carbon atoms, an aryl group having 6 to 18 carbon atoms, or an aralkyl group having 7 to 18 carbon atoms. In addition, examples of the anion (Y⁻) include halide ions such as a chlorine ion (Cl⁻), a bromine ion (Br⁻), and an iodine ion (I⁻), and acid groups such as carboxylate (-COO⁻), sulfonate (-SO₃⁻), and alcoholate (-O⁻). This compound is commercially available, and examples of the compound include tetraalkylphosphonium halides, such as tetra-n-butylphosphonium halide and tetra-n-propylphosphonium halide; trialkylbenzylphosphonium halides, such as triethylbenzylphosphonium halide; triphenylmonoalkylphosphonium halides, such as triphenylmethylphosphonium halide and triphenylethylphosphonium halide; triphenylbenzylphosphonium halide; tetraphenylphosphonium halide; tritolylmonoarylphosphonium halide; or tritolylmonoalkylphosphonium halide (where the halogen atom is a chlorine atom or a bromine atom). Particularly preferred are triphenylmonoalkylphosphonium halides, such as triphenylmethylphosphonium halide and triphenylethylphosphonium halide; triphenylmonoarylphosphonium halides, such as triphenylbenzylphosphonium halide; tritolylmonoarylphosphonium halides, such as tritolylmonophenylphosphonium halide; and tritolylmonoalkylphosphonium halides, such as tritolylmonomethylphosphonium halide (where the halogen atom is a chlorine atom or a bromine atom).

Examples of the phosphine compound include primary phosphines, such as methylphosphine, ethylphosphine, propylphosphine, isopropylphosphine, isobutylphosphine, and phenylphosphine; secondary phosphines, such as dimethylphosphine, diethylphosphine, diisopropylphosphine, diisoamylphosphine, and diphenylphosphine; and tertiary phosphines, such as trimethylphosphine, triethylphosphine, triphenylphosphine, methyldiphenylphosphine, and dimethylphenylphosphine.

The compound of Formula (D-8) is a tertiary sulfonium salt having a structure of R³⁵R³⁶R³⁷S⁺Y⁻. R³⁵, R³⁶, and R³⁷ are each, for example, an alkyl group having 1 to 18 carbon atoms, such as an ethyl group, a propyl group, a butyl group, or a cyclohexylmethyl, an aryl group having 6 to 18 carbon atoms, such as a phenyl group, or an aralkyl group having 7 to 18 carbon atoms, such as a benzyl group. Two of three substituents of R³⁵ to R³⁷ are each preferably an unsubstituted phenyl group or a substituted phenyl group, and examples thereof include a phenyl group or a tolyl group. The remaining one substituent is an alkyl group having 1 to 18 carbon atoms, an aryl group having 6 to 18 carbon atoms, or an aralkyl group having 7 to 18 carbon atoms. Examples of the anion (Y⁻) include halide ions, such as chlorine ion (Cl⁻), bromine ion (Br⁻), and iodine ion (I⁻); and acid groups, such as carboxylate (-COO⁻), sulfonate (-SO₃⁻), alcoholate (-O⁻), maleate anion, and nitrate anion. This compound is commercially available, and examples of the compound include trialkylsulfonium halides, such as tri-n-butylsulfonium halide and tri-n-propylsulfonium halide; dialkylbenzylsulfonium halides, such as diethylbenzylsulfonium halide; diphenylmonoalkylsulfonium halides, such as diphenylmethylsulfonium halide and diphenylethylsulfonium halide; triphenylsulfonium halides, where the halogen atom is a chlorine atom or a bromine atom; trialkylsulfonium carboxylates, such as tri-n-butylsulfonium carboxylate and tri-n-propylsulfonium carboxylate; dialkylbenzylsulfonium carboxylates, such as diethylbenzylsulfonium carboxylate; diphenylmonoalkylsulfonium carboxylates, such as diphenylmethylsulfonium carboxylate and diphenylethylsulfonium carboxylate; and triphenylsulfonium carboxylate. Triphenylsulfonium halide and triphenylsulfonium carboxylate are preferably used.

In addition, a nitrogen-containing silane compound may be added as a curing catalyst. Examples of the nitrogen-containing silane compound include silane compounds containing an imidazole ring, such as N-(3-triethoxysilylpropyl)-4,5-dihydroimidazole.

The content of the curing catalyst [D] in the silicon-containing resist underlayer film-forming composition as the first embodiment is preferably 0.1 to 30 parts by mass, more preferably 0.5 to 25 parts by mass, and still more preferably 1 to 20 parts by mass with respect to 100 parts by mass of the polysiloxane [A] from the viewpoint of more sufficiently achieving the effects of the present invention.

The content of the curing catalyst [D] in the silicon-containing resist underlayer film-forming composition as the second embodiment is preferably 0.1 to 30 parts by mass, more preferably 0.5 to 25 parts by mass, and still more preferably 1 to 20 parts by mass with respect to 100 parts by mass of polysiloxane [A'] from the viewpoint of more sufficiently achieving the effects of the present invention.

### <Component [E]: Nitric Acid>

The silicon-containing resist underlayer film-forming composition preferably contains a nitric acid [E].

The nitric acid [E] may be added during the preparation of the silicon-containing resist underlayer film-forming composition. Alternatively, the nitric acid may be used as a hydrolysis catalyst or used for capping of silanol groups with an alcohol in the production of the aforementioned polysiloxane, and one remaining in the polysiloxane varnish can also be used as the nitric acid [E].

The amount of the nitric acid [E] (amount of residual nitric acid) added may be, for example, 0.0001 mass% to 1 mass%, 0.001 mass% to 0.1 mass%, or 0.005 mass% to 0.05 mass% relative to the total mass of the silicon-containing resist underlayer film-forming composition.

### <Additional Additives>

The silicon-containing resist underlayer film-forming composition may contain various additives depending on the intended use.

Examples of the additives include known additives incorporated in materials (compositions) for forming various films (for example, resist underlayer film, anti-reflective coating, and pattern reversing film) that can be used in the production of a semiconductor device, such as a crosslinking agent, a crosslinking catalyst, a stabilizer (for example, an organic acid, water, or an alcohol), an organic polymer, an acid generator, a surfactant (for example, a nonionic surfactant, an anionic surfactant, a cationic surfactant, a silicon-based surfactant, a fluorine-based surfactant, or an UV-curable surfactant), a pH adjuster, a metal oxide, a rheology modifier, and an adhesion aid.

Hereinafter, various additives will be exemplified, but the additives are not limited thereto.

### <<Stabilizer>>

A stabilizer may be added for the purpose of stabilizing the hydrolytic condensate of the hydrolyzable silane, and as a specific example thereof, an organic acid, water, alcohol, or a combination thereof may be added.

Examples of the organic acid include an oxalic acid, a malonic acid, a methylmalonic acid, a succinic acid, a maleic acid, a malic acid, a tartaric acid, a phthalic acid, a citric acid, a glutaric acid, a lactic acid, and a salicylic acid. Among them, an oxalic acid and a maleic acid are preferable. When the organic acid is added, the amount of the organic acid added is 0.1 to 5.0 mass% relative to the mass of the hydrolytic condensate of the hydrolyzable silane. These organic acids may also serve as pH adjusters.

As the water, pure water, ultrapure water, ion exchanged water, or the like may be used. When pure water, ultrapure water, or ion exchanged water is used, the amount of the water added can be 1 to 20 parts by mass relative to 100 parts by mass of the silicon-containing resist underlayer film-forming composition.

The alcohol is preferably an alcohol that is easily scattered by heating after the application, and examples of the alcohol include methanol, ethanol, propanol, i-propanol, and butanol. When an alcohol is added, the amount of the alcohol added may be 1 to 20 parts by mass relative to 100 parts by mass of the silicon-containing resist underlayer film-forming composition.

### <<Organic Polymer>>

Addition of an organic polymer to the silicon-containing resist underlayer film-forming composition enables adjustment of the dry etching rate (the amount of reduction in film thickness per unit time), attenuation coefficient, refractive index, and the like of a film (resist underlayer film) containing the composition. The organic polymer is not particularly limited, and is appropriately selected from various organic polymers (polycondensation polymer and addition polymerization polymer) depending on the purpose of addition thereof.

Specific examples thereof include addition polymerization polymers and polycondensation polymers such as polyester, polystyrene, polyimide, an acrylic polymer, a methacrylic polymer, polyvinyl ether, phenol novolac, naphthol novolac, polyether, polyamide, and polycarbonate.

In the present invention, an organic polymer containing an aromatic ring or a heteroaromatic ring such as a benzene ring, a naphthalene ring, an anthracene ring, a triazine ring, a quinoline ring, or a quinoxaline ring, which functions as a light absorption site, can also be suitably used when such a function is required. Specific examples of such an organic polymer include, but are not limited to, addition polymerization polymers containing, as structural units, addition polymerizable monomers, such as benzyl acrylate, benzyl methacrylate, phenyl acrylate, naphthyl acrylate, anthryl methacrylate, anthryl methyl methacrylate, styrene, hydroxystyrene, benzyl vinyl ether, and N-phenylmaleimide, and condensation polycondensation polymers, such as phenol novolac and naphthol novolac.

When an addition polymerization polymer is used as an organic polymer, the polymer may be either a homopolymer or a copolymer.

An addition polymerizable monomer is used for the production of the addition polymerization polymer, and specific examples of such an addition polymerizable monomer include, but are not limited to, acrylic acid, methacrylic acid, an acrylate ester compound, a methacrylate ester compound, an acrylamide compound, a methacrylamide compound, a vinyl compound, a styrene compound, a maleimide compound, maleic anhydride, and acrylonitrile.

Specific examples of the acrylate ester compound include, but are not limited to, methyl acrylate, ethyl acrylate, normal hexyl acrylate, i-propyl acrylate, cyclohexyl acrylate, benzyl acrylate, phenyl acrylate, anthrylmethyl acrylate, 2-hydroxyethyl acrylate, 3-chloro-2-hydroxypropyl acrylate, 2-hydroxypropyl acrylate, 2,2,2-trifluoroethyl acrylate, 2,2,2-trichloroethyl acrylate, 2-bromoethyl acrylate, 4-hydroxybutyl acrylate, 2-methoxyethyl acrylate, tetrahydrofurfuryl acrylate, 2-methyl-2-adamantyl acrylate, 5-acryloyloxy-6-hydroxynorbornene-2-carboxylic-6-lactone, 3-acryloxypropyltriethoxysilane, and glycidyl acrylate.

Specific examples of the methacrylate ester compound include, but are not limited to, methyl methacrylate, ethyl methacrylate, normal hexyl methacrylate, i-propyl methacrylate, cyclohexyl methacrylate, benzyl methacrylate, phenyl methacrylate, anthrylmethyl methacrylate, 2-hydroxyethyl methacrylate, 2-hydroxypropyl methacrylate, 2,2,2-trifluoroethyl methacrylate, 2,2,2-trichloroethyl methacrylate, 2-bromoethyl methacrylate, 4-hydroxybutyl methacrylate, 2-methoxyethyl methacrylate, tetrahydrofurfuryl methacrylate, 2-methyl-2-adamantyl methacrylate, 5-methacryloyloxy-6-hydroxynorbornene-2-carboxylic-6-lactone, 3-methacryloxypropyltriethoxysilane, glycidyl methacrylate, 2-phenylethyl methacrylate, hydroxyphenyl methacrylate, and bromophenyl methacrylate.

Specific examples of the acrylamide compound include, but are not limited to, acrylamide, N-methylacrylamide, N-ethylacrylamide, N-benzylacrylamide, N-phenylacrylamide, N,N-dimethylacrylamide, and N-anthrylacrylamide.

Specific examples of the methacrylamide compound include, but are not limited to, methacrylamide, N-methylmethacrylamide, N-ethylmethacrylamide, N-benzylmethacrylamide, N-phenylmethacrylamide, N,N-dimethylmethacrylamide, and N-anthrylmethacrylamide.

Specific examples of the vinyl compound include, but are not limited to, vinyl alcohol, 2-hydroxyethyl vinyl ether, methyl vinyl ether, ethyl vinyl ether, benzyl vinyl ether, vinyl acetic acid, vinyltrimethoxysilane, 2-chloroethyl vinyl ether, 2-methoxyethyl vinyl ether, vinylnaphthalene, and vinylanthracene.

Specific examples of the styrene compound include, but are not limited to, styrene, hydroxystyrene, chlorostyrene, bromostyrene, methoxystyrene, cyanostyrene, and acetylstyrene.

Examples of the maleimide compound include, but are not limited to, maleimide, N-methylmaleimide, N-phenylmaleimide, N-cyclohexylmaleimide, N-benzylmaleimide, and N-hydroxyethylmaleimide.

When a polycondensation polymer is used as the polymer, the polymer is, for example, a polycondensation polymer composed of a glycol compound and a dicarboxylic acid compound. Examples of the glycol compound include diethylene glycol, hexamethylene glycol, and butylene glycol. Examples of the dicarboxylic acid compound include succinic acid, adipic acid, terephthalic acid, and maleic anhydride. In addition, examples thereof include, but are not limited to, polyesters, polyamides, and polyimides, such as polypyromellitimide, poly(p-phenyleneterephthalamide), polybutylene terephthalate, and polyethylene terephthalate.

When the organic polymer contains a hydroxy group, the hydroxy group can undergo a crosslinking reaction with a hydrolytic condensate or the like.

The organic polymer may usually have a weight-average molecular weight of 1,000 to 1,000,000. When an organic polymer is blended, the weight-average molecular weight thereof can be set to, for example, 3,000 to 300,000, or 5,000 to 300,000, or 10,000 to 200,000 from the viewpoint of sufficiently obtaining the effect of the function as a polymer and preventing precipitation in the composition.

Such an organic polymer may be used singly or in combination of two or more kinds thereof.

When the silicon-containing resist underlayer film-forming composition contains an organic polymer, the content cannot be univocally determined, since the content is appropriately determined in consideration of the function of the organic polymer, or the like, and the content may usually be 1 to 200 mass% relative to the mass of the polysiloxane [A] and the polysiloxane [A'], from the viewpoint of, for example, suppressing the precipitation in the composition, the content may be, for example, 100 mass% or less, and is preferably 50 mass% or less, more preferably 30 mass% or less, and from the viewpoint of, for example, sufficiently achieving the effect, the content may be, for example, 5 mass% or more, and preferably 10 mass% or more, more preferably 30 mass% or more.

### <<Acid Generator>>

Examples of the acid generator include a thermal acid generator and a photoacid generator, and a photoacid generator may be preferably used.

Examples of the photoacid generator include, but are not limited to, an onium salt compound, a sulfonimide compound, and a disulfonyldiazomethane compound. The photoacid generator may also function as a curing catalyst depending on the type thereof, for example, a nitrate salt, a carboxylate salt (for example, maleate), or a hydrochloride salt of an onium salt compound described later.

Examples of the thermal acid generator include, but are not limited to, tetramethylammonium nitrate.

Specific examples of the onium salt compound include, but are not limited to, iodonium salt compounds, such as diphenyliodonium hexafluorophosphate, diphenyliodonium trifluoromethanesulfonate, diphenyliodonium nonafluoro normal butanesulfonate, diphenyliodonium perfluoro normal octanesulfonate, diphenyliodonium camphorsulfonate, bis(4-t-butylphenyl)iodonium camphorsulfonate, and bis(4-t-butylphenyl)iodonium trifluoromethanesulfonate; and sulfonium salt compounds, such as triphenylsulfonium hexafluoroantimonate, triphenylsulfonium nonafluoro normal butanesulfonate, triphenylsulfonium camphorsulfonate, triphenylsulfonium trifluoromethanesulfonate, triphenylsulfonium nitrate, triphenylsulfonium trifluoroacetate, triphenylsulfonium maleate, and triphenylsulfonium chloride.

Specific examples of the sulfonimide compound include, but are not limited to, N-(trifluoromethanesulfonyloxy)succinimide, N-(nonafluoronormalbutanesulfonyloxy)succinimide, N-(camphorsulfonyloxy)succinimide, and N-(trifluoromethanesulfonyloxy)naphthalimide.

Specific examples of the disulfonyl diazomethane compound include, but are not limited to, bis(trifluoromethylsulfonyl)diazomethane, bis(cyclohexylsulfonyl)diazomethane, bis(phenylsulfonyl)diazomethane, bis(p-toluenesulfonyl)diazomethane, bis(2,4-dimethylbenzenesulfonyl)diazomethane, and methylsulfonyl-p-toluenesulfonyl diazomethane.

When the silicon-containing resist underlayer film-forming composition contains an acid generator, the content cannot be univocally determined, since the content is appropriately determined in consideration of, for example, the type of the acid generator, the content is usually 0.01 to 5 mass% relative to the mass of the polysiloxane [A] and the polysiloxane [A'], from the viewpoint of, for example, suppressing the precipitation of the acid generator in the composition, the content is preferably 3 mass% or less, more preferably 1 mass% or less, and from the viewpoint of, for example, sufficiently achieving the effect, the content is preferably 0.1 mass% or more, more preferably 0.5 mass% or more.

The acid generators may be used singly or in combination of two or more kinds thereof, and a photoacid generator and a thermal acid generator may be used in combination.

### <<Surfactant>>

When the silicon-containing resist underlayer film-forming composition is applied to a substrate, a surfactant is effective in prevention of formation of pinholes, striations, and the like. Examples of the surfactant include a nonionic surfactant, an anionic surfactant, a cationic surfactant, a silicon-based surfactant, a fluorine-based surfactant, and a UV-curable surfactant. Specific examples of the surfactant include, but are not limited to, nonionic surfactants, for example, polyoxyethylene alkyl ethers, such as polyoxyethylene lauryl ether, polyoxyethylene stearyl ether, polyoxyethylene cetyl ether, and polyoxyethylene oleyl ether, polyoxyethylene alkylaryl ethers, such as polyoxyethylene octylphenol ether and polyoxyethylene nonylphenol ether, polyoxyethylene-polyoxypropylene block copolymers, sorbitan fatty acid esters, such as sorbitan monolaurate, sorbitan monopalmitate, sorbitan monostearate, sorbitan monooleate, sorbitan trioleate, and sorbitan tristearate, polyoxyethylene sorbitan fatty acid esters, such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate; fluorine-based surfactants, such as trade names EFTOP (registered trademark) EF301, EF303, and EF352 (manufactured by Mitsubishi Materials Electronic Chemicals Co., Ltd. (former Tohkem Products Corporation)), trade names MEGAFACE (registered trademark) F171, F173, R-08, R-30, R-30N, and R-40LM (manufactured by DIC Corporation), Fluorad FC430 and FC431 (manufactured by 3M Japan Limited), trade name Asahi Guard (registered trademark) AG710 (manufactured by AGC Inc.), and trade names SURFLON (registered trademark) S-382, SC101, SC102, SC103, SC104, SC105, and SC106 (manufactured by AGC Seimi Chemical Co., Ltd.); and Organosiloxane Polymer KP341 (manufactured by Shin-Etsu Chemical Co., Ltd.).

The surfactant may be used singly or in combination of two or more kinds thereof.

When the silicon-containing resist underlayer film-forming composition contains a surfactant, the content is usually 0.0001 to 5 mass%, preferably 0.001 to 4 mass%, and more preferably 0.01 to 3 mass% with respect to the mass of the polysiloxane [A] or the polysiloxane [A'].

### <<Rheology Modifier>>

The rheology modifier is added mainly for the purpose of improving the fluidity of the silicon-containing resist underlayer film-forming composition, particularly in a baking process, improving the uniformity of the thickness of a film to be formed, or improving the fillability of the composition into holes. Specific examples of the rheology modifier include phthalic acid derivatives, such as dimethyl phthalate, diethyl phthalate, di-i-butyl phthalate, dihexyl phthalate, and butyl-i-decyl phthalate; adipic acid derivatives, such as di-normal butyl adipate, di-i-butyl adipate, di-i-octyl adipate, and octyl decyl adipate; maleic acid derivatives, such as di-normal butyl maleate, diethyl maleate, and dinonyl maleate; oleic acid derivatives, such as methyl oleate, butyl oleate, and tetrahydrofurfuryl oleate; and stearic acid derivatives, such as normal butyl stearate and glyceryl stearate.

When such a rheology modifier is used, the amount of the rheology modifier added is usually less than 30 mass% relative to all film-forming components of the silicon-containing resist underlayer film-forming composition.

### <<Adhesion Aid>>

An adhesion aid is added for the purpose of mainly improving the adhesion between a substrate or a resist and a film (resist underlayer film) containing the silicon-containing resist underlayer film-forming composition, and in particular, for the purpose of suppressing or preventing the peeling of the resist during development. Specific examples of the adhesion aid include chlorosilanes, such as trimethylchlorosilane, dimethylvinylchlorosilane, methyldiphenylchlorosilane, and chloromethyldimethylchlorosilane; alkoxysilanes, such as trimethylmethoxysilane, dimethyldiethoxysilane, methyldimethoxysilane, and dimethylvinylethoxysilane; silazanes, such as hexamethyldisilazane, N,N'-bis(trimethylsilyl)urea, dimethyltrimethylsilylamine, and trimethylsilyl imidazole; other silanes, such as γ-chloropropyltrimethoxysilane, γ-aminopropyltriethoxysilane, and γ-glycidoxypropyltrimethoxysilane; heterocyclic compounds, such as benzotriazole, benzimidazole, indazole, imidazole, 2-mercaptobenzimidazole, 2-mercaptobenzothiazole, 2-mercaptobenzoxazole, urazole, thiouracil, mercaptoimidazole, mercaptopyrimidine; and urea or thiourea compounds, such as 1,1-dimethylurea and 1,3-dimethylurea.

When such an adhesion aid is used, the amount of the adhesion aid added is usually less than 5 mass%, and preferably less than 2 mass%, relative to the film-forming components of the silicon-containing resist underlayer film-forming composition.

### <<pH Adjuster>>

In addition, examples of the pH adjuster can include other acids having one or two or more carboxylic acid groups such as the aforementioned organic acids as the stabilizer. When the pH adjuster is used, the amount of the pH adjuster added may be 0.01 to 20 parts by mass, 0.01 to 10 parts by mass, or 0.01 to 5 parts by mass relative to 100 parts by mass of the polysiloxane [A] or the polysiloxane [A'].

### <<Metal Oxide>>

Examples of the metal oxide that may be added to the silicon-containing resist underlayer film-forming composition include, but are not limited to, oxides of a combination of one or two or more among metals, such as tin (Sn), titanium (Ti), aluminum (Al), zirconium (Zr), zinc (Zn), niobium (Nb), tantalum (Ta), and W (tungsten), and semimetals, such as boron (B), silicon (Si), germanium (Ge), arsenic (As), antimony (Sb), and tellurium (Te).

The concentration of the film-forming component in the silicon-containing resist underlayer film-forming composition may be, for example, 0.1 to 50 mass%, 0.1 to 30 mass%, 0.1 to 25 mass%, or 0.5 to 20.0 mass% relative to the total mass of the composition.

The content of polysiloxane [A] or polysiloxane [A'] in the film-forming component is usually 20 mass% to 100 mass%, but from the viewpoint of obtaining the effect of the present invention with good reproducibility or the like, the lower limit thereof is preferably 50 mass%, more preferably 60 mass%, still more preferably 70 mass%, and yet still more preferably 80 mass%, the upper limit thereof is preferably 99 mass%, and the rest thereof can be an additive described below.

In addition, the silicon-containing resist underlayer film-forming composition preferably has a pH of 2 to 5, and more preferably a pH of 3 to 4.

The silicon-containing resist underlayer film-forming composition of the first embodiment can be produced by mixing the polysiloxane [A], the solvent [C], and an additional component when the additional component is contained as desired. In this case, a solution containing the polysiloxane [A] may be prepared in advance, and this solution may be mixed with the solvent [C] and an additional component.

The mixing order is not particularly limited. For example, the solvent [C] may be added to and mixed with the solution containing polysiloxane [A], and the other components may be added to the mixture, or the solution containing the polysiloxane [A], the solvent [C], and the additional component may be simultaneously mixed.

As necessary, the solvent [C] may be further added at the end, or some components relatively soluble in the solvent [C] may not be included in the mixture, and the components may be added at the end, but, from the viewpoint of suppressing aggregation and separation of the constituent components and preparing a composition excellent in uniformity with good reproducibility, it is preferable to prepare a solution in which the polysiloxane [A] is dissolved well in advance, and prepare a composition using the solution. Note that attention is paid to the fact that the polysiloxane [A] may aggregate or precipitate when mixed, depending on the type and amount of the solvent [C] to be mixed together, the amount and properties of the additional component, and the like. In addition, when a composition is prepared using the solution in which the polysiloxane [A] is dissolved, attention is also paid to the fact that it is necessary to determine the concentration of the solution of the polysiloxane [A] and the use amount thereof so that the polysiloxane [A] in the finally obtained composition is in a desired amount.

During the preparation of the composition, the composition may be appropriately heated so long as the components are not decomposed or denatured.

The silicon-containing resist underlayer film-forming composition according to the second embodiment can be produced by mixing the polysiloxane [A'], the hydrolyzable silane (A) [B], the solvent [C], and, as desired, an additional component. In this case, a solution containing the polysiloxane [A'] may be prepared in advance, and this solution may be mixed with the hydrolyzable silane (A) [B], the solvent [C], and an additional component.

The mixing order is not particularly limited. For example, the hydrolyzable silane (A) [B] and the solvent [C] may be added to and mixed with a solution containing the polysiloxane [A'], and the additional component may be added to the resultant mixture. Alternatively, a solution containing the polysiloxane [A'], the hydrolyzable silane (A) [B], the solvent [C], and an additional component may be mixed simultaneously.

As necessary, the solvent [C] may be finally added, or some components that can be relatively easily dissolved in the solvent [C] may be finally added without being incorporated into the mixture. However, from the viewpoint of preventing aggregation or separation of the components to prepare a highly homogeneous composition with high reproducibility, the composition is preferably produced from a previously prepared solution containing the well-dissolved polysiloxane [A']. Note that attention is paid to the fact that the polysiloxane [A'] may be aggregated or precipitated when mixed with the hydrolyzable silane (A) [B] and the solvent [C], or an additional component, depending on, for example, the type or amount of the solvent [C], or the amount or nature of the additional component. In addition, when a composition is prepared using the solution in which the polysiloxane [A'] is dissolved, attention is also paid to the fact that it is necessary to determine the concentration of the solution of the polysiloxane [A'] and the use amount thereof so that the polysiloxane [A'] in the finally obtained composition is in a desired amount.

During the preparation of the composition, the composition may be appropriately heated so long as the components are not decomposed or denatured.

In the present invention, the silicon-containing resist underlayer film-forming composition may be filtered with a submicrometer-order filter or the like during the production of the composition or after mixing of all the components. The type of the material of the filter used is not limited, and for example, a nylon-made filter or a fluororesin-made filter may be used.

The silicon-containing resist underlayer film-forming composition of the present invention may be suitably used as a resist underlayer film-forming composition used in a lithography process.

### (Resist Underlayer Film, Semiconductor Processing Substrate, Pattern Forming Method, and Method for Producing Semiconductor Device)

Hereinafter, as one aspect of the present invention, a resist underlayer film, a semiconductor processing substrate, a pattern forming method, and a method for producing a semiconductor device using the silicon-containing resist underlayer film-forming composition of the present invention will be described.

The resist underlayer film of the present invention is a cured product of the silicon-containing resist underlayer film-forming composition of the present invention.

The semiconductor processing substrate of the present invention is provided with the resist underlayer film of the present invention.

The method for producing a semiconductor element according to the present invention includes:
a step of forming an organic underlayer film on a substrate;
a step of forming a resist underlayer film on the organic underlayer film using the silicon-containing resist underlayer film-forming composition of the present invention; and
a step of forming a resist film on the resist underlayer film.

The pattern forming method of the present invention includes:
a step of forming an organic underlayer film on a semiconductor substrate;
a step of applying the silicon-containing resist underlayer film-forming composition of the present invention on the organic underlayer film and baking the silicon-containing resist underlayer film-forming composition to form a resist underlayer film;
a step of forming a resist film on the resist underlayer film;
a step of exposing and developing the resist film to obtain a resist pattern;
a step of etching the resist underlayer film using the resist pattern as a mask; and
a step of etching the organic underlayer film using the patterned resist underlayer film as a mask.

First, the silicon-containing resist underlayer film-forming composition of the present invention is applied onto a substrate used for producing a precision integrated circuit element [for example, a semiconductor substrate such as a silicon wafer coated with a silicon oxide film, a silicon nitride film, or a silicon oxynitride film, a silicon nitride substrate, a quartz substrate, a glass substrate (including alkali-free glass, low-alkali glass, and crystallized glass), a glass substrate on which an indium tin oxide (ITO) film or an indium zinc oxide (IZO) film is formed, a plastic (polyimide, PET, or the like) substrate, a low dielectric constant material (low-k material)-coated substrate, a flexible substrate, or the like] by an appropriate application method such as a spinner or a coater, and then baked using a heating means such as a hot plate to form a cured product of the composition, thereby forming a resist underlayer film. Hereinafter, the resist underlayer film in the present specification refers to a film formed from the silicon-containing resist underlayer film-forming composition of the present invention.

The baking conditions are appropriately selected from a baking temperature of 40°C to 400°C, or 80°C to 250°C, and a baking time of 0.3 minutes to 60 minutes. Preferably, the baking temperature is 150°C to 250°C, and the baking time is 0.5 minutes to 2 minutes.

The resist underlayer film formed here has a film thickness of, for example, 10 nm to 1,000 nm, or 20 nm to 500 nm, or 50 nm to 300 nm, or 100 nm to 200 nm, or 10 to 150 nm.

As the silicon-containing resist underlayer film-forming composition used for formation of the resist underlayer film, a silicon-containing resist underlayer film-forming composition filtered through a nylon filter may be used. Here, the silicon-containing resist underlayer film-forming composition filtered through a nylon filter refers to a composition that has been subjected to filtration with a nylon filter during production of the silicon-containing resist underlayer film-forming composition or after mixing all the components.

The present invention includes the aspect in which an organic underlayer film is formed on a substrate, followed by the formation of a resist underlayer film thereon, but may include an aspect in which an organic underlayer film is not provided in some cases.

The organic underlayer film used here is not particularly limited, and may be optionally selected from organic underlayer films commonly used in the lithography process.

By adopting an aspect in which an organic underlayer film on a substrate, a resist underlayer film on the organic underlayer film, and a resist film described later provided on the resist underlayer film, the pattern width of a photoresist film is narrowed, and even when the photoresist film is thinly applied in order to prevent pattern collapse, the substrate can be processed by selecting an appropriate etching gas described later. For example, the resist underlayer film can be processed using a fluorine-based gas having a sufficiently high etching rate with respect to the photoresist film as an etching gas, the organic underlayer film can be processed using an oxygen-based gas having a sufficiently high etching rate with respect to the resist underlayer film as an etching gas, and the substrate can be processed using a fluorine-based gas having a sufficiently high etching rate with respect to the organic underlayer film as an etching gas.

The substrate and application method usable in this process are the same as those described above.

Next, for example, a layer (resist film) of a photoresist material is formed on the resist underlayer film. The resist film can be formed by a known method, that is, by applying a coating type resist material (resist film-forming composition) on the resist underlayer film and baking the resist material.

The resist film has a film thickness of, for example, 10 nm to 10,000 nm, or 100 nm to 2,000 nm, or 200 nm to 1,000 nm, or 30 nm to 200 nm.

The photoresist material used for the resist film formed on the resist underlayer film is not particularly limited as long as it is sensitive to light (for example, KrF excimer laser, ArF excimer laser, or the like) used for exposure, and both a negative photoresist material and a positive photoresist material can be used. Examples thereof include a positive photoresist material formed of a novolac resin and a 1,2-naphthoquinone diazide sulfonic acid ester; a chemically amplified photoresist material formed of a binder having a group that is decomposed by an acid to increase the alkaline dissolution rate and a photoacid generator; a chemically amplified photoresist material formed of a low molecular weight compound that is decomposed by an acid to increase the alkaline dissolution rate of the photoresist material, an alkali-soluble binder, and a photoacid generator; and a chemically amplified photoresist material formed of a binder having a group that is decomposed by an acid to increase the alkaline dissolution rate, a low molecular weight compound that is decomposed by an acid to increase the alkaline dissolution rate of the photoresist material, and a photoacid generator.

Specific examples of commercially available products thereof include, but are not limited to, APEX-E (trade name, manufactured by Shipley Company L.L.C), PAR710 (trade name, manufactured by Sumitomo Chemical Co., Ltd.), AR2772JN (trade name, manufactured by JSR Corporation), and SEPR430 (trade name, manufactured by Shin-Etsu Chemical Co., Ltd.). Examples thereof include a fluorine-containing atomic polymer-based photoresist material as described in Proc. SPIE, Vol. 3999, 330-334 (2000), Proc. SPIE, Vol. 3999, 357-364 (2000), or Proc. SPIE, Vol. 3999, 365-374 (2000).

In addition, for the resist film formed on the resist underlayer film, a resist film for electron beam lithography (also referred to as an electron beam resist film) or a resist film for EUV lithography (also referred to as an EUV resist film) can be used instead of the photoresist film, that is, the silicon-containing resist underlayer film-forming composition of the present invention can be used for forming a resist underlayer film for electron beam lithography or for forming a resist underlayer film for EUV lithography. In particular, it is suitable as a resist underlayer film-forming composition for EUV lithography.

As the electron beam resist material for forming the electron beam resist film, either a negative type material or a positive type material can be used. Specific examples of the negative type material and the positive type material include: a chemically amplified resist material containing an acid generator and a binder having a group that is decomposed by an acid to change the alkaline dissolution rate; a chemically amplified resist material containing an alkali-soluble binder, an acid generator, and a low molecular weight compound that is decomposed by an acid to change the alkaline dissolution rate of the resist material; a chemically amplified resist material containing an acid generator, a binder having a group that is decomposed by an acid to change the alkaline dissolution rate, and a low molecular weight compound that is decomposed by an acid to change the alkaline dissolution rate of the resist material; a non-chemically amplified resist material containing a binder having a group that is decomposed by an electron beam to change the alkaline dissolution rate; and a non-chemically amplified resist material containing a binder having a moiety that is cleaved by an electron beam to change the alkaline dissolution rate. Also in the case of use of these electron beam resist materials, a resist film pattern can be formed by using electron beams as an irradiation source in the same manner as in the case of use of the photoresist material.

In addition, as the EUV resist material for forming the EUV resist film, a methacrylate resin-based resist material or a metal oxide resist material can be used.

Examples of the metal oxide resist material include a coating composition containing a metal oxo-hydroxo network having an organic ligand through a metal carbon bond and/or a metal carboxylate bond described in JP 2019-113855 A.

In EUV lithography, since LWR and sensitivity are usually in a trade-off relationship, the silicon-containing resist underlayer film-forming composition of the present invention capable of improving the resist sensitivity without lowering LWR of the resist is suitable for EUV lithography, and more suitable for EUV lithography using a metal oxide resist.

Next, the resist film formed on the resist underlayer film is exposed through a predetermined mask (reticle). The exposure may be performed using a KrF excimer laser (wavelength: 248 nm), an ArF excimer laser (wavelength: 193 nm), an F₂ excimer laser (wavelength: 157 nm), EUV (wavelength: 13.5 nm), electron beams, or the like.

After the exposure, post exposure bake may be performed as necessary. The post exposure bake is performed under conditions appropriately selected from a heating temperature of 70°C to 150°C and a heating time of 0.3 minutes to 10 minutes.

Next, development is performed with a developer (for example, an alkaline developer). When, for example, a positive photoresist film is used, an exposed portion of the photoresist film is removed, and thus a pattern of the photoresist film is formed.

Examples of the developer (alkaline developer) include alkaline aqueous solutions (alkaline developers) such as: aqueous solutions of alkali metal hydroxides such as potassium hydroxide and sodium hydroxide; aqueous solutions of quaternary ammonium hydroxides such as tetramethylammonium hydroxide, tetraethylammonium hydroxide, and choline; and aqueous amine solutions such as ethanolamine, propylamine, and ethylenediamine. Furthermore, a surfactant or the like may be added to these developers. Development conditions are appropriately selected from a temperature of 5°C to 50°C, and a time of 10 seconds to 600 seconds.

In the present invention, an organic solvent can be used as a developer, and development is performed with the developer (solvent) after exposure. When, for example, a negative photoresist film is used, an unexposed portion of the photoresist film is removed, and a pattern of the photoresist film is thus formed.

Examples of the developer (organic solvent) include methyl acetate, butyl acetate, ethyl acetate, isopropyl acetate, amyl acetate, isoamyl acetate, ethyl methoxyacetate, ethyl ethoxyacetate, propylene glycol monomethyl ether acetate, ethylene glycol monoethyl ether acetate, ethylene glycol monopropyl ether acetate, ethylene glycol monobutyl ether acetate, ethylene glycol monophenyl ether acetate, diethylene glycol monomethyl ether acetate, diethylene glycol monopropyl ether acetate, diethylene glycol monoethyl ether acetate, diethylene glycol monophenyl ether acetate, diethylene glycol monobutyl ether acetate, diethylene glycol monoethyl ether acetate, 2-methoxybutyl acetate, 3-methoxybutyl acetate, 4-methoxybutyl acetate, 3-methyl-3-methoxybutyl acetate, 3-ethyl-3 methoxybutyl acetate, propylene glycol monomethyl ether acetate, propylene glycol monoethyl ether acetate, propylene glycol monopropyl ether acetate, 2-ethoxybutyl acetate, 4-ethoxybutyl acetate, 4-propoxybutyl acetate, 2-methoxypentyl acetate, 3-methoxypentyl acetate, 4-methoxypentyl acetate, 2-methyl-3-methoxypentyl acetate, 3-methyl-3-methoxypentyl acetate, 3-methyl-4-methoxypentyl acetate, 4-methyl-4-methoxypentyl acetate, propylene glycol diacetate, methyl formate, ethyl formate, butyl formate, propyl formate, ethyl lactate, butyl lactate, propyl lactate, ethyl carbonate, propyl carbonate, butyl carbonate, methyl pyruvate, ethyl pyruvate, propyl pyruvate, butyl pyruvate, methyl acetoacetate, ethyl acetoacetate, methyl propionate, ethyl propionate, propyl propionate, isopropyl propionate, methyl 2-hydroxypropionate, ethyl 2-hydroxypropionate, methyl-3-methoxypropionate, ethyl-3-methoxypropionate, ethyl-3 ethoxypropionate, and propyl-3-methoxypropionate. Furthermore, a surfactant or the like may be added to these developers. Development conditions are appropriately selected from a temperature of 5°C to 50°C, and a time of 10 seconds to 600 seconds.

The pattern of the photoresist film (upper layer) thus formed is used as a protective film for removing the resist underlayer film (intermediate layer), and a film including the patterned photoresist film and the patterned resist underlayer film (intermediate layer) is then used as a protective film to remove the organic underlayer film (underlayer). Finally, the substrate is processed using the patterned resist underlayer film (intermediate layer) and the patterned organic underlayer film (underlayer) as protective films.

Removal (patterning) of the resist underlayer film (intermediate layer) performed using the pattern of the resist film (upper layer) as the protective film is performed through dry etching, and gases such as tetrafluoromethane (CF₄), perfluorocyclobutane (C₄F₈), perfluoropropane (C₃F₈), trifluoromethane, carbon monoxide, argon, oxygen, nitrogen, sulfur hexafluoride, difluoromethane, nitrogen trifluoride, chlorine trifluoride, chlorine, trichloroborane, and dichloroborane can be used.

A halogen-based gas is preferably used for dry etching of the resist underlayer film. In the dry etching using a halogen-based gas, a resist film (photoresist film) basically containing an organic substance is less likely to be removed. On the other hand, the resist underlayer film containing a large amount of silicon atoms is quickly removed by the halogen-based gas. Therefore, a decrease in the film thickness of the photoresist film due to dry etching of the resist underlayer film can be suppressed. Then, as a result, the photoresist film can be used as a thin film. Therefore, the dry etching of the resist underlayer film is preferably performed with a fluorine-based gas, and examples of the fluorine-based gas include tetrafluoromethane (CF₄), perfluorocyclobutane (C₄F₈), perfluoropropane (C₃F₈), trifluoromethane, and difluoromethane (CH₂F₂), but are not limited thereto.

When the organic underlayer film is provided between the substrate and the resist underlayer film, the organic underlayer film (underlayer) is preferably removed (patterned) by dry etching with an oxygen-based gas (oxygen gas, oxygen/carbonyl sulfide (COS) mixed gas, and the like) using a film including (when the patterned resist film (upper layer) remains) the patterned resist film (upper layer) and the patterned resist underlayer film (intermediate layer) as a protective film. This is because the resist underlayer film of the present invention containing a large amount of silicon atoms is hardly removed by dry etching using an oxygen-based gas.

Thereafter, the processing (patterning) of the (semiconductor) substrate performed using the patterned resist underlayer film (intermediate layer) and, as desired, the patterned organic underlayer film (underlayer) as protective films is preferably performed by dry etching with a fluorine-based gas.

Examples of the fluorine-based gas include tetrafluoromethane (CF₄), perfluorocyclobutane (C₄F₈), perfluoropropane (C₃F₈), trifluoromethane, and difluoromethane (CH₂F₂).

After the removal (patterning) of the organic underlayer film or after the processing (patterning) of the substrate, the resist underlayer film may be removed. The resist underlayer film may be removed by dry etching or wet etching (wet method).

The dry etching of the resist underlayer film is preferably performed with a fluorine-based gas as described in the patterning, and examples thereof include tetrafluoromethane (CF₄), perfluorocyclobutane (C₄F₈), perfluoropropane (C₃F₈), trifluoromethane, and difluoromethane (CH₂F₂), but are not limited thereto.

Examples of the chemical solution used for wet etching of the resist underlayer film include alkaline solutions such as a dilute hydrofluoric acid (hydrofluoric acid), a buffered hydrofluoric acid (mixed solution of HF and NH₄F), an aqueous solution containing a hydrochloric acid and a hydrogen peroxide (SC-2 chemical solution), an aqueous solution containing a sulfuric acid and a hydrogen peroxide (SPM chemical solution), an aqueous solution containing a hydrofluoric acid and a hydrogen peroxide (FPM chemical solution), and an aqueous solution containing ammonia and a hydrogen peroxide (SC-1 chemical solution). In addition, examples of the alkaline solution include an aqueous solution containing 1 to 99 mass% of ammonia, tetramethylammonium hydroxide (TMAH), tetraethylammonium hydroxide, tetrapropylammonium hydroxide, tetrabutylammonium hydroxide, choline hydroxide, benzyltrimethylammonium hydroxide, benzyltriethylammonium hydroxide, DBU (diazabicycloundecene), DBN (diazabicyclononene), hydroxylamine, 1-butyl-1-methylpyrrolidinium hydroxide, 1-propyl-1-methylpyrrolidinium hydroxide, 1-butyl-1-methylpiperidinium hydroxide, 1-propyl-1-methylpiperidinium hydroxide, mepiquat hydroxide, trimethylsulfonium hydroxide, hydrazines, ethylenediamines, or guanidine, in addition to the ammonia hydrogen peroxide (SC-1 chemical solution) obtained by mixing ammonia, hydrogen peroxide water, and water described above. These chemical solutions can also be used in mixture.

In addition, an organic anti-reflective coating can be formed on the resist underlayer film before the resist film is formed. The anti-reflective coating composition to be used is not particularly limited, and can be optionally selected and used, for example, from those conventionally used in a lithography process, and the anti-reflective coating can be formed by a commonly used method, for example, coating using a spinner or a coater and baking.

In addition, the substrate to which the silicon-containing resist underlayer film-forming composition is applied may have an organic or inorganic anti-reflective coating formed by a CVD method or the like on the surface thereof, and the resist underlayer film can be formed thereon. When the organic underlayer film is formed on the substrate and the resist underlayer film of the present invention is then formed thereon, the substrate to be used may have an organic or inorganic anti-reflective coating formed by a CVD method or the like on the surface thereof.

The resist underlayer film formed from the silicon-containing resist underlayer film-forming composition may also absorb light depending on the wavelength of the light used in a lithography process. Then, in such a case, it is possible to function as an anti-reflective coating having an effect of preventing reflected light from the substrate.

Furthermore, the resist underlayer film can also be used as a layer for preventing interaction between a substrate and a resist film (such as a photoresist film), a layer having a function of preventing a bad effect on the substrate of a material used for the resist film or a substance generated at the time of exposure to the resist film, a layer having a function of preventing diffusion of a substance generated from the substrate to the resist film at the time of heating and firing, a barrier layer for reducing a poisoning effect of the resist film by a semiconductor substrate dielectric layer, and the like.

The resist underlayer film can be applied to a substrate on which via holes used in a dual damascene process are formed, and can be used as a hole-filling material (filling material) capable of filling the holes without gaps. The resist underlayer film can also be used as a planarization material for planarizing the surface of a semiconductor substrate having irregularities.

In addition, the resist underlayer film of the present invention can prevent reflection of exposure light, for example, UV (ultraviolet) light or DUV (deep ultraviolet) light (ArF light, KrF light), which is not preferable in EUV exposure (wavelength: 13.5 nm), from a substrate or an interface without intermixing with, for example, the EUV resist film, in addition to the function as an underlayer film of the EUV resist film or a hard mask. Therefore, in order to form the underlayer antireflection film of the EUV resist film, the silicon-containing resist underlayer film-forming composition of the present invention can be suitably used. That is, the resist underlayer film can efficiently prevent the light reflection as the underlayer of the EUV resist film. When the resist underlayer film is used as an EUV resist underlayer film, the film can be processed in a similar manner to a photoresist underlayer film.

When the semiconductor processing substrate including the resist underlayer film of the present invention described above and a semiconductor substrate is used, the semiconductor substrate can be suitably processed.

In addition, by the method for producing a semiconductor element including the step of forming an organic underlayer film, the step of forming a resist underlayer film using the silicon-containing resist underlayer film-forming composition of the present invention on the organic underlayer film, and the step of forming a resist film on the resist underlayer film as described above, processing of a semiconductor substrate with high accuracy can be achieved with high reproducibility, and therefore the stable production of a semiconductor element can be expected.

### Examples

Hereinafter, the present invention will be described more specifically with reference to Synthesis Examples and Examples, but the present invention is not limited to only the following Examples.

In Examples, apparatuses and conditions used for analysis of the physical properties of samples are as follows.

### (1) Measurement of Molecular Weight

The molecular weight of a polysiloxane used in the present invention is determined by GPC analysis in terms of polystyrene.

The GPC analysis can be performed, for example, under the following conditions: GPC apparatus (trade name: HLC-8220GPC, manufactured by Tosoh Corporation), GPC columns (trade name: Shodex (registered trademark) KF803L, KF802, and KF801, manufactured by Showa Denko K.K.), column temperature of 40°C, tetrahydrofuran as an eluent (elution solvent), flow amount (flow rate) of 1.0 mL/min, and polystyrene (manufactured by Showa Denko K.K.) as a standard sample.

### [1] Synthesis of Compounds

### (Synthesis Example of Raw Material)

Into a 200 mL recovery flask, 14.4 g (0.048 mol) of 4-iodobenzene-1-sulfonyl chloride, 9.0 g (0.072 mol) of sodium sulfite, 18.0 g (0.215 mol) of sodium hydrogen carbonate, and 45.0 g of water were charged, and the mixture was heated to 100°C, and reacted for 1 hour. Thereafter, 50.0 g of toluene was added, the mixture was heated to a reflux state, and water was collected by a Dean-Stark apparatus. To the mixture, 9.5 g (0.048 mol) of 3-chloropropyltrimethoxysilane, 1.4 g (0.010 mol) of sodium iodide, and 45.0 g of N-methyl-2-pyrrolidone were added, and the resultant mixture was heated and stirred at 150°C for 3 hours while a solvent was distilled off. The reaction solution was separated with toluene and water, sodium carbonate was then added to the organic phase, the mixture was stirred and filtered, and toluene was removed with an evaporator to obtain a crude product. The crude product was distilled under reduced pressure to obtain the following compound 1 as a desired product in a yield of 36%.

¹H-NMR (500 MHz, CDCl₃): 0.70 ppm (t, 2H), 1.82 ppm (m, 2H), 3.12 ppm (t, 2H), 3.53 ppm (s, 9H), 7.61 ppm (d, 2H), 7.93 ppm (d, 2H)

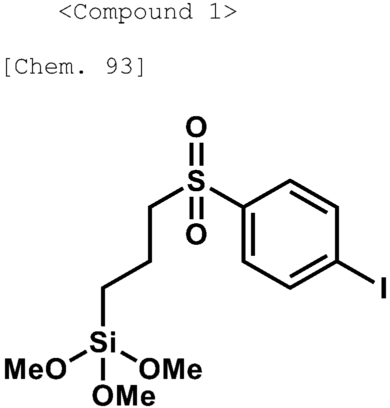

Me represents a methyl group.

### [2] Synthesis of Polymer (Hydrolytic Condensate)

### (Synthesis Example 1)

A 200 mL flask was charged with 8.3 g of tetraethoxysilane, 2.5 g of methyltriethoxysilane, 1.2 g of the above-described compound 1, and 14.3 g of 1-ethoxy-2-propanol, and the mixture was stirred. While the resultant solution was stirred with a magnetic stirrer, 7.2 g of a 0.1 mol/L aqueous nitric acid solution was added dropwise thereto.

After the dropwise addition, the flask was transferred to an oil bath set at 63°C, and the mixed solution was reacted for 20 hours. Thereafter, the reaction solution was cooled to room temperature, 20 g of 1-ethoxy-2-propanol was added to the reaction solution, and water and nitric acid, and methanol and ethanol as reaction by-products were distilled off under reduced pressure to obtain a concentrated solution of a hydrolytic condensate (polymer) using 1-ethoxy-2-propanol as a solvent. The solid content concentration of the obtained concentrated solution was more than 20 mass% in terms of solid residue when heated at 150°C.

The obtained hydrolytic condensate (polysiloxane) corresponded to the following formula, and the weight-average molecular weight (Mw) by GPC was 3,800 in terms of polystyrene.

In the following chemical formula, the number attached to the side of the siloxane unit represents a molar ratio (total 100).

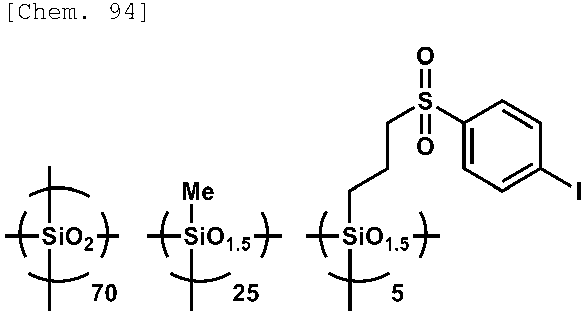

Me represents a methyl group.

### (Comparative Synthesis Example 1)

A 300 mL flask was charged with 8.3 g of tetraethoxysilane, 2.5 g of methyltriethoxysilane, 0.6 g of phenyltrimethoxysilane, and 48.4 g of 1-ethoxy-2-propanol, and the mixture was stirred. While the resultant solution was stirred with a magnetic stirrer, 19.3 g of a 0.2 mol/L aqueous nitric acid solution was added dropwise thereto.

After the dropwise addition, the flask was transferred to an oil bath set at 63°C, and the mixed solution was reacted for 20 hours. Thereafter, the reaction solution was cooled to room temperature, 18 g of 1-ethoxy-2-propanol was added to the reaction solution, and water and nitric acid, and methanol and ethanol as reaction by-products were distilled off under reduced pressure to obtain a concentrated solution of a hydrolytic condensate (polymer) using 1-ethoxy-2-propanol as a solvent.

The obtained hydrolytic condensate (polysiloxane) corresponded to the following formula, and the weight-average molecular weight (Mw) by GPC was 3,000 in terms of polystyrene.

In the following chemical formula, the number attached to the side of the siloxane unit represents a molar ratio (total 100).

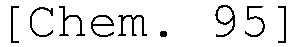

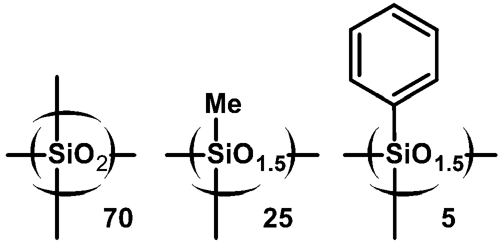

Me represents a methyl group.

### [3] Example 1 and Comparative Example 1: Preparation of Silicon-Containing Resist Underlayer Film-Forming Composition (Coating Solution)

Additives and solvents were mixed with each of a hydrolytic condensate (polymer) obtained in Synthesis Example 1 and a hydrolytic condensate (polymer) obtained in Comparative Synthesis Example 1 in the proportions shown in Table 1, and the mixture was filtered through a 0.02 µm polyethylene filter to prepare each silicon-containing resist underlayer film-forming composition. In Table 1, the amount of each component added is shown by part(s) by mass.

In Table 1, the fact that each Synthesis Example described in the column of composition is 1 part by mass means that the hydrolytic condensate is 1 part by mass.

In Table 1, MA means maleic acid, TPSNO3 means triphenylsulfonium nitrate, PGEE means propylene glycol monoethyl ether, and PGME means propylene glycol monomethyl ether.

**[Table 1]**

| | Polymer | Additive 1 | Additive 2 | Solvent | | |
|---|---|---|---|---|---|---|
| Example 1 | Synthesis Example 1 | MA | TPSN03 | PGEE | PGME | Water |
| (part (s) by mass) | 1 | 0.01 | 0.03 | 80 | 8 | 12 |
| Comparative Example 1 | Comparative Synthesis Example 1 | MA | TPSN03 | PGEE | PGME | Water |
| (part (s) by mass) | 1 | 0.01 | 0.03 | 80 | 8 | 12 |

| | | | | | | |
|---|---|---|---|---|---|---|
| * Example 1 and Comparative Example 1 further contain nitric acid contained in the polymer solution prepared in each Synthesis Example. | | | | | | |

### [4] Preparation of Organic Underlayer Film-Forming Composition

Under nitrogen, a 100 ml four-necked flask was charged with carbazole (6.69 g, 0.040 mol, manufactured by Tokyo Chemical Industry Co., Ltd.), 9-fluorenone (7.28 g, 0.040 mol, manufactured by Tokyo Chemical Industry Co., Ltd.), and para-toluenesulfonic acid monohydrate (0.76 g, 0.0040 mol, manufactured by Tokyo Chemical Industry Co., Ltd.), 1,4-dioxane (6.69 g, manufactured by KANTO CHEMICAL CO., INC.) was then added, and the resultant mixture was stirred and heated to 100°C for dissolution, thereby initiating polymerization. After 24 hours, the mixture was allowed to cool to 60°C.

The cooled reaction mixture was diluted with chloroform (34 g, manufactured by KANTO CHEMICAL CO., INC.), and the diluted mixture was added to methanol (168 g, manufactured by KANTO CHEMICAL CO., INC.) for precipitation.

The resultant precipitate was collected by filtration, and the collected solid was dried with a reduced-pressure dryer at 80°C for 24 hours to obtain 9.37 g of a desired polymer represented by Formula (X) (hereinafter, abbreviated as PCzFL).

The results of ¹H-NMR measurement of PCzFL were as follows.
¹H-NMR (400 MHz, DMSO-d₆):δ 7.03-7.55 (br, 12H), δ 7.61-8.10 (br, 4H), δ 11.18 (br, 1H)

In addition, PCzFL was found to have a weight-average molecular weight Mw of 2,800 as determined by GPC in terms of polystyrene and a polydispersity Mw/Mn of 1.77.

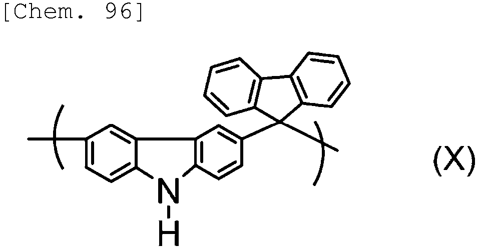

Mixing 20 g of PCzFL, 3.0 g of tetramethoxymethyl glycoluril (trade name: Powder Link 1174, manufactured by Nippon Cytec Industries (former Mitsui Cytec Ltd.)) as a crosslinking agent, 0.30 g of pyridinium paratoluenesulfonate as a catalyst, and 0.06 g of MEGAFACE R-30 (trade name, manufactured by DIC Corporation) as a surfactant was performed, and the resultant mixture was dissolved in 88 g of propylene glycol monomethyl ether acetate to prepare a solution. Thereafter, the obtained solution was filtered using a polyethylene microfilter having a pore size of 0.10 µm, and further filtered using a polyethylene microfilter having a pore size of 0.05 µm to prepare an organic underlayer film-forming composition.

### [5] Formation of Positive Resist Pattern by Electron Beam Lithography System

The above-described organic underlayer film-forming composition was applied onto a silicon wafer using a spinner, and heated on a hot plate at 240°C for 60 seconds to form an organic underlayer film (A layer) (film thickness: 40 nm).

The composition prepared in Example 1 was spin-coated on the organic underlayer film, and then heated on a hot plate at 215°C for 1 minute to form a silicon-containing resist underlayer film (B layer) (10 nm).

Furthermore, a positive resist for EUV was applied on the silicon-containing resist underlayer film by spin coating, and heated on a hot plate at 110°C for 60 seconds to form a resist film (C layer) (38 nm), and the resist film was then exposed under predetermined conditions using an electron beam lithography system (ELS-G130). After exposure, the film was baked (PEB) at 90°C for 60 seconds, cooled to room temperature on a cooling plate, and developed with an alkaline developer (2.38% TMAH), and the exposure dose that formed a 25 nm line/50 nm pitch (line- and-space (L/S) = 1/1) pattern was then defined as the optimal exposure dose.

In the same procedure, a resist pattern was formed using the composition obtained in Comparative Example 1.

The optimal exposure dose is shown in Table 2. In addition, Table 2 shows the optimal exposure dose (%) of Example 1 in a case where the optimal exposure dose of Comparative Example 1 is 100%.

**[Table 2]**

| | Optimal exposure dose (mJ/cm²) | (%) |
|---|---|---|
| Example 1 | 338 | 94 |
| Comparative Example 1 | 360 | 100 |

## Claims

1. A silicon-containing resist underlayer film-forming composition comprising:
a polysiloxane as a component [A]; and
a solvent as a component [C], wherein
the polysiloxane contains a constituent unit derived from a hydrolyzable silane (A) having at least one of an arylsulfonyl group having an iodine atom directly bonded to an aromatic ring or an arylthioester group having an iodine atom directly bonded to an aromatic ring.

2. A silicon-containing resist underlayer film-forming composition comprising:
a polysiloxane as a component [A'];
a hydrolyzable silane (A) having at least one of an arylsulfonyl group having an iodine atom directly bonded to an aromatic ring or an arylthioester group having an iodine atom directly bonded to an aromatic ring as a component [B]; and
a solvent as a component [C].

3. The silicon-containing resist underlayer film-forming composition according to claim 1 or 2, wherein the hydrolyzable silane (A) is a compound represented by Formula (A-1) described below, 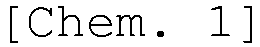 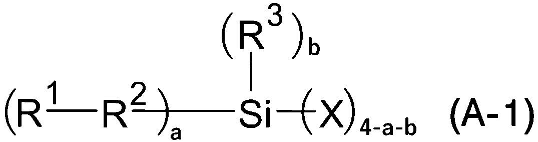
in the Formula (A-1), a represents an integer of 1 to 3;
b represents an integer of 0 to 2;
a + b represents an integer of 1 to 3;
R¹ represents an arylsulfonyl group having an iodine atom directly bonded to an aromatic ring or an arylthioester group having an iodine atom directly bonded to an aromatic ring;
R² represents a single bond or a divalent linking group;
R³ represents an alkyl group which may be substituted, an aryl group which may be substituted, an aralkyl group which may be substituted, an alkyl halide group which may be substituted, an aryl halide group which may be substituted, an aralkyl halide group which may be substituted, an alkoxyalkyl group which may be substituted, an alkoxyaryl group which may be substituted, an alkoxyaralkyl group which may be substituted, or an alkenyl group which may be substituted, or an organic group having an epoxy group, an organic group having an acryloyl group, an organic group having a methacryloyl group, an organic group having a mercapto group, an organic group having an amino group, an organic group having an alkoxy group, an organic group having a sulfonyl group, or an organic group having a cyano group, or a combination of two or more thereof;
X represents an alkoxy group, an aralkyloxy group, an acyloxy group, or a halogen atom; and
when a plurality of R¹s, a plurality of R²s, a plurality of R³s, and a plurality of Xs are present, the plurality of R¹s, the plurality of R²s, the plurality of R³s, and the plurality of Xs may be the same or different from each other.

4. The silicon-containing resist underlayer film-forming composition according to claim 3, wherein R¹ in the Formula (A-1) is represented by Formula (A-1-1) or Formula (A-1-2) described below, 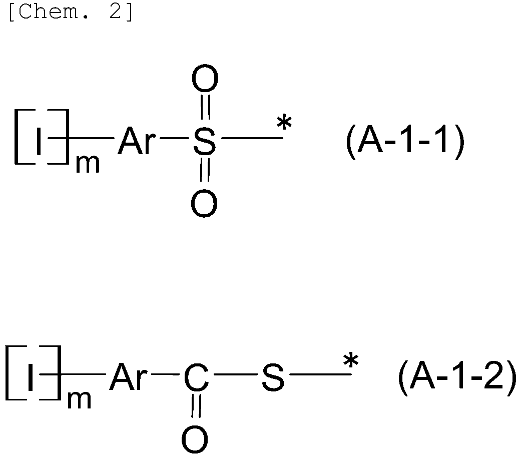
in the Formulae (A-1-1) and (A-1-2), each Ar independently represents an aromatic hydrocarbon group which may have a substituent;
m represents an integer of 1 to x, where x represents the number of substituents which can be bonded to an aromatic hydrocarbon ring in the Ar; and
* represents a bond.

5. The silicon-containing resist underlayer film-forming composition according to claim 4, wherein the Ar in the Formulae (A-1-1) and (A-1-2) represents a benzene ring, and m represents an integer of 1 to 5.

6. The silicon-containing resist underlayer film-forming composition according to claim 1 or 2, wherein the component [C] contains an alcohol-based solvent.

7. The silicon-containing resist underlayer film-forming composition according to claim 6, wherein the component [C] contains a propylene glycol monoalkyl ether.

8. The silicon-containing resist underlayer film-forming composition according to claim 1 or 2, further comprising a curing catalyst as a component [D].

9. The silicon-containing resist underlayer film-forming composition according to claim 1 or 2, further comprising a nitric acid as a component [E].

10. A resist underlayer film which is a cured product of the silicon-containing resist underlayer film-forming composition according to claim 1 or 2.

11. A semiconductor processing substrate comprising: a semiconductor substrate; and the resist underlayer film according to claim 10.

12. A method for producing a semiconductor element, the method comprising:
a step of forming an organic underlayer film on a substrate;
a step of forming a resist underlayer film on the organic underlayer film using the silicon-containing resist underlayer film-forming composition according to claim 1 or 2; and
a step of forming a resist film on the resist underlayer film.

13. A pattern forming method, comprising:
a step of forming an organic underlayer film on a semiconductor substrate;
a step of applying the silicon-containing resist underlayer film-forming composition according to claim 1 or 2 on the organic underlayer film and baking the silicon-containing resist underlayer film-forming composition to form a resist underlayer film;
a step of forming a resist film on the resist underlayer film;
a step of exposing and developing the resist film to obtain a resist pattern;
a step of etching the resist underlayer film using the resist pattern as a mask; and
a step of etching the organic underlayer film using the patterned resist underlayer film as a mask.

14. The pattern forming method according to claim 13, further comprising:
a step of removing the resist underlayer film by a wet method using a chemical solution after the step of etching the organic underlayer film.

15. A hydrolyzable silane comprising at least one of an arylsulfonyl group having an iodine atom directly bonded to an aromatic ring or an arylthioester group having an iodine atom directly bonded to an aromatic ring.

16. The hydrolyzable silane according to claim 15, wherein the hydrolyzable silane is a compound represented by Formula (A-1) described below, 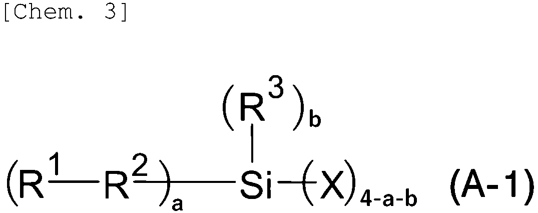
in the Formula (A-1), a represents an integer of 1 to 3;
b represents an integer of 0 to 2;
a + b represents an integer of 1 to 3;
R¹ represents an arylsulfonyl group having an iodine atom directly bonded to an aromatic ring or an arylthioester group having an iodine atom directly bonded to an aromatic ring;
R² represents a single bond or a divalent linking group;
R³ represents an alkyl group which may be substituted, an aryl group which may be substituted, an aralkyl group which may be substituted, an alkyl halide group which may be substituted, an aryl halide group which may be substituted, an aralkyl halide group which may be substituted, an alkoxyalkyl group which may be substituted, an alkoxyaryl group which may be substituted, an alkoxyaralkyl group which may be substituted, or an alkenyl group which may be substituted, or an organic group having an epoxy group, an organic group having an acryloyl group, an organic group having a methacryloyl group, an organic group having a mercapto group, an organic group having an amino group, an organic group having an alkoxy group, an organic group having a sulfonyl group, or an organic group having a cyano group, or a combination of two or more thereof;
X represents an alkoxy group, an aralkyloxy group, an acyloxy group, or a halogen atom; and
when a plurality of R¹s, a plurality of R²s, a plurality of R³s, and a plurality of Xs are present, the plurality of R¹s, the plurality of R²s, the plurality of R³s, and the plurality of Xs may be the same or different from each other.

17. The hydrolyzable silane according to claim 16, wherein R¹ in the Formula (A-1) is represented by Formula (A-1-1) or Formula (A-1-2) described below, 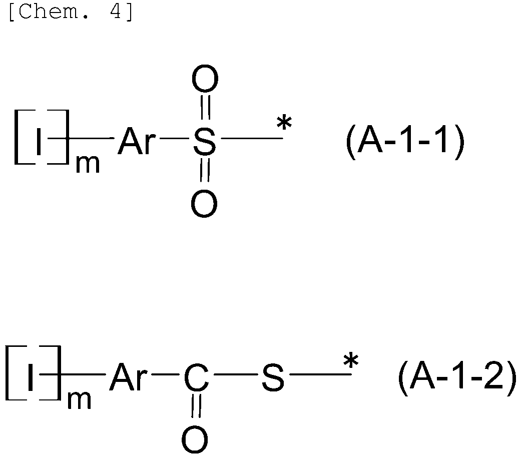
in the Formulae (A-1-1) and (A-1-2), each Ar independently represents an aromatic hydrocarbon group which may have a substituent;
m represents an integer of 1 to x, where x represents the number of substituents which can be bonded to an aromatic hydrocarbon ring in the Ar; and
* represents a bond.

18. A polysiloxane comprising a constituent unit derived from the hydrolyzable silane according to any one of claims 15 to 17.
